(19) Europäisches Patentamt
European Patent Office
Office européen des brevets

(11) **EP 4 625 826 A1**

(12) **DEMANDE DE BREVET EUROPEEN**

(43) Date de publication:
**01.10.2025 Bulletin 2025/40**

(21) Numéro de dépôt: **25166016.3**

(22) Date de dépôt: **25.03.2025**

(51) Classification Internationale des Brevets (IPC):
*H03M 3/00* (2006.01)    *G06N 3/044* (2023.01)
*G06N 3/0455* (2023.01)    *G06N 3/048* (2023.01)
*G06N 3/09* (2023.01)

(52) Classification Coopérative des Brevets (CPC):
**H03M 3/436; G06N 3/044; G06N 3/0455; G06N 3/048; G06N 3/09; H03M 3/462; H03M 3/464**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **29.03.2024 FR 2403328**

(71) Demandeur: **Commissariat à l'Energie Atomique et aux Energies Alternatives
75015 Paris (FR)**

(72) Inventeurs:
• **VERDANT, Arnaud**
 **38054 Grenoble Cedex09 (FR)**
• **GUICQUERO, William**
 **38054 Grenoble Cedex09 (FR)**

(74) Mandataire: **Cabinet Beaumont
4, Place Robert Schuman
B.P. 1529
38025 Grenoble Cedex 1 (FR)**

(54) **MÉTHODE DE CONCEPTION D'UN CONVERTISSEUR DE TYPE SIGMA-DELTA**

(57) La présente description concerne une méthode de conception d'un convertisseur de type sigma delta comprenant une étape d'apprentissage profond supervisé appliquée à un modèle de convertisseur. Le modèle de convertisseur comprend au moins un encodeur récurrent et au moins un décodeur récurrent. Chaque encodeur récurrent est basé sur un modèle générique comprenant une succession de K cellules génériques identiques Cellk, avec K un paramètre entier et supérieur ou égal à 1 et k un indice entier allant de 1 à K. Le convertisseur sigma-delta est obtenu en fabriquant un circuit électronique correspondant au modèle obtenu après l'entrainement.

EP 4 625 826 A1

Fig 17

**Description**

Domaine technique

La présente description concerne de façon générale les circuits électroniques et, plus particulièrement, les convertisseurs de type sigma-delta, qu'ils soient des convertisseurs analogique-numérique (AD de l'anglais "Analog to Digital") ou analogique-information (A2I de l'anglais "Analog to Information").

Technique antérieure

L'utilisation des procédés d'apprentissages profonds ("deep learning" en anglais) pour concevoir des circuits à signaux analogiques et mixtes ("analog and mixed-signal circuits" en anglais), a été proposée pour la conception de convertisseurs analogique-numérique ou analogique-information.

Par exemple, des méthodes assistées par une intelligence artificielle (AI de l'anglais "Artificial Intelligence") ont été utilisées sur les sorties de convertisseurs connus pour atténuer des non-idéalités matérielles de ces convertisseurs connus. Toutefois, dans ce cas, les méthodes assistées par une intelligence artificielle ne sont pas directement utilisées pour concevoir le convertisseur.

A titre d'autre exemple, des topologies de convertisseurs inspirées des réseaux de neurones ont été proposées, parfois en appliquant des méthodes d'apprentissages profonds pour adapter les poids de ces topologies. Toutefois, dans ces autres exemples, chaque topologie proposée est prédéfinie à partir d'un convertisseur connu bien spécifique, et ne peut donc pas être réutilisée pour développer un nouveau convertisseur à partir, par exemple, d'un cahier des charges ou d'une spécification listant les contraintes matérielles et les performances qu'il serait souhaitable que ce nouveau convertisseur respecte. Par exemple, l'article "Design Automation of Analog and Mixed Signal Circuits Using Neural Networks - A Tutorial Brief" de G. Linan-Cembrano et al, publié dans "IEEE Transactions on Circuits and Systems II: Express Briefs" présente des travaux sur l'utilisation de l'intelligence artificielle pour assister le portage d'une topologie de référence vers une implémentation matérielle la plus adaptée.

Résumé de l'invention

Il existe un besoin d'une méthode de conception de convertisseurs de type sigma-delta qui pallie tout ou partie des méthodes de conception connues de convertisseurs utilisant des procédés d'apprentissages profonds et/ou des intelligences artificielles.

Un mode de réalisation pallie tout ou partie des inconvénients des méthodes de conception connues de convertisseur de type sigma-delta.

Un mode de réalisation prévoit une méthode de conception d'un convertisseur de type sigma delta comprenant une étape d'apprentissage profond supervisé appliquée à un modèle de convertisseur, dans laquelle :

le modèle de convertisseur comprend au moins un encodeur récurrent et au moins un décodeur récurrent ;
chaque encodeur récurrent est basé sur un modèle générique comprenant une succession de K cellules génériques identiques $Cell_k$, avec K un paramètre entier et supérieur ou égal à 1 et k un indice entier allant de 1 à K ;
le convertisseur fonctionne à un taux de suréchantillonnage N, avec N un entier supérieur ou égal à 1 ;
chaque conversion par le convertisseur comprend N cycles $C[n]$, avec n un indice entier allant de 1 à N ;
chaque cellule $Cell_k$ du modèle générique est un réseau de neurones récurrent qui, à chaque cycle $C[n]$, calcule un produit d'un vecteur d'entrée $X[n]$ par un vecteur de poids $W_k$ de la cellule $Cell_k$ et fournit un vecteur de sortie $Q_k[n]$ comprenant D paires de sorties $A_{kd}[n]$ et $B_{kd}[n]$, avec :

- D entier supérieur ou égal à 1 et d un indice entier allant de 0 à D-1,
- $A_{kd}[n]$ le résultat du produit calculé par la cellule $Cell_k$ retardé de d cycles,
- $B_{kd}[n]$ une quantification du résultat du produit calculé par la cellule $Cell_k$ retardée de d cycles ; et

à chaque début de cycle $C[n]$, le vecteur $X[n]$ est le même pour toutes les cellules $Cell_k$ et comprend, par exemple est égal à, la concaténation des K vecteurs $Q_k[n]$ et d'un échantillon $x[n]$, pour le cycle $C[n]$, d'un signal x à convertir, et dans laquelle le convertisseur sigma-delta est obtenu en fabriquant un circuit électronique correspondant au modèle obtenu après l'entrainement.

Selon un mode de réalisation, chaque encodeur récurrent modélise un modulateur sigma-delta du convertisseur et chaque décodeur récurrent modélise un filtre du convertisseur.

Selon un mode de réalisation, chaque décodeur récurrent est basé sur une ou plusieurs successions de réseaux de neurones récurrents simples.

Selon un mode de réalisation, au moins une contrainte déterminée par une propriété matérielle ou par une propriété fonctionnelle du convertisseur à fabriquer est appliquée au modèle de convertisseur, de préférence à chaque encodeur.

Selon un mode de réalisation, ladite au moins une contrainte comprend :

une contrainte déterminée par une dynamique maximale en sortie d'une des K cellules Cellk et correspondant à un ajout d'une couche de coupure en sortie de ladite cellule Cellk ; et/ou une contrainte déterminée par une robustesse à des non-idéalités temporelles et correspondant à un ajout sur un noeud interne de l'encodeur d'une couche d'augmentation de donnée modélisant un bruit aléatoire gaussien ; et/ou une contrainte déterminée par un dimensionnement de circuits mettant en œuvre des poids de l'encodeur et correspondant à un entrainement axé sur la quantification ; et/ou une contrainte déterminée par une surface du convertisseur à fabriquer et correspondant à un masquage de poids de l'encodeur ; et/ou

une contrainte déterminée par une topologie du convertisseur à fabriquer et correspondant à un masquage de poids de l'encodeur ; et/ou

une contrainte déterminée par une surface du convertisseur et correspondant à une technique de coupure de poids de l'encodeur.

Selon un mode de réalisation, au moins une régularisation déterminée par une propriété matérielle ou par une propriété fonctionnelle du convertisseur est appliquée au modèle de convertisseur.

Selon un mode de réalisation :

une régularisation est déterminée par une surface du convertisseur à fabriquer et correspond à une régularisation L1 appliquée aux poids de l'encodeur ; et/ou une régularisation est déterminée par une atténuation de signaux internes et correspond à une pénalité lorsqu'un poids d'un chemin de rebouclage d'une cellule Cellk est inférieur à 1.

Selon un mode de réalisation, une fonction de coût utilisée pour l'entraînement comprend un terme déterminé par une fonction de régularisation déterminée par des conditions de saturation du convertisseur.

Selon un mode de réalisation, la fonction de coût comprend un terme déterminé par une fonction de fidélité de type logarithme de la somme des exponentielles des différences.

Selon un mode de réalisation, la fabrication du convertisseur comprend une mise en oeuvre de chaque poids non nul du modèle d'encodeur entrainé par un circuit capacitif ayant une capacité dont une valeur est déterminée par ledit poids.

Selon un mode de réalisation, la fabrication du convertisseur comprend une mise en oeuvre de chaque poids non nul du modèle d'encodeur entrainé par un circuit résistif ayant une résistance dont une valeur est déterminée par ledit poids.

Selon un mode de réalisation, l'entrainement est axé sur la quantification.

Selon un mode de réalisation, le décodeur est déterminé par une fonctionnalité du convertisseur à fabriquer.

Selon un mode de réalisation, le convertisseur à fabriquer met en œuvre un échantillonnage cyclique et alterné de plusieurs canaux d'entrée du convertisseur.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente de manière schématique un convertisseur analogique numérique de type sigma-delta ;

la figure 2 représente un exemple d'une structure d'auto-encodeur récurrent modélisant la structure du convertisseur sigma-delta de la figure 1;

la figure 3 représente un exemple de mode de réalisation d'une partie du convertisseur de la figure 2 ;

la figure 4 représente un autre exemple de mode de réalisation d'une partie du convertisseur de la figure 2 ;

la figure 5 illustre un exemple de mode de réalisation d'une cellule générique basée sur un réseau de neurones récurrent, pour un modèle générique d'encodeur récurrent ;

la figure 6 illustre un exemple de modèle générique basé sur la cellule générique de la figure 5 ;

la figure 7 illustre une mise à jour des sorties des cellules du modèle de la figure 6 ;

la figure 8 illustre un exemple de décodeur ;

la figure 9 est un organigramme illustrant un mode de réalisation d'une méthode de conception d'un convertisseur sigma-delta ;

la figure 10 illustre un mode de réalisation d'une transposition d'une cellule générique en un circuit ;

la figure 11 illustre un mode de réalisation d'une transposition d'un modèle de convertisseur en un circuit ainsi qu'un exemple de signaux de commande du circuit ;

la figure 12 illustre un mode de réalisation d'un circuit pour une mise en œuvre matérielle d'un modèle de convertisseur ;

la figure 13 illustre un mode de réalisation d'un autre circuit pour une mise en œuvre matérielle d'un modèle de convertisseur ;

la figure 14 illustre un mode de réalisation d'encore un autre circuit pour une mise en œuvre matérielle d'un modèle de convertisseur ;

la figure 15 illustre un mode de réalisation d'encore un autre circuit pour une mise en œuvre matérielle d'un modèle de convertisseur ;

la figure 16 illustre un mode de réalisation d'une transposition d'un modèle de convertisseur en un circuit ainsi qu'un exemple de signaux de commande du circuit ;

la figure 17 illustre un autre exemple de décodeur ;

la figure 18 illustre un échantillonnage cyclique, alterné et entrelacé entre trois canaux d'entrée d'un convertisseur ;

la figure 19 illustre, sous forme de blocs, un exemple de modèle de convertisseur adapté à un échantillonnage alterné et entrelacé des canaux d'entrée du convertisseur ;

la figure 20 illustre, sous forme de blocs, un autre exemple de modèle de convertisseur adapté à un échantillonnage alterné et entrelacé des canaux d'entrée du convertisseur ;

la figure 21 illustre, sous forme de blocs, un exemple d'un modèle de convertisseur analogique-information ;

la figure 22 illustre des résultats d'inférence d'un paramètre latent par le modèle de convertisseur de la figure 21 après un entrainement profond supervisé ;

la figure 23 illustre des résultats d'inférence d'un paramètre latent par le modèle de convertisseur de la figure 21 après un entrainement profond supervisé ;

la figure 24 illustre des résultats d'inférence d'un paramètre latent par le modèle de convertisseur de la figure 21 après un entrainement profond supervisé ;

la figure 25 illustre des résultats d'inférence d'un paramètre latent par le modèle de convertisseur de la figure 21 après un entrainement profond supervisé ; et

la figure 26 illustre des étapes de la méthode décrite en relation avec la figure 9.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

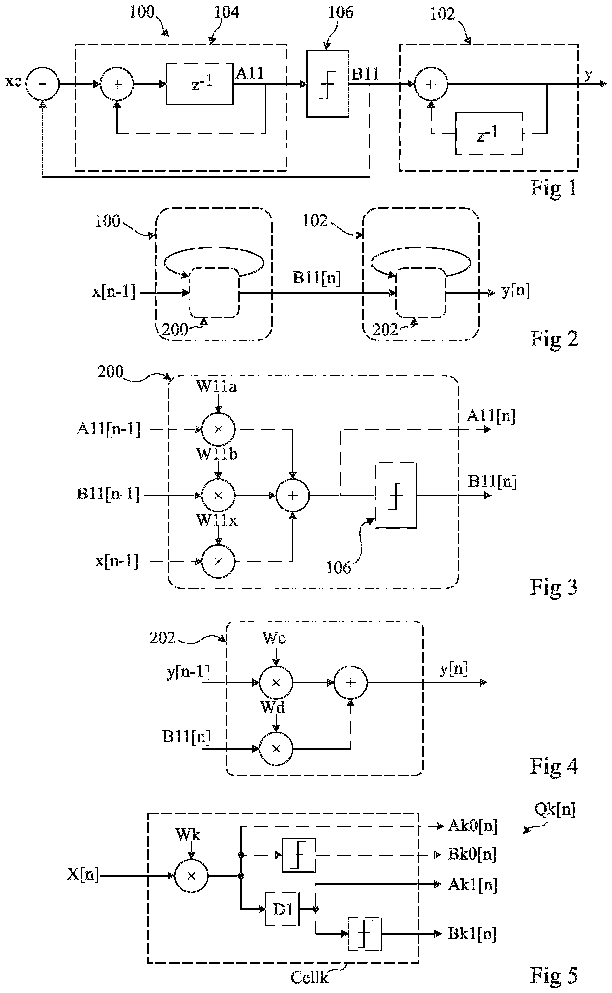

La figure 1 représente de manière schématique un exemple de convertisseur analogique numérique de type sigma-delta d'ordre M, avec M un entier supérieur ou égal à 1 et égal à 1 dans l'exemple de la figure 1. Le convertisseur est ici un convertisseur qui est configuré pour convertir un signal x analogique et par exemple continu (DC de l'anglais "direct current") en un signal numérique. Le convertisseur est réinitialisé à chaque conversion, chaque conversion comprenant, comme cela sera décrit plus en détail par la suite, N cycles.

Le convertisseur comprend un modulateur sigma-delta 100 et un filtre 102 (délimités chacun par des pointillés en figure 1).

Le modulateur 100 comprend un intégrateur analogique 104 (délimité par des pointillés en figure 1) et un quantificateur 106, ici sur un bit.

Le filtre 102 est par exemple mis en œuvre par un intégrateur numérique comme cela est représenté en figure 1.

Le convertisseur fonctionne avec un taux de suréchantillonnage N couramment désigné par le sigle OSR (de l'anglais "OverSampling Rate"), avec N un entier supérieur ou égal à 1, par exemple supérieur ou égal à 2. Ainsi, chaque conversion d'un signal d'entrée x comprend N cycles C[n], avec n un indice entier allant de 1 à N.

A chaque cycle C[n], le modulateur 100 reçoit un échantillon xe (ou x[n-1]) correspondant à l'échantillonnage du signal x au cycle précédent. A chaque cycle C[n], le convertisseur met en œuvre les trois opérations suivantes :

- la différence entre l'échantillon xe du cycle précédent et la sortie B11 du modulateur 100 au cycle précédent est intégrée par l'intégrateur analogique 104, de sorte à fournir la sortie A11 de l'intégrateur 104 ;
- la sortie A11 est quantifiée par le quantificateur 106 pour mettre à jour la sortie B11 du modulateur 100 ;
- la sortie B11 est fournie au filtre 102 qui calcule alors la sortie numérique y (ou y[n]) du convertisseur pour ce cycle n.

Dit autrement, le filtre met en œuvre l'équation en z suivante :

[Math 1]

$$A11 = Z^{-1}(A11 + xe - B11)$$

avec $Z^{-1}$ un retard d'un cycle.

Cela revient en temporel à :

[Math 2]

$$A11[n] = A[n-1] + x[n-1] - B11[n-1]$$

En pratique, les signaux internes du convertisseur doivent rester dans une dynamique donnée centrée sur le seuil du quantificateur 106. Cela est rendu possible grâce à la boucle de contre réaction négative commandée par le signe du signal de sortie B11 du quantificateur. A titre d'exemple, une pondération peut être ajoutée entre la sortie du différentiateur d'entrée et l'entrée de l'intégrateur 104.

Pour l'exemple illustré en figure 1, ce comportement s'exprime selon les équations [Math 3] et [Math 4] ci-dessus, avec les hypothèses [Math 5] respectées :

[Math 3]

$$A11[n] = \sum_{i=0}^{n-1} x[i] - \sum_{i=0}^{n-1} B11[i]$$

avec i un indice entier.

[Math 4]

$$B11[n] = \frac{1}{2} * sign(A11[n])$$

où sign(A11[n]) est la fonction retournant le signe de A11[n] par rapport au seuil du quantificateur 106.

[Math 5]

$$\begin{cases} n \geq 1 \\ |x[i]| \leq \frac{1}{2} \\ B11[i] \in \left\{-\frac{1}{2}, \frac{1}{2}\right\} \ pour \ i > 0, et \ B11[0] = 0 \end{cases}$$

Le signal numérique xq obtenu à la fin de chaque conversion, c'est à dire à la fin de N cycles de conversion correspondant, est alors égal à y[N] et peut alors s'exprimer, dans cet exemple, selon l'équation [Math 6] :

[Math 6]

$$xq = y[N] = \frac{\sum_{n=1}^{N} B11[n]}{N} \quad ,$$

la normalisation en 1/N n'étant pas représentée en figure 1.

Dans l'exemple de la figure 1, dans l'intégrateur 104, le retard $z^{-1}$ d'un cycle est appliqué sur le chemin direct. Toutefois, la personne du métier saura adapter cet exemple au cas où, dans l'intégrateur 104, le retard $z^{-1}$ d'un cycle est appliqué sur le chemin de contre réaction, entre la sortie A11 et le bloc sommateur, en prévoyant qu'un retard $z^{-1}$ d'un cycle soit également appliqué sur le chemin de contre réaction entre la sortie B11 et le bloc soustracteur.

Dans l'exemple de la figure 1, dans le filtre 102, le retard $z^{-1}$ d'un cycle est appliqué sur le chemin de contre réaction, entre la sortie y[n] et le bloc sommateur. Là aussi, la personne du métier sera en mesure d'adapter cet exemple au cas où, dans le filtre 102, le retard $z^{-1}$ d'un cycle est appliqué sur le chemin direct, entre le bloc sommateur et la sortie y[n].

Pour réduire le bruit de quantification, il est connu d'utiliser des convertisseurs d'ordre M supérieur à 1. Dans ce cas, le modulateur 104 comprend une succession d'intégrateurs, et le filtre comprend, par exemple, une succession d'intégrateurs.

La méthode proposée vise à concevoir un convertisseur, et, plus particulièrement, l'encodeur du convertisseur, en mettant en œuvre un apprentissage profond supervisé associant des données d'entrée à des données de sortie, basé sur l'exploration de topologies de convertisseur sigma-delta. En constatant que les convertisseurs de type sigma-delta ont des structures récursives, il est proposé de modéliser un convertisseur de type sigma-delta par une structure d'auto-encodeur récurrent telle qu'illustrée en figure 2. L'auto-encodeur récurrent fournit alors une image numérisée du signal analogique x d'entrée dans l'exemple illustré en figure 2. Dans d'autres exemples, l'auto-encodeur récurrent fourni une estimation numérique d'un ou plusieurs paramètres latents du signal d'entrée.

La figure 2 représente un exemple d'une structure d'auto-encodeur récurrent modélisant la structure du convertisseur sigma-delta de la figure 1.

Le modulateur 100 (délimité par des pointillés en figure 2) est ici mis en œuvre par un encodeur récurrent 100. L'encodeur récurrent 100 comprend, dans cet exemple où M est égal à 1, une cellule 200 correspondant à un réseau de neurones récurrent (RNN de l'anglais "Recurrent Neural Network"). Cette cellule 200 est configurée pour mettre en œuvre des traitements récursifs où les données de sortie de la cellule, pour un cycle donné, sont mises à jour à partir, ou en fonction, des données de sortie de la cellule au cycle précédent et d'une ou plusieurs données (ou valeurs) d'entrée de la cellule. Les réseaux de neurones récurrents sont bien connus de la personne du métier et ne sont pas redéfinis ici. A titre d'exemple, un réseau de neurones récurrent peut être similaire du point de vue mathématique à un filtre à réponse impulsionnelle infinie du fait de sa récurrence.

Le filtre 102 est ici mis en œuvre par un décodeur récurrent 102. Le décodeur récurrent 102 comprend, dans cet exemple, une cellule 202 correspondant à un réseau de neurones récurrent simple (SRNN de l'anglais "Simple Recurrent Neural Network). Par exemple, un réseau de neurones récurrent simple est configuré pour mettre en œuvre au moins le fonctionnement suivant : la sortie de la cellule 202, y[n] dans l'exemple de la figure 2, correspond à la somme de la sortie de la cellule 202 au cycle précédent, y[n-1] dans l'exemple de la figure 2, pondérée par un poids Wc correspondant (non représenté en figure 2), et d'une entrée de la cellule 202, B11[n] dans l'exemple de la figure 2, pondérée par un poids Wd correspondant (non représenté en figure 2). Cela correspond à un produit scalaire entre un vecteur d'entrée et un vecteur de poids (« dot product » en anglais) où, dans cet exemple, le vecteur d'entrée est égal à la concaténation de y[n-1] et de B11[n] et le vecteur de poids est constitué des poids Wc et Wd. La cellule 202 de la figure 2 correspond au filtre 102 de la figure 1 lorsque les poids Wc et Wd sont unitaires. Les réseaux de neurones récurrents simples sont bien connus de la personne du métier et ne sont redéfinis ici. Par exemple, le code source d'un réseau de neurones récurrent simple est disponible sur la page internet suivante :
https://github.com/keras-team/keras/blob/v2.14.0/keras/layers/rnn/simple_rnn.py#L193-L214.

La figure 3 représente un exemple de mode de réalisation d'une cellule 200 correspondant au convertisseur sigma-delta d'ordre M=1 de la figure 2.

La cellule 200 comprend une couche de neurones récurrente, ou dit, autrement, correspond à un réseau de neurones récurrent. La cellule ou couche de neurones 200 est dite récurrente en ce qu'elle reçoit ses sorties A11 et B11 sur ses entrées, et plus particulièrement qu'elle reçoit, à un cycle C[n] d'indice n donné, les sorties A11[n-1] et B11[n-1] du cycle C[n-1] précédent (le retard $z^{-1}$ d'un cycle n'étant pas représenté en figure 3).

A chaque cycle C[n], la cellule 200 reçoit également l'échantillon x[n-1] correspondant à ce cycle.

La cellule 200 est configurée pour multiplier chacune de ses entrées A11[n-1], B11[n-1] et x[n-1] par un poids correspondant respectivement W11a, W11b et W11x, et pour sommer les résultats de ces produits. Le résultat de la sommation correspond à la sortie A11[n], et la quantification de la sortie A11[n] par le quantificateur 106, qui correspond en fait à une couche d'activation ("activation layer" en anglais), résulte en la sortie B11[n]. Dans l'exemple de la figure 3, le quantificateur 106 est un quantificateur sur deux niveaux. Toutefois, la personne du métier sera en mesure d'adapter cet exemple au cas où le quantificateur 106 quantifie sur plus de deux niveaux. Par exemple, le quantificateur 106 peut être un quantificateur sur 4 niveaux et la sortie B11[n] peut alors prendre 4 valeurs quantifiées, de préférence uniformément réparties, par exemple entre -0,5 et 0,5 en reprenant les conditions de l'exemple de l'équation [Math 4] où B11 appartient à la plage -0,5 ; 0,5. Du fait que la cellule ou couche de neurones récurrente 200 fournit une sortie quantifiée B11, cette cellule récurrente ou couche de neurones récurrente 200 est, par exemple, dite à sortie quantifiée.

Dit autrement, la cellule 200 est configurée pour calculer le produit scalaire de son vecteur d'entrée X[n] = [x[n-1], A11[n-1], B11[n-1]] par son vecteur de poids W11 = [W11x, W11a, W11b], fournir la sortie A11[n] égale au résultat de ce produit scalaire, et fournir la sortie B11[n] correspondant à la quantification sur un bit de la sortie A11[n]. La cellule 200 fournit donc un vecteur de sortie Q1[n] = [A11[n], B11[n]].

Le modulateur 100 illustré en figure 1 est obtenu avec la cellule 200 lorsque les poids W11x, W11a et W11b sont respectivement égaux à 1, 1 et -1.

Dans l'exemple de la figure 3, les retards $z^{-1}$ d'un cycle ne sont pas représentés. Dans cet exemple, un retard d'un cycle est disposé sur le chemin de contre réaction reliant la sortie A11[n] à l'entrée A11[n-1] de la cellule 200, et un retard d'un cycle est disposé sur le chemin de contre réaction reliant la sortie B11[n] à l'entrée B11[n-1]. Toutefois, la personne du métier sera en mesure d'adapter cet exemple au cas où les chemins de contre réaction des données A11 et B11 sont dépourvus de retard, et où un retard d'un cycle est prévu entre le bloc sommateur de la cellule 200 et la sortie A11[n], comme cela est représenté dans l'exemple de la figure 1.

La figure 4 représente un exemple de mode de réalisation d'un réseau de neurones simple 202 correspondant à l'exemple de filtre 102 du convertisseur sigma-delta d'ordre M=1 de la figure 2. Le réseau de neurones 202 est dit simple en ce qu'il ne comprend qu'une seule couche de neurones récurrente.

Le réseau de neurones 202, c'est à dire sa couche de neurones, est récurrent en ce qu'il prend en entrée, à un cycle C[n] d'indice n donné, la sortie y[n-1] que le réseau 202 a fourni au cycle C[n-1] précédent. En outre, à un cycle C[n] d'indice n donné, le réseau 202 prend également en entrée la sortie B11[n] de la cellule 200. Dans cet exemple, le réseau 202 multiplie chacune de ses entrées y[n-1] et B11[n] par les poids correspondant Wc et Wd respectivement, et la sortie y[n] du réseau est alors égale à la somme de ces produits. En fixant Wc=1 et Wd=1/N, on retrouve l'exemple de filtre 102 de la figure 1 (dans laquelle la normalisation 1/N n'est pas représentée). On pourrait également introduire une normalisation dépendante de l'indice n, de sorte à obtenir une sortie y[n] normalisée pour chaque indice n en utilisant la relation de récurrence suivante :

[Math 7]

$$y[n] = \frac{B11[n] + (n-1)y[n-1]}{n}$$

Dans l'exemple de la figure 4, le retard $z^{-1}$ d'un cycle n'est pas représenté. Dans cet exemple, ce retard d'un cycle est disposé sur le chemin de contre réaction reliant la sortie y[n] à l'entrée y[n-1] de la cellule 202. Toutefois, la personne du métier sera en mesure d'adapter cet exemple au cas où le chemin de contre réaction de la donnée y est dépourvu de retard, et où ce retard d'un cycle est prévu entre le bloc sommateur de la cellule et la sortie y[n] de la cellule.

Les figures décrites ci-dessus montrent qu'une topologie particulière de convertisseur sigma-delta peut être

7

modélisée par un auto-encodeur comprenant un encodeur récursif 100 mis en œuvre à partir d'une cellule 200 de réseau de neurones récurrent et un décodeur récursif 102 mis en œuvre à partir d'un réseau de neurones récurrent simple.

A titre d'exemple, l'auto-encodeur décrit ci-dessus pourrait subir une étape d'apprentissage profond supervisé, par exemple pour obtenir des valeurs des poids W11a, W11b, W11x, Wy et Wb, bien que cela n'ait que peu d'intérêt pour un convertisseur sigma-delta d'ordre 1. En revanche, cela pourrait avoir un intérêt pour des convertisseurs sigma-delta d'ordre strictement supérieur à 1, à la condition de modéliser chacun de ces convertisseurs par un modèle basé sur des réseaux de neurones récurrents.

Toutefois, il existe de très nombreuses topologies différentes de convertisseurs de type sigma-delta. Ces topologies sont, par exemple déterminées par :

la nature du signal d'entrée ; et/ou
le type d'information que le convertisseur doit fournir en sortie ; et/ou
les performances que le convertisseur doit avoir en termes de précision de conversion ; et/ou
la surface maximale que doit avoir le convertisseur ; et/ou l'ordre M du convertisseur ; et/ou
la valeur N du taux de suréchantillonnage ; et/ou une robustesse au bruit souhaitée ; et/ou
des excursions maximales que doivent avoir des signaux de sortie des étages du convertisseur ; et/ou
des contraintes sur les poids du convertisseur, cette liste n'étant pas exhaustive.

Pour améliorer le fonctionnement d'un convertisseur de type sigma-delta donné ayant une topologie particulière, on pourrait penser à d'abord à réaliser à partir de cette topologie particulière un modèle spécifique de cette topologie, ce modèle comprenant un couple encodeur-décodeur avec un modèle d'encodeur (correspondant au modulateur) basé sur des réseaux de neurones récurrents et un modèle de décodeur (correspondant au filtre) basé également sur des réseaux de neurones récurrents, par exemple des réseaux de neurones récurrents simples. Une fois ce formalisme posé, un apprentissage profond supervisé pourrait alors être mis en œuvre sur le modèle extrait à partir de cette topologie particulière. Toutefois, la conception d'un tel modèle doit être adaptée à chaque topologie du convertisseur de type sigma-delta considéré, ce qui peut s'avérer complexe et fastidieux. En outre, ce travail de conception d'un modèle basé sur les réseaux de neurones récurrents devrait alors être fait pour chaque topologie différente de convertisseur de type sigma-delta, ce qui n'est pas souhaitable en raison du grand nombre de topologies différentes de convertisseur de type sigma-delta.

Il est ici proposé une méthode de conception d'un convertisseur de type sigma-delta dans laquelle un modèle générique de convertisseur est utilisé, et un apprentissage profond supervisé est appliqué à ce modèle générique pour obtenir un modèle dimensionné de convertisseur qui est ensuite fabriqué. En effet, le but de la présente description n'est pas d'entrainer un réseau de neurones pour ensuite programmer un processeur dédié à la mise en œuvre de réseaux de neurones, mais bien d'obtenir un circuit spécifique, par exemple un circuit intégré, satisfaisant un ensemble de spécifications, ou critères, liés à l'implémentation matérielle visée. Dit autrement, plutôt que de proposer une méthode de dimensionnement d'une topologie particulière de convertisseur de type sigma-delta en s'assurant séquentiellement de satisfaire un ensemble de spécifications liées à une implémentation matérielle visée, il est ici proposé un modèle générique de topologie de convertisseur sigma-delta. Le dimensionnement de ce modèle est optimisé, lors d'un apprentissage profond mis en œuvre sur le modèle, pour satisfaire conjointement un ensemble de spécifications matérielles. En effet, ces spécifications matérielles sont retranscrites sous la forme de contraintes et/ou de régularisations sur les poids et les données du modèle de sorte à limiter l'espace de recherche lors de l'apprentissage profond supervisé et à guider le processus d'apprentissage (ou d'optimisation) vers une topologie satisfaisant des spécifications attendues. Le convertisseur ainsi obtenu est, par exemple, désigné par le sigle RCN (de l'anglais "Recurrent Converter Network" ou "Recurrent Conversion Network" - Réseau de Conversion Récurrent).

Dit encore autrement, il est ici proposé une topologie générique ayant des degrés de liberté très importants d'interconnexions possibles entre des cellules internes, sans empreinte d'une topologie en particulier. Cette topologie générique permet de couvrir une multitude de configurations, sans a priori sur la configuration finale retenue. L'apprentissage profond va permettre d'affecter un poids particulier à chacune des interconnexions de sorte à converger vers une topologie finale adaptée aux données d'apprentissage. Le point de départ est donc une topologie générique (ou généraliste) ayant une pondération aléatoire des différentes interconnexions possibles (et donc agnostique du problème adressé) que l'on va spécialiser par apprentissage, ou bien avec une pondération correspondant à une structure de référence que l'on va vouloir faire évoluer.

Plus particulièrement, ce modèle générique, qui correspond à un auto-encodeur, comprend un encodeur récurrent correspondant au modulateur sigma-delta du modèle générique, et un décodeur récurrent correspondant au filtre du modèle générique. L'encodeur comme le décodeur correspondent à des couches de réseaux de neurones récurrents (RNN de l'anglais "recurrent neural network").

Encore plus particulièrement, le modèle de convertisseur proposé est dit générique car la modélisation de son encodeur est basée sur une cascade (ou succession) de K cellules génériques identiques, avec K un entier supérieur ou égal à 1, de préférence supérieur ou égal à 2, où chaque cellule générique correspond à un réseau de neurones récurrent. Le nombre K est alors un paramètre (ou hyper-paramètre) du modèle générique. Le nombre K est, par exemple, déterminé par l'ordre M visé du convertisseur, et est, par exemple, égal à M+1.

La figure 5 illustre un exemple de mode de réalisation d'une cellule générique Cellk, k étant un indice entier allant de 1 à K et identifiant la cellule Cellk parmi la succession des K cellules Cellk de l'encodeur récurrent.

A chaque cycle C[n], la cellule Cellk reçoit un vecteur d'entrée X[n]. Ce vecteur X[n] est mis à jour à chaque début d'un cycle C[n], à partir des données de sorties des K cellules Cellk obtenues à la fin du cycle C[n-1] précédent. Bien qu'une seule cellule Cellk soit représentée, lorsque le modèle générique comprend plusieurs cellules Cellk successives, ces cellules reçoivent le même vecteur X[n], qui est identique pour toutes les cellules Cellk au début de chaque cycle C[n].

La cellule Cellk comprend une couche (ou vecteur) Wk de poids, comprenant autant de poids qu'il y a d'éléments dans le vecteur d'entrée X[n] de la cellule Cellk.

La cellule Cellk est configurée, à chaque cycle C[n], pour multiplier chacune de ses entrées par un poids correspondant, pour fournir la somme Ak0[n] de ces produits, et la quantification Bk0[n] de cette somme. Dit autrement, la cellule Cellk est configurée, à chaque cycle, pour faire le produit scalaire de son vecteur d'entrée X[n] par son vecteur de poids Wk, le résultat de ce produit scalaire étant la sortie Ak0[n] de la cellule, et la quantification de la sortie Ak0[n] fournissant la sortie Bk0[n].

De préférence, pour permettre d'obtenir un modèle générique permettant une plus grande liberté de choix lors de l'étape d'apprentissage profond supervisé, la cellule Cellk est configurée pour fournir également des sorties correspondant aux sorties Ak0[n] et Bk0[n], mais avec un retard d'au moins un cycle de conversion. Dans l'exemple de la figure 5, la cellule Cellk fournit des sorties Ak1[n] et Bk1[n] correspondant aux sorties respectives Ak0[n] et Bk0[n] retardées d'un cycle, comme cela est représenté par un bloc D1 en figure 5.

Plus généralement, la cellule générique Cellk est donc configurée pour fournir, à chaque cycle C[n], D paires de sorties Akd[n], Bkd[n], avec Akd[n] le résultat du produit du vecteur d'entrée X[n-d] par le vecteur de poids Wk, et Bkd[n] la quantification du résultat du produit du vecteur d'entrée X[n-d] par le vecteur de poids Wk, D étant un entier supérieur ou égal à 1, de préférence à 2, et d étant un indice entier allant de 0 à D-1.

Ainsi, pour un cycle C[n] d'indice n donné, la sortie Ak0[n] correspond au produit scalaire X[n].Wk (aussi noté <X[n],Wk>) calculé par la cellule Cellk à ce cycle, la sortie Bk0[n] correspondant à la quantification de la sortie Ak0[n].

En outre, pour ce même cycle C[n], la sortie Akd[n] correspond au produit scalaire X[n-d].Wk, et la sortie Bkd[n] correspond à la quantification de la sortie Akd[n]. Dit autrement, au début de chaque cycle de conversion C[n], Akd[n] = Ak0[n-d] et Bkd[n] = Bk0[n-d]. Dit encore autrement, au début de chaque cycle de conversion C[n], la sortie Akd[n] correspond à la sortie Ak0[n] calculée par la cellule Cellk d cycles avant le cycle C[n] et la sortie Bkd[n] correspond à la sortie Bk0[n] calculée par la cellule Cellk d cycles avant le cycle C[n]. Dit encore d'une autre façon, à chaque début de cycle C[n], Akd[n] ← Akd-1[n-1] et Bkd[n] ← Bkd-1[n-1], avec "←" un opérateur mathématique signifiant "reçoit".

Dans l'exemple de la figure 5, et dans la suite de la description, D est, à titre d'exemple, choisi égal à 2, et la cellule Cellk fournit alors, à chaque cycle C[n], une paire de sorties Ak0[n], Bk0[n] non retardées, et une paire de sorties Ak1[n], Bk1[n] retardées d'un cycle. En figure 5, pour chaque valeur de d non nulle, un bloc Dd représente l'application d'un retard de d cycles entre la paire de sorties Ak0[n], Bk0[n] non retardées, et une paire de sorties Akd[n], Bkd[n] retardées de d cycles. Dans l'exemple de la figure 5, la cellule Cellk comprend un bloc D1.

On notera que l'entier D est un paramètre (ou hyper-paramètre) du modèle générique proposé.

A chaque cycle C[n], l'ensemble des D paires de sorties Akd[n], Bkd[n] forme le vecteur de sortie Qk[n] de la cellule Cellk.

A chaque cycle C[n], le vecteur X[n] d'entrée de chacune des K cellules Cellk est alors le même pour toutes les cellules, au moins au début du cycle C[n] avant que les cellules Cellk calculent leurs sorties Ak0[n] et Bk0[n] qui sont donc mises à jour pendant le cycle C[n]. Le vecteur X[n] est égal à la concaténation de l'échantillon x[n] au début du cycle C[n] et des K vecteurs de sortie Qk[n] des K cellules Cellk qui sont mis à jour pendant le cycle à partir de l'échantillon x[n]. Le vecteur X[n] comprend donc 1 + K.2.D éléments (ou entrées pour les cellules Cellk), de même que le vecteur Wk de chaque cellule Cellk comprend 1+K.2.D éléments (ou poids de la cellule Cellk). A chaque cycle C[n], les valeurs Ak0[n] et Bk0[n] sont mises à jour pendant le cycle C[n] à partir de la valeur de x[n] au début du cycle.

Ainsi, pour chaque cellule Cellk d'indice k égal à p, avec p un indice entier allant de 1 à K, le vecteur Wp des poids de la cellule Cellp, c'est à dire le vecteur Wk des poids de la cellule Cellk d'indice k égal à l'indice p considéré, comprend : un poids Wpx appliqué à l'entrée x[n] de la cellule Cellp ; et K fois D paires de poids Wapkd, Wbpkd, avec p l'indice entier de la cellule Cellp considérée et k allant de 1 à K.

Dans chaque cellule Cellk d'indice k égal à p, ou, dit autrement, dans chaque cellule Cellp, pour k allant de 1 à K et pour d allant de 0 à D-1, le poids Wapkd de la cellule Cellp est appliqué à la sortie Akd[n] de la cellule Cellk, cette sortie Akd[n] de la cellule Cellk étant une entrée de la cellule Cellp, et le poids Wbpkd est appliqué à la sortie Bkd[n] de la cellule Cellk, cette sortie Bkd[n] de la cellule Cellk étant une entrée de la cellule Cellp.

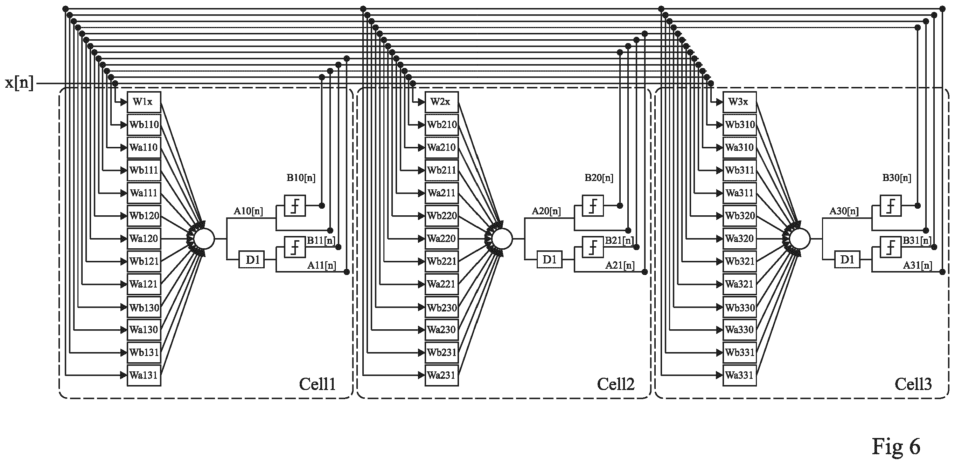

La figure 6 illustre par un exemple le formalisme décrit ci-dessus.

La figure 6 représente un exemple d'encodeur 200 basé sur un modèle générique à K=3 cellules Cellk successives, dans le cas où D est égal à 2.

Les cellules Cellk (Cell1, Cell2 et Cell3 dans l'exemple de la figure 6) sont connectées les unes à la suite des autres par ordre d'indice k croissant. Dit autrement, à chacun des N cycles d'une conversion, les cellules Cellk mettent à jour leurs sorties Ak0[n] et Bk0[n] les unes après les autres par ordre d'indice k croissant, ou, dit encore autrement, mettent à jour leurs sorties non retardées de manière séquentielle et par ordre d'indice k croissant. Chaque mise à jour des sorties Ak0[n] et Bk0[n] par une cellule Cellk correspondante s'effectue pendant une partie du cycle C[n] correspondant, cette partie du cycle C[n] étant, par exemple, appelé intra-cycle, par exemple intra-cycle d'indice k. Une fois qu'une cellule Cellk a mise à jour ses sorties non retardées lors de l'intra-cycle d'indice k, la cellule Cellk+1 suivante met à jour ses sorties non retardées lors de l'intra-cycle suivant d'indice k+1. Une fois que toutes les cellules Cellk ont mis à jour leurs sorties non retardées, les sorties retardées des cellules Cellk sont mises à jour à la fin du cycle C[n], et le cycle C[n+1] suivant peut débuter.

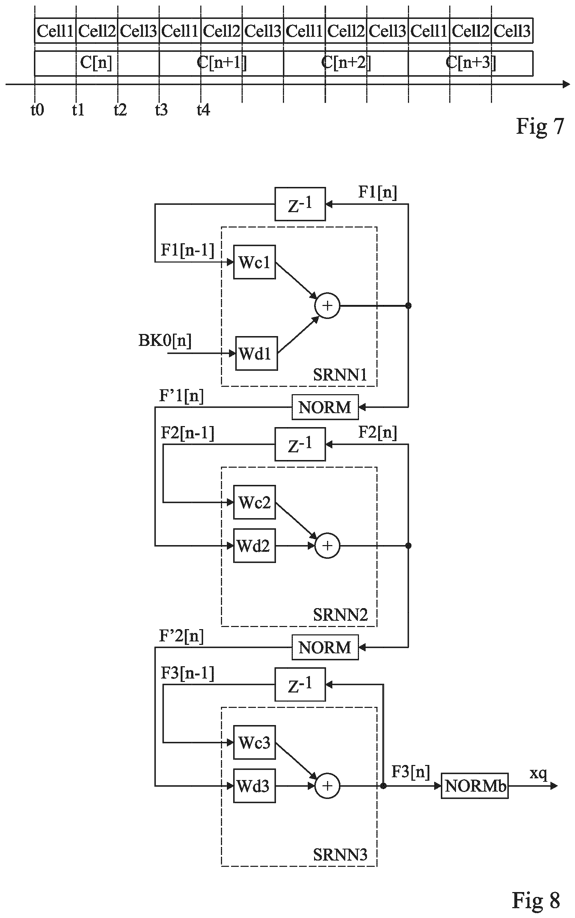

La figure 7 illustre la mise à jour séquentielle des sorties non retardées des cellules Cellk, et, plus particulièrement dans cet exemple, la mise à jour des sorties des cellules Cellk dans le cas où K est égal à 3.

A un instant t0 le nième cycle de conversion C[n] débute.

De l'instant t0 à un instant t1 suivant, toujours dans le cycle C[n], la cellule Cell1 calcule le produit X[n].W1, et, à l'instant t1, les nouvelles sorties A10[n] et B10[n] de la cellule Cell1 sont disponibles. Les sorties A10[n] et B10[n] sont donc mises à jour à l'instant t1, et ne changent plus jusqu'à la fin du cycle C[n].

De l'instant t1 à un instant t2 suivant, toujours dans le cycle C[n], la cellule Cell2 calcule le produit X[n].W2, et, à l'instant t2, les sorties A20[n] et B20[n] de la cellule Cell2 sont disponibles. Les sorties A20[n] et B20[n] sont donc mises à jour à l'instant t2, et ne changent plus jusqu'à la fin du cycle C[n].

De l'instant t2 à un instant t3 suivant, toujours dans le cycle C[n], la cellule Cell3 calcule le produit X[n].W3, et, à l'instant t3, les sorties A30[n] et B30[n] de la cellule Cell2 sont disponibles. Les sorties A30[n] et B30[n] sont donc mises à jour à l'instant t3, et ne changent plus jusqu'à la fin du cycle C[n].

L'instant t3 marque la fin du cycle C[n] et le début du cycle C[n+1] suivant. Ainsi, à l'instant t3, pour chaque cellule Cellk, les sorties retardées des cellules sont mises à jour, ou, dit autrement, à chaque début de cycle C[n+1], Akd[n+1] = Akd-1[n] et Bkd[n+1] = Bkd-1[n]. Par exemple, à l'instant t0, la sortie retardée A11[n] de la cellule Cell1 est mise à jour avec la valeur de la sortie A10[n-1] calculée par la cellule Cell1 au cycle C[n-1] précédent. Dit autrement, à chaque début de cycle C[n+1], c'est à dire à chaque fin de cycle C[n], Akd[n+1] ← Akd-1[n] et Bkd[n+1] ← Bkd-1[n], avec "←" un opérateur mathématique signifiant "reçoit". Les données Akd[n+1], Bkd[n+1] disponibles à chaque début de cycle C[n+1] constituent, par exemple, les données inter-cycle. Les données inter-cycle sont disponibles à chaque passage d'un cycle C[n] au cycle C[n+1] suivant, par exemple aux instants t0 et t3 en figure 7.

Ensuite, le fonctionnement décrit pour le cycle C[n] se répète au cycle C[n+1]. Par exemple, entre l'instant t3 et un instant t4, la cellule Cell1 calcule le produit X[n+1].W1, et, à l'instant t4, les sorties A10[n+1] et B10[n+1] de la cellule Cell1 sont disponibles, et ainsi de suite.

En revenant à l'exemple de la figure 6, les mises à jour des sorties non retardées Ak0[n], Bk0[n] des cellules Cellk s'effectuent donc de gauche à droite lors de chaque cycle C[n]. Ainsi, dans cet exemple, lors d'un cycle C[n] donné, les sorties A10[n] et B10[n] de la cellule Cell1 sont mises à jour avant les sorties A20[n] et B20[n] de la cellule Cell2, ces deux sorties étant elles-mêmes mises à jour avant les sorties A30[n] et B30[n] de la cellule Cell3. Cette mise à jour des sorties Ak0[n] et Bk0[n] pendant le cycle C[n] est appelée, par exemple, mise à jour intra-cycle. La mise à jour intra cycle diffère de la mise à jour des sorties Akd[n] et Bkd[n], où d est strictement positif, qui est faite à partir des sorties Ak0[n] et Bk0[n] entre deux cycles successifs et qui est appelée, par exemple, mise à jour, ou transfert, inter-cycle. Par exemple, dans chaque cycle C[n], les données de sortie mises à jour à chaque intra-cycle de ce cycle C[n] constituent les données intra-cycle du cycle C[n]. Par exemple, en figure 7, les données intra-cycle du cycle C[n] sont disponibles aux instants t1, t2, t3.

Dans l'exemple de la figure 6, le vecteur W1 des poids de la cellule Cell1 est constitué des K*2*D+1 = 13 poids suivants :

W1x, Wb110, Wa110, Wb111, Wa111, Wb120, Wa120, Wb121, Wa121, Wb130, Wa130, Wb131, Wa131,
le vecteur W2 des poids de la cellule Cell2 est constitué des K.2.D+1 = 13 poids suivants :

W2x, Wb210, Wa210, Wb211, Wa211, Wb220, Wa220, Wb221, Wa221, Wb230, Wa230, Wb231, Wa231, et
le vecteur W3 des poids de la cellule Cell3 est constitué des K.2.D+1 = 13 poids suivants :
W3x, Wb310, Wa310, Wb311, Wa311, Wb320, Wa320, Wb321, Wa321, Wb330, Wa330, Wb331, Wa331.

Ainsi, la matrice WM des poids de l'exemple de modèle générique d'encodeur de la Figure 6 peut s'écrire :

[Math 8]

$$WM^T = (W1; W2; W3)^T = \begin{pmatrix} W1x & W2x & W3x \\ Wb110 & Wb210 & Wb310 \\ Wa110 & Wa210 & Wa310 \\ Wb111 & Wb211 & Wb311 \\ Wa111 & Wa211 & Wa311 \\ Wb120 & Wb220 & Wb320 \\ Wa120 & Wa220 & Wa320 \\ Wb121 & Wb221 & Wb321 \\ Wa121 & Wa221 & Wa321 \\ Wb130 & Wb230 & Wb330 \\ Wa130 & Wa230 & Wa330 \\ Wb131 & Wb231 & Wb331 \\ Wa131 & Wa231 & Wa331 \end{pmatrix}$$

avec T l'opérateur matriciel transposé.

Le modèle générique proposé permet un plus grand nombre de degrés de liberté dans la mise en œuvre matérielle par rapport au modèle de l'exemple des figures 3 et 4 qui est très spécifique à l'exemple de convertisseur de la figure 1.

En effet, le modèle générique d'encodeur proposé permet d'explorer une grande diversité de topologies possibles, dans lequel chaque cellule Cellk a accès, sur ses entrées, aux sorties de chacune des K cellules Cellk du modèle. Par exemple, le modèle générique d'encodeur proposé permet d'explorer par apprentissage profond supervisé des solutions techniques, c'est à dire des topologies, qui seraient difficiles, voire impossibles, à dimensionner avec des approches analytiques usuelles. Cela permet également de proposer des topologies originales exploitant conjointement les données quantifiées en sortie des différentes cellules. Des topologies de type MASH (de l'anglais "Multi-Stage Noise Shaping" - mise en forme pluri-étages du bruit) sont proposées dans la littérature, dans lesquelles l'erreur de quantification est transférée à chaque cycle d'un modulateur amont à un modulateur aval. L'approche proposée permet de dépasser cette technique MASH en transférant d'une cellule à l'autre, ou d'un groupe de cellule à un autre, toute configuration possible de signaux.

La figure 8 représente un exemple de filtre 102 pouvant être utilisé dans un modèle générique de convertisseur de type sigma delta basé sur un encodeur à K cellules Cellk.

Dans cet exemple, le convertisseur de type sigma-delta considéré est configuré pour convertir un signal x analogique (c'est à dire non discrétisé) et continu en un signal numérique, et est réinitialisé à chaque conversion, chaque conversion comprenant N cycles C[n].

Pour un tel convertisseur, le filtre 102 est alors composé, par exemple, d'une succession de Q cellules SRNNq correspondant chacune à un réseau de neurones récurrent simple SRNNq du type de celui décrit en relation avec la figure 4, avec q un indice entier allant de 1 à Q, et Q un nombre entier. A titre d'exemple, Q au moins égal, de préférence égal, au nombre K de cellules Cellk de l'encodeur. Dans cet exemple, Q est égal à 3 et le filtre 102 est dimensionné pour un convertisseur comprenant par exemple K=3 cellules Cellk. Ainsi, dans cet exemple, le filtre 102 comprend Q égal 3 cellules successives SRNN1, SRNN2 et SRNN3.

Les réseaux SRNNq sont connectés les uns à la suite des autres par ordre d'indice q croissant. Chaque réseau SRNNq fournit, à chaque cycle C[n], une sortie Fq[n].

Dans cet exemple, chaque réseau SRNNq comprend une première entrée, une deuxième entrée, et une sortie. La première entrée de chaque réseau SRNNq est couplée à la sortie de ce réseau SRNNq, la deuxième entrée du premier réseau SRNN1 étant couplée à une sortie de l'encodeur, et la deuxième entrée de chaque réseau SRNNq suivant étant couplée à la sortie du réseau SRNNq-1 précédent.

Par exemple, à chaque cycle C[n], chaque réseau SRNNq reçoit sa sortie Fq retardée d'un cycle (bloc $z^{-1}$ en figure 8), c'est-à-dire sa sortie Fq[n-1] du cycle C[n-1] précédent, sur sa première entrée.

Dans cet exemple, la deuxième entrée du premier réseau SRNN1 reçoit un flux de données quantifiées fourni par la cellule Cellk d'indice k égal à K, par exemple le flux de données quantifiées BK0 fourni par la dernière cellule Cellk de la succession des K cellules Cellk de l'encodeur. A titre d'autre exemple, la deuxième entrée du premier réseau SRNN1 reçoit un flux de données quantifiées retardées de d cycles fourni par la cellule CellK, par exemple le flux de données quantifiées retardées de d=1 cycle BK1. Dans cet exemple, la deuxième entrée du premier réseau SRNN1 reçoit donc le flux de données quantifiées B30. Plus particulièrement, dans cet exemple, à chaque cycle C[n], la deuxième entrée du premier réseau SRNN1 reçoit la sortie B30[n] de la cellule Cell3.

**EP 4 625 826 A1**

Pour q supérieur ou égal à 2, c'est à dire pour les réseaux SRNNq autre que le premier réseau SRNN1, la deuxième entrée de chaque réseau SRNNq est couplée à la sortie du réseau SRNNq-1 précédent. Bien que cela ne soit pas le cas dans cet exemple, dans d'autres exemples non illustrés, un ou plusieurs réseaux SRNNq peut comprendre, outre sa deuxième entrée couplée à la sortie du réseau SRNNq-1 précédent, une troisième entrée couplée à la sortie d'un réseau SRNNq-g précédent, avec g un indice entier supérieur ou égal à 2. En outre, bien que cela ne soit pas le cas dans l'exemple de la figure 8, chaque réseau SRNNq d'indice q strictement supérieur à 1 peut avoir une entrée supplémentaire recevant, comme le réseau SRNN1, la donnée BK0[n].

Dans cet exemple, pour q supérieur ou égal à 2, la deuxième entrée de chaque réseau SRNNq est couplée à la sortie Fq-1 du réseau SRNNq-1 précédent par un étage de normalisation NORM présent sur la sortie de l'étage SRNNq-1. Dit autrement, pour q strictement inférieur à 3, la sortie de chaque réseau SRNNq est couplée à la deuxième entrée du réseau suivant SRNNq+1 par un étage de normalisation NORM. L'objectif de ces étages NORM est de faciliter l'apprentissage profond. Ces étages NORM n'ont pas nécessairement d'équivalence matérielle. Ces étages NORM sont optionnels. Ainsi, pour q supérieur ou égal à 2, la deuxième entrée de chaque réseau SRNNq reçoit une donnée Fq-1' correspondant à la normalisation par un étage NORM de la sortie Fq-1 de l'étage SRNNq-1 précédent. Par exemple, à chaque cycle C[n], pour q supérieur ou égal à 2, la deuxième entrée de chaque réseau SRNNq reçoit une donnée Fq-1'[n].

Par exemple, chaque étage NORM met à l'échelle la sortie Fq-1 de l'étage SRNNq-1 qui le précède pour fournir une sortie Fq-1' normalisée pour une séquence de N cycles successifs. A titre d'exemple, chaque étage de normalisation NORM est configuré pour que, pour chacun des N cycles d'une conversion, la sortie de l'étage NORM ne dépasse pas une valeur maximale donnée, par exemple 1. Par exemple, chaque étage NORM applique, à chaque cycle C[n], un gain à la donnée qu'il reçoit pour fournir sa donnée de sortie, ce gain pouvant dépendre de l'indice n du cycle considéré.

Dans un autre exemple, les étages de normalisation NORM entre les réseaux SRNNq sont omis, et la deuxième entrée de chaque réseau SRNNq d'indice q supérieur ou égal à 2 reçoit directement la sortie Fq-1 du réseau SRNNq-1 précédent.

Le filtre comprend en outre un étage de normalisation NORMb configuré pour recevoir la sortie Fq du dernier réseau SRNNq, c'est-à-dire la sortie F3 dans cet exemple, et pour fournir le signal xq.

L'étage de normalisation NORMb est configuré pour mettre la valeur de sortie xq de sortie du filtre à la même échelle que le signal d'entrée x du convertisseur, de sorte à permettre une reconstruction du signal x à chaque cycle C[n] de conversion. Le signal xq correspond alors à la sortie de l'étage NORMb. A titre de variante, ces étages de normalisation peuvent également intégrer un biais, afin de réaliser une fonction affine du type : $F'x[n] = a.Fx[n]+b$, ou a et b sont respectivement le gain et l'offset de la fonction NORMb.

A chaque cycle C[n], chaque réseau SRNNq est configuré pour calculer le produit scalaire entre son vecteur d'entrée et un vecteur de poids correspondant, et pour mettre à jour sa sortie avec le résultat de ce produit scalaire. En particulier, pour chaque réseau SRNNq, le vecteur d'entrée du réseau au cycle C[n] comprend la sortie Fq[n-1] fournie par ce même réseau au cycle C[n-1] précédent ainsi que la sortie du réseau SRNNq-1.

Dans cet exemple où chaque réseau SRNNq comprend deux entrées et une sortie, chaque réseau SRNNq comprend un vecteur de poids ayant un premier poids Wcq appliqué à la première entrée du réseau SRNNq considéré, et un deuxième poids Wdq appliqué à la deuxième entrée du réseau SRNNq considéré.

Par exemple, à chaque cycle C[n] :

- la sortie F1[n] du réseau SRNN1 correspond à la somme de son entrée F1[n-1] multipliée par un poids Wc1 et de son entrée B30[n] multipliée par un poids Wd1 ;
- la sortie F2[n] du réseau SRNN2 correspond à la somme de son entrée F2[n-1] multipliée par un poids Wc2 et de son entrée F'1[n] multipliée par un poids Wd2 ; et
- la sortie F3[n] du réseau SRNN3 correspond à la somme de son entrée F3[n-1] multipliée par un poids Wc3 et de son entrée F'2[n] multipliée par un poids Wd3.

On a décrit ci-dessus un exemple de filtre adapté à un convertisseur de type sigma-delta configuré pour convertir, en N cycles, un signal analogique continu x en un signal numérique xq, ce convertisseur étant réinitialisé à chaque début de conversion.

Selon un mode de réalisation, quel que soit le convertisseur de type sigma-delta considéré, le filtre du convertisseur est mis en œuvre à partir d'une ou plusieurs mises en cascade (ou successions) de réseaux de neurones récurrents simples, ou cellules, avec ou sans étage de normalisation NORM en sortie d'un ou plusieurs de ces réseaux.

Les figures décrites précédemment illustrent un modèle de convertisseur de type sigma-delta constitué d'un encodeur basé sur modèle générique mis en œuvre par K cellules Cellk génériques de réseaux de neurones récurrents, et d'un décodeur mis en œuvre à partir de plusieurs réseaux de neurones récurrents simples aussi appelés cellules.

Il est alors possible de mettre en œuvre un apprentissage profond supervisé sur ce modèle de convertisseur.

Bien que l'on ait décrit ci-dessus un exemple de modèle de convertisseur de type sigma-delta dans lequel l'encodeur est obtenu à partir d'un modèle générique où K est égal à 3, et dans lequel le décodeur est du type décrit en relation avec la figure 8, de nombreux autres modèles de convertisseurs de type sigma-delta peuvent être obtenus à partir de la cellule générique Cellk, par exemple en changeant la valeur K et/ou la valeur D et/ou le modèle de filtre utilisés pour le modèle.

De manière usuelle, l'apprentissage profond supervisé est mis en œuvre à l'aide d'un ensemble de données d'entrainement, en définissant une fonction de coût Fcost que l'on cherche à minimiser lors de l'entrainement profond supervisé avec les données d'entrainement. Plus particulièrement, les valeurs des poids de l'encodeur et du décodeur sont optimisées lors de l'apprentissage profond pour minimiser la fonction de coût.

La fonction Fcost comprend une fonction, ou terme, de fidélité Ffid qui exprime, pour chaque donnée d'entrainement fournie en entrée du modèle, donc du convertisseur, une image de l'erreur entre la ou les valeurs de sortie du modèle et la ou les valeurs de sortie attendues (idéales) pour cette entrée.

A titre d'exemple, dans le cas d'un convertisseur sigma-delta configuré pour convertir un signal analogique continu de valeur xa en un signal numérique xq correspondant, réinitialisé à chaque conversion de N cycles, la fonction de fidélité compare, pour chaque donnée d'entraînement, l'écart entre la valeur xa du signal x fourni en entrée du modèle et la valeur de la contrepartie numérique xq obtenue pour cette valeur xa du signal d'entrée x.

Toutefois, la personne du métier sera en mesure d'adapter les exemples indiqués ci-dessous de fonction de coût, et en particulier les exemples de fonction de fidélité, au cas d'un convertisseur de type sigma-delta réinitialisé à chaque conversion et ayant une autre fonction que la conversion d'un signal analogique continu en un signal numérique, par exemple à un convertisseur de type sigma-delta configuré pour extraire un ou plusieurs paramètres latents d'une entrée du convertisseur. Dit autrement, la personne du métier saura adapter ces exemples de fonction de coût, et en particulier les exemples de fonction de fidélité, au cas où ce qui est minimisé est l'erreur entre un paramètre latent extrait par le convertisseur sur une donnée d'entrainement fournie en entrée du convertisseur, et le paramètre latent attendu correspondant à cette donnée d'entrainement.

A titre d'exemple, pour chaque lot d'entrainement ("batch" en anglais) de dimension S, c'est à dire qu'un lot comprend, dans cet exemple, S valeurs xa d'entrée, avec S un entier strictement positif, la fonction Ffid(xa, xq) du lot peut être basée sur l'erreur quadratique moyenne Frmse(xa, xq) entre les S couples de valeurs xa[s] et xq[s] du lot, avec s indice entier allant de 1 à S :

[Math 9]

$$Frmse(xa, xq) = \sqrt{\frac{1}{S} \sum_{s=1}^{S} (xa[s] - xq[s])^2}$$

A titre d'autre exemple, la fonction Fid(xa,xq) de chaque lot d'entrainement peut être basée sur une fonction Flse logarithme de la somme des exponentielle des différences entre les S valeurs xa[s] et xq[s] du lot :

[Math 10]

$$Flse(xa, xq) = \log\left(\frac{1}{S} \sum_{s=1}^{S} e^{(|xa[s] - xq[s]|)}\right)$$

A titre d'autre exemple, la fonction Fid(xa, xq) de chaque lot d'entrainement peut être basée sur une combinaison linéaire Fmix(xa, xq) des fonctions Frmse et Flse :

[Math 11]

$$Fmix(xa, xq) = A * Frmse(xa, xq) + B * Flse(sa, xq) \text{ ,}$$

avec A et B des facteurs positifs dont la somme est égale à 1, par exemple égaux respectivement à 0,8 et 0,2 bien que la personne du métier soit en mesure de prévoir d'autres valeurs.

A titre d'autre exemple, la fonction Fid(xa, xq) de chaque lot d'entrainement peut être basée une combinaison linéaire Fmax(xa, xq) de l'erreur maximale entre les valeurs xa[s] et xq[s] du lot et de la norme $L^p$ de l'erreur entre les valeurs xa[s] et xq[s] du lot :

[Math 12]

$$Fmax(xa, xq) = C1 * \max_S \{|xa[s] - xq[s]|\} + C2 * \left(\frac{1}{S} * \sum_{s=1}^{S} |xa[s] - xq[s]|^p\right)^{\frac{1}{p}}$$

Avec

[Math 13]

$$\begin{cases} \dfrac{C1 * \max_S\{|xa[s] - xq[s]|\}}{C2 * \left(\frac{1}{S} * \sum_{s=1}^{S} |xa[s] - xq[s]|^p\right)^{\frac{1}{p}}} = 0,5, \\ C1 + C2 = 1 \end{cases}$$

où p est l'indice de la norme L$^p$, par exemple p est égal à 5 pour la norme L$^5$, et où max$_s$\{|xa[s] - xq[s]|\} la fonction retournant l'erreur maximale, en valeur absolue, de conversion pour le lot d'entrainement considéré comprenant S couples d'une valeur d'entrée xa[s] et d'une valeur de sortie (ou valeur convertie) xq[s], étant entendu que dans cet exemple de convertisseur de type sigma-delta, la valeur de sortie attendue pour une valeur xa[s] d'entrée donnée est égale à cette valeur d'entrée.

Bien que l'on ait décrit ci-dessus quatre exemples de fonctions de fidélité Ffid(xa, xq), la personne du métier est en mesure de prévoir d'autres fonctions de fidélité adaptées à un modèle de convertisseur de type sigma-delta configuré pour convertir un signal analogique continu x de valeur xa en un signal numérique xq, où le convertisseur est réinitialisé à chaque conversion de N cycles. Plus généralement, la personne du métier est en mesure de prévoir des fonctions de fidélité adaptées à des modèles de convertisseurs de type sigma-delta qui sont réinitialisés à chaque conversion de N cycles mais qui ont pour but l'extraction d'un ou plusieurs paramètres latents d'une entrée fournie au convertisseur. A titre d'exemple, ces fonctions de fidélité pourront être adaptées de sorte à optimiser différentes métriques (erreur maximale, erreur moyenne, autorisation de point aberrant, etc.).

Dans les exemples de fonctions de fidélité Ffid(xa, xq) décrites ci-dessus, pour chaque donnée d'entrée d'indice s d'un lot d'entrainement donné, l'erreur calculée entre l'entrée xa[s] et sa contrepartie numérique xq[s] est calculée uniquement à la fin de la conversion, c'est à dire au cycle d'indice N. Toutefois, la personne du métier sera en mesure d'adapter ces exemples de fonctions de fidélité au cas où, pour chaque donnée d'entrée d'indice s d'un lot donné, l'image de l'erreur est calculée, dans le cas d'une régression simple, comme une somme, par exemple pondérée, des erreurs calculées à chacun des N cycles de conversion entre la donnée d'entrée et sa contrepartie numérique. Une telle pondération permet, par exemple, de tenir compte de la diminution de l'erreur avec l'augmentation de l'indice n pendant les N cycles de conversion, et, par exemple, également de maximiser la performance du convertisseur pour chaque cycle de conversion.

De manière usuelle, la fonction Fcost peut, en plus d'être basée sur une fonction de fidélité Ffid, être basée ou comprendre une ou plusieurs fonctions de régularisation. Ces fonctions de régularisation sont, par exemple, appliquées à des couches du modèles ou mises en œuvre dans le modèle sous la forme d'une couche spécifique n'ayant pas forcément de contrepartie matérielle. De manière usuelle, une régularisation est appliquée sur des poids ou des données du modèle et a pour but de guider l'apprentissage profond supervisé, par exemple en exprimant un résultat visé (c'est à dire une spécification visée), par exemple dans l'implémentation matérielle qui sera faite du convertisseur à partir du modèle entraîné.

Ainsi, selon un mode de réalisation, la fonction Fcost comprend au moins une fonction de régularisation.

Selon un mode de réalisation, ladite au moins une fonction de régularisation est déterminée par une propriété fonctionnelle et/ou une propriété matérielle du convertisseur que l'on souhaite obtenir après l'apprentissage profond supervisé.

Selon un mode de réalisation, l'une de ces régularisations vise à assurer que les excursions des signaux internes du modulateur soient bornées, ce qui permet d'éviter des saturations dans le convertisseur matériel qui sera fabriqué à partir du modèle entraîné.

Selon un mode de réalisation, une fonction de régularisation vise à conserver, pour chaque lot d'entrainement, et pour chacune des S données d'entraînement du lot, les signaux Ak0 de sortie des K cellules Cellk de l'encodeur dans K plages de valeurs respectives allant de - Δk à +Δk, avec Δk une valeur de seuil positive par exemple déterminée par la valeur de la tension d'alimentation que recevra le convertisseur. En définissant, pour chaque lot d'entrainement, Ak0[s] comme la valeur maximale prise lors des N cycles d'une conversion par le signal Ak0 pour une donnée d'entrée xa de rang s du lot d'entrainement considéré, cette fonction de régularisation Fdr(Ak0) peut, par exemple, s'écrire, pour chaque lot d'entrainement :

[Math 14]

$$Fdr(Ak0) = \sqrt{\frac{1}{K} \sum_{s=1}^{S} \sum_{k=1}^{K} (Ak0[s] - clip(Ak0[s], -\Delta k, \Delta k))^2}$$

avec clip(Ak0[s], -$\Delta$k,$\Delta$k) la fonction qui force la valeur Ak0[s] à la valeur -$\Delta$k lorsque que Ak0[s] est inférieure à -$\Delta$k, et à +$\Delta$k lorsque la valeur Ak0[s] est supérieure à +$\Delta$k. A titre d'exemple, dans la suite de la description, $\Delta$k est égal à 0,4 dans cet exemple où les signaux (ou données) quantifiées dans l'encodeur, c'est à dire les signaux Bkd, ont une dynamique correspondant à une plage allant de -0,5 à 0,5.

Ainsi, selon un mode de réalisation, la fonction Fcost peut s'écrire :

[Math 15]

$$Fcost(xa, xq, Ak0) = Ffid(xa, xq) + \lambda * Fdr(Ak0)$$

avec $\lambda$ un facteur scalaire.

De la même façon qu'une fonction de fidélité, pour chaque donnée d'entrainement d'indice s d'un lot d'entrainement donné, une fonction de régularisation peut n'être calculée qu'au Nième cycle de conversion, ou, en variante, être calculée à au moins un cycle C[n] particulier, par exemple à chacun des N cycles C[n] de conversion. En outre, une fonction de régularisation calculée à un cycle C[n] donné peut être calculée à partir d'une séquence de données obtenue jusqu'à ce cycle, et peut être non linéaire, par exemple correspondre à une valeur minimale ou maximale d'un calcul effectué sur ces données, ou linéaire, par exemple correspondre à une somme pondérée d'un calcul effectué sur ces données.

La fonction de régularisation Fdr dans la fonction de Fcost vise avantageusement à assurer la stabilité du modulateur récurrent pour une valeur N donnée de taux de suréchantillonnage.

Bien entendu, la personne du métier sera en mesure de prévoir d'autres fonctions de régularisation déterminées par des propriétés fonctionnelles et/ou matérielles du convertisseur à fabriquer.

Outre la fonction Fcost déterminée par une fonction de fidélité Ffid et, de manière préférable, par au moins une fonction de régularisation, des contraintes et/ou des termes de régularisation peuvent être appliquées au modèle générique.

Ainsi, selon un mode de réalisation, au moins une contrainte et/ou au moins un terme de régularisation est appliqué au modèle générique, sur les poids du modèle ou sur les données.

Selon un mode de réalisation, au moins une contrainte et/ou au moins une régularisation (ou terme de régularisation) appliquée au modèle générique est déterminée par une propriété matérielle et/ou une propriété fonctionnelle que le convertisseur à fabriquer doit respecter.

A titre d'exemple, une contrainte correspond à une caractéristique que l'on force dans le modèle, lors de l'apprentissage profond supervisé. Une contrainte peut être mise en œuvre en ajoutant une couche au modèle qui n'aura pas de contrepartie matérielle (ou autrement dit de déclinaison matérielle), en appliquant par exemple un masque aux poids du modèle, ou en appliquant une fonction à des couches du modèle. Une contrainte peut s'appliquer aux tenseurs de données ("data tensor" en anglais) du modèle, ou aux poids du modèle. Une contrainte est, par exemple, une fonction ou une couche qui agit directement sur les données ou les poids qu'elle reçoit, c'est à dire qui peut modifier les valeurs de ces données ou de ces poids.

A titre d'exemple, une régularisation vise à guider l'apprentissage en vue d'obtenir un résultat souhaité dans le modèle entrainé ou dans sa contrepartie matérielle. Une régularisation peut être mise en œuvre en ajoutant une couche au modèle qui n'aura pas de contrepartie matérielle et qui aura pour but de calculer des grandeurs sur les données la traversant sans modifier ces données, ces grandeurs étant ensuite utilisées dans le calcul de la fonction de coût, par exemple en étant ajoutées à la fonction de fidélité. Une régularisation peut également être mise en œuvre en appliquant une fonction à des couches du modèle. Une régularisation peut s'appliquer aux tenseurs de données ("data tensor" en anglais) du modèle et est alors par exemple appelé régularisateur d'activité (" activity regularizer " en anglais), ou aux poids du modèle et est alors par exemple appelé régularisateur de noyau (" kernel regularizer " en anglais). Les couches ou fonctions de régularisation sur les poids ou les données permettent, par exemple, d'affecter des pénalités supplémentaires à la fonction de coût, ces pénalités étant définies par des écarts entre des grandeurs calculées sur les poids latents ou les données du modèle et des valeurs attendues pour ces grandeurs.

Selon un mode de réalisation, une contrainte appliquée au modèle est déterminée par la dynamique maximale possible en sortie de chaque cellule Cellk du modèle. Par exemple, cette contrainte correspond à l'ajout d'une couche de coupure ("clipping layer" en anglais), en sortie de chaque cellule Cellk, qui écrête (ou sature) les signaux de sortie des cellules Cellk lorsque ces signaux sortent de la dynamique maximale autorisée.

Selon un mode de réalisation, une contrainte appliquée au modèle est déterminée par une robustesse visée du convertisseur fabriqué aux non-idéalités temporelles, par exemple liées au bruit kTC lorsque les poids du convertisseur fabriqué sont mis en œuvre par des capacités ou circuits capacitifs. Par exemple, cette contrainte correspond à l'ajout, sur chaque noeud interne de l'encodeur, d'une couche d'augmentation des données ("data augmentation layer" en anglais) ajoutant un bruit aléatoire gaussien sur ce noeud interne.

Selon un mode de réalisation, une contrainte appliquée aux poids du modèle, en particulier aux poids de l'encodeur, est déterminée par un dimensionnement des circuits (capacitifs ou résistifs) mettant en œuvre les poids. Cette contrainte correspond à la recherche d'un dénominateur commun aux poids de l'encodeur ou d'un sous-groupe de poids de l'encodeur. Le but de cette contrainte est de trouver un dimensionnement adéquat des poids du modèle qui favorise l'obtention d'un dénominateur commun à toutes les valeurs de poids du convertisseur ou d'un sous-groupe de poids du convertisseur. Cette contrainte revient à mettre en œuvre un apprentissage profond supervisé en utilisant un entrainement axé sur la quantification (QAT de l'anglais "Quantization Aware Training"). Les entrainements de type QAT sont bien connus et permettent l'apprentissage de poids WM (voir [Math 8]) quantifiés, ces poids quantifiés étant dérivés des poids latents, notés WM[1]. Par exemple, l'entraînement pour obtenir des poids quantifiés comprend une étape de Q quantification uniforme ("Q-step uniform quantization" en anglais) mise en œuvre pendant la phase d'inférence ("feedforward phase" en anglais), combinée à un estimateur direct ("Straight Through Estimator" en anglais) pour le gradient lors de la phase de rétropropagation ("back propagation" en anglais). A titre d'exemple alternatif, la personne du métier saura également prévoir, à la place d'un estimateur direct, n'importe quel proxy pour la phase de rétropropagation du gradient. A titre d'exemple, un proxy permet de remplacer, pour le calcul du gradient, une fonction non dérivable utilisée lors de l'inférence, comme par exemple la fonction de quantification, par une fonction alternative sur laquelle le gradient peut être calculé. Par exemple, la fonction de quantification proposée est basée sur la fonction round() qui arrondit à l'entier le plus proche la partie fractionnaire. La dynamique d'entrée de la fonction round() est réglée, par exemple, à partir de la valeur maximale $W^l max$ des valeurs absolues des poids latents de l'encodeur, avec :

$$[Math\ 16]$$

$$W^l max = \max(|WM^l|)$$

Par exemple :

$$[Math\ 17]$$

$$WM = qstep * round\left(\frac{WM^l}{qstep}\right)$$

avec qstep le pas de quantification. A titre d'exemple qstep est égal à 1/(round(($2^{q-1}$)/$W^l$max)) et q un entier permettant de fixer la granularité de la quantification opérée et fixer le rapport maximal entre la poids absolu le plus grand et le plus faible. A titre d'autre exemple, qstep est une valeur apprise en utilisant un poids *$W^l$scale* appris lors de l'entrainement, et est alors par exemple égal à 1/ (round (($2^{q-1}$)/$W^l$scale)).

Dans l'exemple ci-dessus, l'apprentissage profond supervisé axé sur la quantification permet de trouver un dimensionnement adéquat des poids du modèle favorisant l'obtention d'un dénominateur commun à toutes les valeurs de poids. Cela permet la mise en œuvre des poids par des capacités commutées correspondant chacune à une ou plusieurs capacités unitaires identiques, chacune des capacités unitaires ayant une même valeur déterminée par le dénominateur commun obtenu pendant l'entrainement. Dans un autre exemple, cela permet la mise en œuvre des poids par des résistances correspondant chacune à une ou plusieurs résistances unitaires identiques, chacune des résistances unitaires ayant une même valeur déterminée par le dénominateur commun obtenu pendant l'entrainement.

Selon un mode de réalisation, une régularisation qui peut être appliquée au modèle lors de l'apprentissage profond supervisé est déterminée par une surface du convertisseur à fabriquer, et, plus particulièrement, vise à réduire cette surface. Par exemple, il est prévu d'introduire une régularisation s'appliquant aux poids de l'encodeur qui soit analogue à une norme L0 (représentative du nombre de valeurs non nulle) ou à toute forme équivalente, par exemple une régularisation L1 sous certaines hypothèses, pour limiter le nombre de connexions électriques dans le convertisseur, ou, dit autrement, pour élaguer des connexions électriques dans le convertisseur.

Selon un mode de réalisation, une contrainte appliquée au modèle est déterminée par une surface du convertisseur à fabriquer et, plus particulièrement, vise à réduire cette surface en masquant des connexions dans l'encodeur. Par exemple, des poids du modèle d'encodeur sont masqués lors de l'apprentissage pour limiter le nombre de connexions effectives entre les cellules de l'encodeur, ce qui se traduit par une compacité plus importante du convertisseur final. Par exemple, la matrice des poids latents WM[l] est multipliée par un masque binaire, c'est à dire par une matrice de poids latents de masquage, de sorte à désactiver les connexions correspondantes. Ce masque binaire est, par exemple, obtenu par seuillage d'une matrice de poids latents de masquage. Pour contrôler le nombre de poids nuls du masque binaire, une fonction de régularisation peut dépendre du nombre de poids nuls après seuillage de la matrice de poids de masquage, et ajouter un terme à la fonction de coût qui sera déterminé par un écart entre le nombre de poids nuls du masque binaire compté par la fonction de régularisation et un nombre poids de masquage nuls ciblé ou attendu. Selon un mode de réalisation, plutôt que d'être déterminée par une surface visée pour le convertisseur à fabriquer, la contrainte consistant à appliquer un masque binaire sur des poids du modèle est déterminée par une topologie visée pour le convertisseur à fabriquer, et le masque est configuré pour supprimer des chemins de données (ou connexions) dans le modèle qui ne correspondent à aucun chemin dans la topologie visée.

Selon un mode de réalisation, une contrainte appliquée au modèle, est déterminée par une surface du convertisseur à fabriquer et, plus particulièrement, vise à réduire cette surface. A titre d'exemple, des techniques de coupure de poids ("weight clipping" en anglais) peuvent être mises en œuvre pour réduire la surface du convertisseur.

Selon un mode de réalisation, une régularisation appliquée au modèle est déterminée par des propriétés matérielles du convertisseur à fabriquer et vise à éviter l'atténuation de signaux du modulateur. Par exemple, cette régularisation est appliquée aux poids correspondant au chemin de contre réaction avec retard d'un cycle de chaque cellule Cellk, c'est à dire par exemple au poids Wapk1 avec k égal p de chaque cellule Cellk d'indice k égal p, par exemple aux poids Wa111, Wa221 et Wa331 dans l'exemple de la figure 6. A titre d'exemple, cette régularisation introduit une pénalité s'ajoutant à la fonction de coût lorsqu'un ou plusieurs de ces poids sont inférieurs à 1. Dit autrement, cette régularisation correspond à une fonction de régularisation déterminant la fonction de coût avec la fonction de fidélité, et, par exemple, d'autres fonctions de régularisation, par exemple la fonction Fdr. Dit encore autrement, cette régularisation correspond à une fonction de régularisation utilisée dans le calcul de la fonction de coût.

Selon un mode de réalisation, une ou plusieurs contraintes appliquées au modèle sont déterminées par des propriétés matérielles du convertisseur à fabriquer, et visent à émuler des erreurs statiques sur la valeur des poids effectivement mis en œuvre en matériel et la valeur des poids correspondant du modèle et/ou des gains finis des amplificateurs opérationnels mettant en œuvre en matériel les fonctions de sommation et/ou d'intégration du modèle. Par exemple, chacune de ces contraintes est réalisée par une couche sans correspondance matérielle qui agit sur les données ou les poids du modèle. Par exemple, une couche d'augmentation de données peut être utilisée pour ajouter une erreur sur les poids effectifs du modèle lors de la phase d'entraînement, voire d'inférence. A titre d'autre exemple, une couche d'augmentation peut être utilisée en aval du sommateur de chaque Cellk, pour introduire une pondération non unitaire modélisant l'erreur de gain de l'amplificateur mettant en œuvre la sommation.

Selon un mode de réalisation, une contrainte appliquée aux poids du modèle (latents ou quantifiés), et plus particulièrement au poids du modèle d'encodeur, est déterminée par des propriétés fonctionnelles du convertisseur à fabriquer, et vise à forcer le type, positif ou négatif, d'au moins certaines contre-réactions mise en œuvre dans le convertisseur à fabriquer. Cette contrainte consiste à forcer le signe de poids donnés du modèle d'encodeur pour forcer des contre-réactions négatives et positives dans le modèle. Par exemple, le signe des poids correspondant à des contre-réactions négatives est forcé pour être un signe négatif, et le signe des poids correspondant à des contre-réactions positives est forcé pour être un signe positif.

Selon un mode de réalisation, outre des contraintes et/ou des appliquées au modèle dont certaines au moins sont déterminées par des propriétés matérielles ou fonctionnelles du convertisseur à fabriquer, de manière optionnelle une couche de normalisation est ajoutée en sortie du modèle. Cette couche de normalisation consiste à ajouter un facteur (ou poids) de dimensionnement en sortie du modèle du décodeur, de sorte à adapter la dynamique de la sortie du modèle de convertisseur à l'indice n du cycle C[n] courant. A titre d'exemple, la couche de normalisation est configurée pour que le convertisseur fournisse à chaque cycle une donnée de sortie à l'échelle. Selon un mode de réalisation, une fonction de régularisation peut être affectée à cette couche de normalisation. Par exemple, pour lisser la reconstruction entre chaque cycle, une régularisation L2 est appliquée à la dérivée de la valeur absolue de ces poids de dimensionnement, de sorte que ces poids de dimensionnement aient des valeurs qui évoluent de façon monotone en fonction de la valeur N de suréchantillonnage.

Selon un mode de réalisation, outre des contraintes et/ou des régulations et/ou des pondérations appliquées au modèle dont certaines au moins sont déterminées par des propriétés matérielles ou fonctionnelles du convertisseur à fabriquer, de manière optionnelle des stratégies d'apprentissage sont appliquées à l'entrainement profond supervisé, ou, dit autrement, sont introduites dans la phase d'apprentissage profond supervisé.

A titre d'exemple, cette ou ces stratégies d'apprentissage visent à assurer un comportement stable du modèle lors de l'entrainement profond supervisé.

Selon un mode de réalisation, l'une de ces stratégies d'apprentissage consiste à mettre en œuvre une ou plusieurs fonctions de rappel ("callback function" en anglais) pour régler des caractéristiques de la phase d'entrainement, par exemple d'un lot d'entrainement ("batch" en anglais) au suivant, et/ou d'une époque d'entrainement ("epoch" en anglais) à la suivante.

Selon un mode de réalisation, l'une de ces stratégies d'apprentissage consiste à choisir des paramètres statistiques sur les données d'entrée fournies au modèle lors de la phase d'apprentissage profond supervisé. A titre d'exemple, chaque lot d'entrainement est sélectionné ou construit à partir des données d'entrainement, par exemple issues d'une base de données statique ou générées à la volée, de sorte que chaque lot d'entrainement respecte une propriété statistique. A titre d'exemple, la distribution des données d'entrées et de sorties permet en outre d'introduire une régularisation implicite du modèle, par exemple une régularisation favorisant une homogénéité des performances du convertisseur sur toute la dynamique du signal d'entrée.

Selon un mode de réalisation, l'une de ces stratégies d'apprentissage concerne l'initialisation des poids latents du modèle d'encodeur. Par exemple, les poids latents du modèle d'encodeur sont initialisés à des valeurs purement aléatoires. A titre d'autre exemple, les poids latents du modèle d'encodeur sont initialisés à des valeurs correspondant aux valeurs des poids d'une topologie de référence. A titre d'autre exemple, les poids latents du modèle d'encodeur sont initialisés avec les valeurs de poids correspondants d'une topologie de référence si ces poids de la topologie de référence sont non nuls, et avec une valeur aléatoire sinon.

Selon un mode de réalisation, une fonction de rappel de type "ReduceLROnPlateau" (Réduction du taux d'apprentissage sur plateau) est utilisée sur une métrique représentative des spécifications souhaitées, par exemple relatives à la mise en œuvre matérielle et/ou aux fonctionnalités du convertisseur, à chaque fin d'une époque d'apprentissage. Par exemple, cette fonction vise à réduire le taux d'apprentissage lorsque la métrique considérée ne varie plus. A titre d'exemple, la métrique est représentative d'une propriété matérielle du convertisseur à fabriquer. Un exemple de métrique pouvant être utilisée est déterminée par le rapport entre la dynamique DR du paramètre à inférer sur l'erreur maximale de conversion sur cette dynamique DR (par exemple l'erreur de quantification). Cette métrique est représentative d'un nombre maximal de pas de quantification utilisable sans qu'il n'y ait d'erreur de quantification sur cette dynamique DR. Par exemple, cette métrique peut être exprimée par la formule [Math 18] suivante :

[Math 18]

$$MAXresol = log_2\left(\frac{DR}{\max_S\{|xa[s] - xq[s]|\}}\right)$$

Selon un mode de réalisation, une fonction de rappel est utilisée à la fin de chaque époque ou période ("epoch" en anglais) d'apprentissage pour activer et désactiver de manière aléatoire des couches d'augmentation de données ajoutées sur les noeuds internes de l'encodeur, par exemple les couches d'augmentation de données introduisant du bruit blanc sur ces noeuds internes. Cela peut permettre une meilleure convergence du modèle lors de l'apprentissage.

Selon un mode de réalisation, une fonction de rappel utilisée lors de l'apprentissage permet de désactiver progressivement des masques binaires statiques appliqués aux poids latent du modèle de l'encodeur, c'est à dire que cette fonction de rappel permet de réactiver progressivement des connexions du modèle lors de l'apprentissage, parmi les connexions qui ont été masquées au début de l'apprentissage.

Selon un mode de réalisation, une fonction de rappel utilisée lors de l'apprentissage diminue progressivement la valeur de q définie en relation avec un apprentissage axé sur la quantification (QAT). Par exemple, l'apprentissage peut débuter sans quantification des poids lors d'un premier ensemble d'époques d'apprentissage, puis la quantification des poids est activée avec un premier niveau de quantification q=q1 (avec q1 une valeur initiale de niveau de quantification) pour un deuxième ensemble d'époques d'apprentissage débutant à partir du meilleur ensemble de poids latents obtenu à la fin du premier ensemble d'époques d'apprentissage, puis, pour des ensembles suivants d'époques d'apprentissage, chaque ensemble d'époques d'apprentissage débute, par exemple, avec le meilleur ensemble de poids latents obtenu à la fin de l'ensemble précédent d'époques d'apprentissage en réduisant la valeur de q, jusqu'à obtenir une valeur de q désirée et déterminée par des propriétés matérielles du convertisseur à fabriquer.

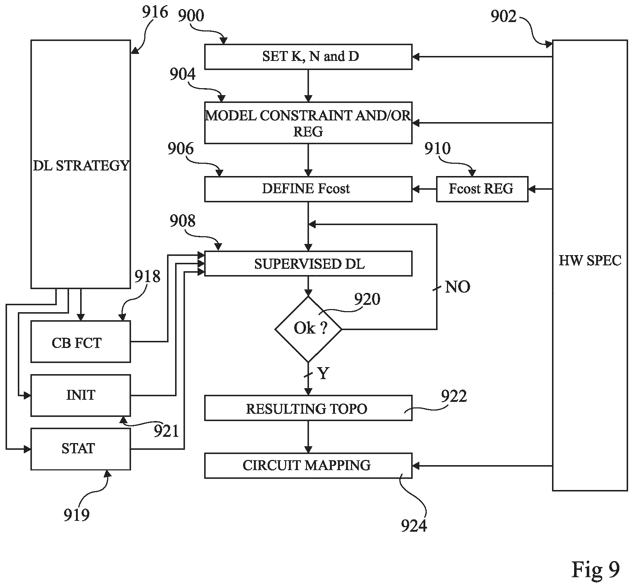

La figure 9 illustre de manière schématique, par un organigramme, un mode de réalisation d'une méthode de conception (ou dimensionnement) d'un convertisseur sigma-delta.

A une étape 900 (bloc "SET K, N and D"), les hyperparamètres du modèle, à savoir le nombre K de cellules Cellk, le taux de suréchantillonnage N et la valeur D définissant les retards, sont définis par le concepteur. A titre d'exemple, d'autres hyperparamètres du modèle peuvent être définis par le concepteur à cette étape, comme par exemple le nombre de valeurs possibles en sortie de chaque quantificateur ou, dit autrement, la résolution de quantification des sorties Bkd.

Par exemple, la valeur du nombre N peut être déterminée par une contrainte matérielle provenant d'un cahier des charges 902 (bloc "HW SPEC") définissant des contraintes matérielles et/ou fonctionnelles que le convertisseur devrait respecter, comme cela est représenté en figure 9.

Par exemple, la valeur du nombre D peut être au moins en partie déterminée par ce cahier des charges. Par exemple, le nombre D peut être réduit avec la surface maximale visée pour le convertisseur. En effet, plus le nombre D est grand, plus le nombre de connexions et de poids du modèle est élevé, et donc plus la surface du convertisseur sera importante.

Par exemple, le nombre K peut être au moins en partie déterminé par le cahier des charges 902, par exemple par une surface maximale visée pour le convertisseur et/ou par une précision de conversion cible du convertisseur. Par exemple, plus le nombre K est élevé, plus le convertisseur sera gros, et/ou plus le nombre K est élevé, plus l'erreur de conversion, par exemple lié au bruit thermique et à l'erreur de quantification, sera faible. A titre d'exemple, le nombre K peut être déterminé au moins en partie par l'ordre M du convertisseur à fabriquer, K étant de préférence supérieur ou égal à M.

Bien que cela ne soit pas illustré en figure 9, l'étape 900 comprend en outre une étape de détermination d'un modèle de filtre (ou de décodeur) à partir de réseaux de neurones récurrents, de sorte à obtenir, à l'issue de l'étape 900, un modèle de convertisseur. A titre d'exemple, le filtre comprend une ou plusieurs successions (mises en cascades) de réseaux de neurones récurrents simples. Un exemple de modèle de filtre pour un convertisseur analogique-numérique a été décrit en relation avec la figure 8. La personne du métier sera en mesure de prévoir d'autres modèles de filtres modélisés à partir de réseaux de neurones récurrents, par exemple à partir au moins de réseaux de neurones récurrents simples, pour un convertisseur analogique-numérique, voire pour des convertisseurs analogique-information prenant en entrée un signal analogique et fournissant en sortie des informations sur ce signal (fréquence, amplitude etc..).

A une étape suivante optionnelle 904 (bloc "MODEL CONSTRAINT AND/OR REG"), des contraintes et/ou des régularisations sont ajoutées directement au modèle de convertisseur. Par exemple, ces contraintes et/ou régularisations sont ajoutées sous la forme de couches n'ayant pas de contrepartie matérielle dans le convertisseur qui sera fabriqué, sous la forme de fonctions appliquées à des couches du modèle, ou encore sous la forme de masques appliqués à des poids du modèle. Par exemple, au moins une régularisation peut être appliquée au modèle sous la forme d'un terme supplémentaire dans la fonction de coût.

Selon un mode de réalisation, au moins une contrainte et/ou au moins une régularisation appliquée au modèle générique est déterminée par une propriété matérielle et/ou une propriété fonctionnelle que le convertisseur à fabriquer doit respecter, comme cela est illustré en figure 9 par une flèche allant du bloc 902 au bloc 904.

Par exemple, au moins une contrainte et/ou au moins une régularisation appliquée au modèle générique est déterminée par des valeurs de saturation des signaux internes du modulateur et correspond, par exemple, à l'ajout de couches de coupure au modèle.

Par exemple, au moins une contrainte appliquée au modèle générique est déterminée par une robustesse cible du convertisseur à des non-idéalités temporelles, et consiste, par exemple, à insérer des couches d'augmentation de données pour modéliser le bruit dans le convertisseur.

Par exemple, au moins une contrainte appliquée au modèle générique est déterminée par une mise en œuvre des poids sous une forme quantifié, et correspond, par exemple, à une mise en œuvre de l'apprentissage profond en utilisant un entrainement axé sur la quantification. Dit autrement, cette contrainte correspond à l'ajout d'une couche de quantification des poids latents du modèle.

Par exemple, au moins une contrainte appliquée au modèle générique est déterminée par une surface visée pour le convertisseur à fabriquer, et correspond, par exemple à l'application d'au moins un masque binaire à des poids du modèle et/ou à la mise en œuvre de technique de coupure de poids.

Par exemple, au moins une contrainte appliquée au modèle générique est déterminée par des erreurs sur les gains finis d'amplificateurs opérationnels qui seront utilisés pour mettre en œuvre le convertisseur et correspond, par exemple, à l'ajout d'une couche d'augmentation en aval du sommateur de chaque de chaque Cellk, pour introduire une pondération non unitaire modélisant l'erreur de gain fini de l'amplificateur mettant en œuvre la sommation.

Par exemple, au moins une contrainte appliquée au modèle générique est déterminée par des erreurs statiques maximales visées sur des valeurs de composants mettant en œuvre les poids du modèle et correspond, par exemple, à l'ajout d'erreurs sur des poids du modèle.

Par exemple, au moins une contrainte appliquée au modèle générique est déterminée par une topologie visée de convertisseur ou du modulateur, et consiste à masquer des poids du modèle générique pour supprimer les chemins de données dans le modèle qui ne correspondent à aucun chemin de données dans la topologie visée.

Par exemple, au moins une contrainte appliquée au modèle générique est déterminée par le sens des chemins de données dans le convertisseur à fabriquer (chemins directs ou chemins de contre-réaction), et consiste à forcer les signes de certains poids du modèle générique pour mettre en œuvre des boucles de contre-réaction positives et/ou négatives dans le convertisseur à fabriquer.

Par exemple, au moins une contrainte appliquée au modèle générique est déterminée par une surface maximale visée, et consiste à masquer des poids de l'encodeur pour réduire le nombre de chemin de données dans le modèle, ce qui revient à réduire le nombre de connexion dans le convertisseur fabriqué, et donc sa surface.

Par exemple, au moins une régularisation appliquée au modèle est déterminée par une surface maximale visée, et consiste, par exemple, en une régularisation L1 pour limiter le nombre total de poids utilisés.

Par exemple, au moins une régularisation appliquée au modèle est déterminée par une dynamique de sortie du convertisseur à fabriquer. Par exemple, une régularisation L2 peut être mise en œuvre sur la dérivée des valeurs absolues des facteurs, ou poids, de dimensionnement d'une couche de pondération ajoutée en sortie du modèle.

A une étape suivante 906 (bloc "DEFINE Fcost"), une fonction de coût est définie pour l'étape suivante d'entrainement profond supervisé 908 (bloc "SUPERVISED DL"). La définition de la fonction Fcost consiste à définir une fonction de fidélité Ffid à partir de laquelle est exprimée la fonction Fcost.

De préférence, la fonction Fcost est déterminée par la fonction Ffid et par au moins une fonction de régularisation comme cela est illustrée en figure 9 par le bloc 910 (bloc "Fcost REG") indiquant que la fonction de coût Fcost déterminée à l'étape 906 l'est en partie à partir d'une fonction de régularisation.

Par exemple, la fonction Fcost est déterminée en partie à partir d'une fonction de régularisation déterminée par une propriété matérielle et/ou une propriété fonctionnelle du convertisseur à fabriquer comme cela est illustré en figure 9 par la flèche allant du bloc 902 au bloc 910. Par exemple, la fonction Fcost est déterminée en partie à partir d'une fonction de régularisation, par exemple Fdr, déterminée par une excursion maximale des signaux de sortie de chaque cellule Cellk du modulateur, et/ou, par exemple, par une fonction de régularisation ajoutant une pénalité dans la fonction de coût lorsque que certains poids, par exemple les poids Wapk1 de chaque cellule Cellk d'indice k égal à p, sont inférieurs à 1.

A l'étape suivante 908, le modèle générique du convertisseur est entraîné par la mise en œuvre d'un entrainement profond supervisé.

Comme cela a été indiqué précédemment, des stratégies d'apprentissage peuvent être prévues lors de l'entrainement profond supervisé, comme cela est illustré par un bloc 916 ("DL STRATEGY" en figure 9).

Selon un mode de réalisation, au moins une stratégie d'apprentissage correspond à une fonction de rappel 918 (bloc "CB FCT") comme cela est illustré en figure 9 par une flèche allant du bloc 916 au bloc 918. La fonction de rappel est appliquée à l'étape d'apprentissage 908, c'est à dire utilisée pendant l'étape 908, comme cela est illustré en figure 9 par une flèche allant du bloc 918 au bloc 908. Des exemples de telles fonctions de rappel ont été donnés précédemment.

Selon un mode de réalisation, au moins une stratégie d'apprentissage correspond à une propriété statistique 919 (bloc "STAT") appliquée, ou imposée, aux données d'entrainement comme cela est illustré en figure 9 par une flèche allant du bloc 919 au bloc 918. A titre d'exemple, chaque lot d'entrainement est sélectionné ou construit à partir des données d'entrainement de sorte que chaque lot d'entrainement respecte une propriété statistique. Par exemple, pour entrainer un modèle de convertisseur configuré pour convertir un signal analogique continu en sa contrepartie numérique, chaque lot d'entrainement est construit pour que la moyenne des valeurs absolues des données d'entrainement qui le compose soit la même dans tous les lots d'entrainement, et soit, par exemple, égale à la moitié de la dynamique d'entrée positive du convertisseur à fabriquer.

Selon un mode de réalisation, au moins une stratégie d'apprentissage correspond à une initialisation des poids latents du modèle 921 (bloc "INIT"), et correspond à une façon d'initialiser les poids latents du modèle comme cela est illustré par une flèche allant du bloc 921 au bloc 908 en figure 9. Diverses façons d'initialiser les poids latents du modèle ont été décrites précédemment, par exemple de manière aléatoire et/ou à partir des poids d'une topologie de référence et/ou à partir des poids d'un modèle obtenu à l'issue d'une étape 908 précédente.

L'étape 908 d'entrainement est ensuite mise en œuvre. C'est pendant l'étape d'entrainement 908 que sont appliquées les diverses stratégies d'apprentissage, comme par exemple les fonctions de rappel et/ou les propriétés statistiques définies sur les données d'entrainement et/ou les choix d'initialisations des poids latents du modèle.

A la fin d'une ou plusieurs époques d'entrainement 908, à une étape suivante 920 (bloc "Ok?"), il est vérifié si le modèle obtenu, c'est à dire les poids du modèle qui sont obtenus après la mise en œuvre d'une étape 908, satisfont les propriétés matérielles et/ou fonctionnelles définies pour le convertisseur à fabriquer. Dit autrement, cette étape 920 consiste à vérifier si un critère d'arrêt de l'entrainement a été atteint ou non.

Si ce n'est pas le cas (sortie NO du bloc 920), l'étape 908 est de nouveau mise en œuvre en utilisant comme modèle de départ le modèle entrainé obtenu à la fin de l'étape 908 précédente, ou un modèle entrainé obtenu à la fin d'une des époques de l'étape 908 précédente, ou un modèle ayant des conditions d'initialisation des poids latents différentes, par exemple une initialisation des poids latents qui soit aléatoire et indépendante de toute topologie précédemment apprise ou toute topologie de référence. A titre d'autre exemple, l'étape 908 peut être de nouveau mise en œuvre à partir d'un modèle générique obtenu en mettant de nouveau en œuvre les étapes 900, 904, 906 et 916 mais avec des contraintes et/ou des régularisations et/ou des stratégies d'apprentissages différentes.

Si c'est le cas (sortie Y du bloc 920), l'étape 920 est suivie d'une étape 922 (bloc "RESULTING TOPO"). A cette étape 922, on dispose d'un modèle entrainé qui satisfait les propriétés matérielles et/ou les propriétés fonctionnelle qui ont déterminé les contraintes et régularisations appliquées au modèle générique à l'étape 904 et 906. Ce modèle définit, ou détermine, une topologie du convertisseur à fabriquer, c'est à dire, par exemple, les connexions (ou chemins de données) dans le convertisseur à fabriquer, les poids à appliquer à chaque signal interne du convertisseur, les retards à appliquer, et les sommations à mettre en œuvre.

A une étape suivante 924 (bloc "CIRCUIT MAPPING"), la topologie de l'étape 922, c'est à dire le modèle entrainé reçu à l'étape 922, est projetée sur ("mapped" en anglais), ou transformée en, du matériel. Par exemple, chaque chemin de données du modèle entraîné est mis en œuvre par une connexion électrique, et/ou les poids sont mis en œuvre par des composants résistifs ou capacitifs et/ou les retards sont mis en œuvre par des signaux de cadencement correspondant, les sommes entre données sont mises en œuvre par des circuits sommateurs, par exemple à partir d'amplificateurs opérationnels etc...

De préférence, lors de cette étape de transformation du modèle entrainé en un circuit, les propriétés matérielles et/ou les propriétés fonctionnelles du convertisseur à fabriquer qui ont été utilisées aux étapes 900, 904, 906, 908 et 910 sont respectées, comme cela est illustré en figure 9 par une flèche allant du bloc 902 au bloc 924. Par exemple, si une régularisation basée sur la dynamique des signaux du convertisseur a été appliquée au modèle à l'étape 904, le circuit est conçu pour respecter cette dynamique. A titre d'autre exemple, si l'entrainement est axé sur la quantification, les poids seront chacun mis en œuvre à partir d'un composant résistif ou capacitif unitaire. Par exemple, si le modèle utilisé pendant l'entrainement comprend des couches de contrainte pour émuler le gain maximal des amplificateurs opérationnels mettant en œuvre des sommes dans le convertisseur à fabriquer, les amplificateurs opérationnels effectivement utilisés pour le circuit du convertisseur ont cette valeur de gain maximal.

Enfin, à une étape suivante non illustrée, le circuit obtenu à l'issue de l'étape 924 est fabriqué.

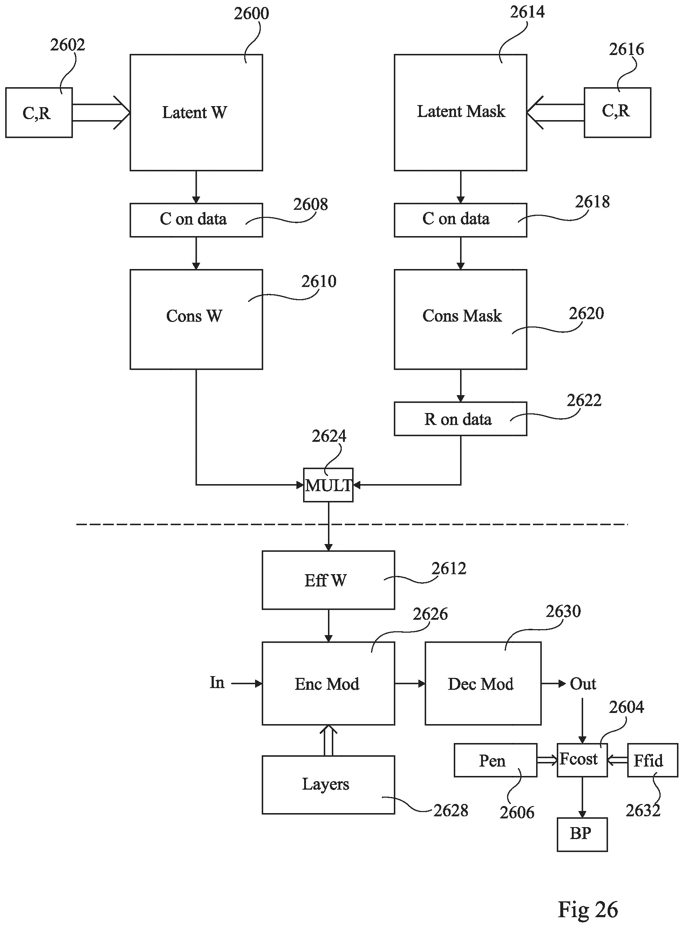

La figure 26 illustre, de manière schématique, générale et sous la forme de blocs, un exemple de comment des contraintes et des régularisations peuvent être appliquées au modèle lors de l'entrainement. Dit autrement, la figure 26 illustre des étapes de la méthode décrite en relation avec la figure 9.

Dans cette figure 26, un bloc 2600 ("Latent W") représente les poids latents de l'encodeur. Comme cela est illustré par un bloc 2602 ("C,R"), des fonctions de régularisation et/ou des contraintes peuvent être appliquées sur ces poids latents. Par exemple, une contrainte est appliquée aux poids latents et va directement agir sur les valeurs des poids latents, par exemple en limitant la valeur maximale que peuvent prendre ces poids latents. Par exemple, une régularisation L1 est rattachée aux poids latents de l'encodeur, qui va affecter un terme de pénalité à la fonction de coût. En figure 26, la fonction de coût est représentée sous la forme d'un bloc 2604 ("Fcost") et la ou les pénalités affectées à la fonction de coût sont représentées sous la forme d'un bloc 2606 ("Pen").

En outre, des contraintes peuvent être appliquées aux poids latents de l'encodeur au moyen d'une ou plusieurs couches qui n'auront pas de contrepartie matérielle. En figure 26, ces contraintes sont représentées par un bloc 2608 ("C on Data") recevant les poids latents (bloc 2600), auxquels des contraintes et/ou des régularisations (bloc 2602) ont pu être appliquées directement, et fournissant des poids contraints représentés sous la forme d'un bloc 2610 ("Cons W") en figure 26.

Par exemple, le bloc 2608 comprend une telle couche de contrainte mettant en œuvre la quantification des poids. Cette couche de contrainte reçoit les poids latents 2600, et fournit des poids quantifiés. Les poids contraints 2610 seront alors des poids quantifiés.

Par exemple, lorsque l'on vise une mise en œuvre des poids basée sur des capacités, le bloc 2608 peut comprendre une couche de contrainte émulant la dispersion des valeurs de capacités liée à la fabrication de ces capacités. Cette couche va ajouter des dispersions fixes sur les données qu'elle reçoit, ces données étant par exemple les poids quantifiés fournis par la couche de contrainte de l'exemple ci-dessus.

Les poids latents contraints 2610 ainsi obtenus peuvent alors directement correspondre aux poids effectifs du modèle d'encodeur, ces derniers étant représentés par un bloc 2612 ("Eff W") en figure 26.

Toutefois, comme cela est illustré dans l'exemple de la figure 26, ces poids latents contraints 2610 peuvent être multipliés par un masque, le résultat de cette multiplication correspondant alors aux poids effectifs 2612.

Par exemple, en figure 26, il est prévu des poids latents de masquage représentés sous la forme d'un bloc 2614 ("Latent Mask"). De la même façon que pour les poids latents 2600 de l'encodeur, des contraintes et/ou des régularisations peuvent être appliquées directement aux poids latents de masquage 2614. En figure 26, ces contraintes et/ou régularisations directement appliquées aux poids latents de masquage 2614 sont représentées sous la forme d'un bloc 2616 ("C, R").

Au moins une contrainte est appliquée aux poids latents de masquage 2614 par une couche sans contrepartie matérielle, représentée en figure 26 par un bloc 2618 ("C on data"). Cette couche 2618 reçoit les poids latents de masquage 2614, et fournit des poids latents de masquage contraints représentés sous la forme d'un bloc 2620 ("Cons Mask") en figure 26. Par exemple la couche 2618 effectue un seuillage sur niveaux des poids 2614. En pratique, les poids latents de masquage contraints 2620 correspondent à un masque binaire.

Pour contrôler le masque binaire 2620, par exemple le taux de poids nuls dans le masque binaire 2620, une ou plusieurs fonctions de régularisation 2616 peuvent être appliquées aux poids latents de masquage 2614, et/ou une ou plusieurs fonctions de régularisation 2622 (bloc "R on data") peuvent être appliquées aux poids 2620 (c'est à dire au masque binaire). En pratique, lorsqu'elles sont prévues, ces régularisations ne modifient pas la valeur des poids du masque binaire 2620. Par exemple, une fonction de régularisation 2622 compte le nombre de poids nuls dans le masque binaire 2620, et affecte une pénalité 2606 proportionnelle à l'écart entre le nombre compté et un nombre souhaité.

Les poids latents contraints 2610 de l'encodeur sont alors multipliés par le masque binaire 2620, comme cela est représenté par un bloc 2624 ("Mult") en figure 26, pour obtenir les poids effectifs 2612.

Ces poids effectifs sont utilisés dans le modèle d'encodeur, représenté sous la forme d'un bloc 2626 ("Enc Mod") en figure 26, et correspondent aux poids qui seront implémentés physiquement lorsque le modèle entrainé sera satisfaisant en termes de performances visées.

En outre, des couches sans contrepartie matérielle peuvent être appliquées, c'est à dire ajoutées, au modèle d'encodeur 2626. En figure 26, ces couches sans contrepartie matérielle sont représentées sous la forme d'un bloc 2628 ("Layers"). A titre d'exemple, une ou plusieurs couches 2628 correspondent à des couches de contraintes. Par exemple une couche de contrainte 2628 permet de saturer des signaux dans le modèle d'encodeur 2626 lorsque ces signaux dépassent un seuil. A titre d'autre exemple, une ou plusieurs couches 2628 correspondent à des couches d'augmentation de données. Par exemple une couche d'augmentation de données 2628 permet d'ajouter un bruit temporel gaussien sur des signaux du modèle d'encodeur 2626.

En figure 26, le modèle de décodeur est représenté sous la forme d'un bloc 2630 ("Dec Mod"). Ce bloc reçoit des signaux du modèle d'encodeur 2626, et fournit des données de sortie Out. Le modèle d'encodeur 2626 reçoit des données d'entrée In.

Bien que cela ne soit pas détaillé en figure 26, des fonctions de régularisation et/ou des normalisations peuvent être appliquées au modèle de décodeur 2630.

Lors de l'entrainement, le bloc 2626 reçoit les données d'entrée In et le bloc 2630 fournit les données de sortie Out correspondantes.

La fonction Fcost est alors calculée à partir des données Out. Plus particulièrement, la fonction Fcost est calculée à partir d'une fonction de fidélité 2632 ("Ffid") et, lorsqu'il y en a, des pénalités 2606 affectées à la fonction de coût par des fonctions de régularisation. La fonction Fcost est alors représentative d'une erreur entre les données Out obtenues en sortie du modèle, et les données attendues pour les entrées In fournies au modèle.

Il s'ensuit une étape BP de rétropropagation de l'erreur. C'est par exemple lors de cette étape BP que les poids du modèle vont être mis à jour.

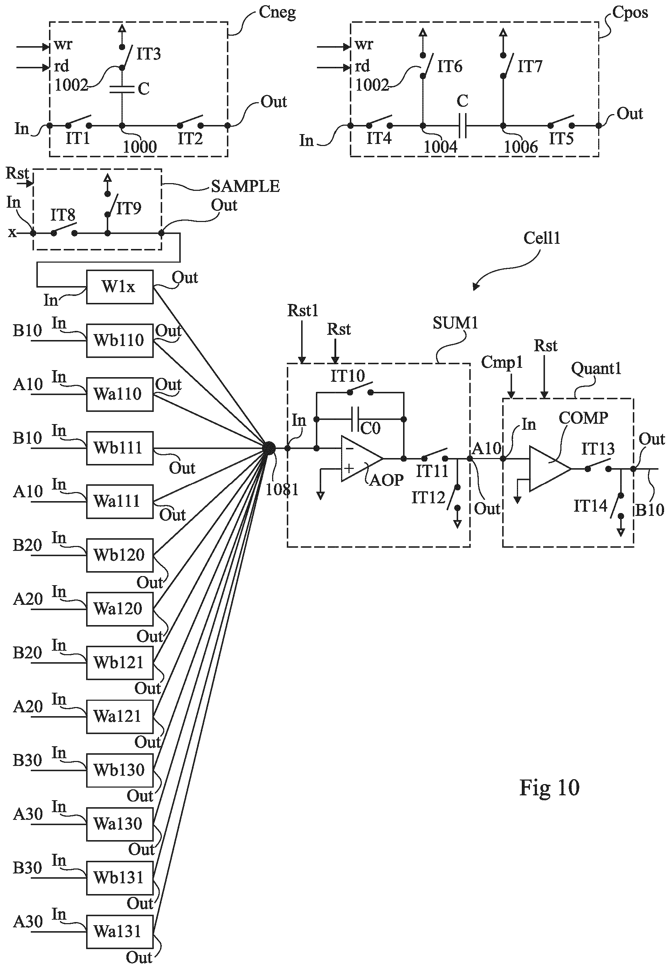

La figure 10 illustre, de manière générique, un exemple de mise en œuvre matérielle d'un modèle entraîné d'encodeur lorsque les poids sont mis en œuvre à partir de composants capacitifs.

Plus particulièrement, le haut la figure 10 représente la mise en œuvre d'un poids W quelconque, c'est à dire l'un quelconque des poids Wpx, Wapkd ou Wbpkd d'une cellule Cellk.

Comme cela est représenté en haut à gauche de la figure 10, lorsque le poids W est négatif, ce dernier est mis en œuvre par un circuit Cneg comprenant une capacité C de valeur égale à la valeur absolue du poids fois la valeur d'une capacité unitaire C0. La capacité C est connectée entre deux noeuds 1000 et 1002. Un interrupteur IT1 connecte le noeud 1000 à une entrée In du circuit Cneg, et un interrupteur IT2 connecte le noeud 1000 à une sortie Out du circuit Cneg. Un interrupteur IT3 connecte le noeud 1002 à un potentiel de référence.

Chaque circuit Cneg comprend deux entrées de commande wr et rd. L'interrupteur IT3 est fermé quand l'une ou l'autre de ses entrées wr et rd reçoit un signal actif. L'interrupteur IT1 est commandé par un signal correspondant au signal sur son entrée wr avec, de manière optionnelle, un retard pour limiter les injections de charges, et est fermé quand ce signal retardé est actif, ouvert sinon. L'interrupteur IT2 est commandé par un signal correspondant au signal sur son entrée rd avec, de manière optionnelle, un retard pour limiter les injections de charges, et est fermé quand ce signal retardé est actif, et ouvert sinon.

Comme cela est représenté en haut à droite de la figure 10, lorsque le poids W est positif, ce dernier est mis en œuvre par un circuit Cpos comprenant une capacité C de valeur égale à la valeur absolue du poids fois la valeur d'une capacité unitaire C0. La capacité C est connectée entre deux noeuds 1004 et 1006. Un interrupteur IT4 connecte le noeud 1004 à une entrée In du circuit Cpos, et un interrupteur IT5 connecte le noeud 1006 à une sortie Out du circuit Cpos. Un interrupteur IT6 connecte le noeud 1004 au potentiel de référence, et un interrupteur IT7 connecte le noeud 1006 au potentiel de référence.

Chaque circuit Cpos comprend deux entrées de commande wr et rd. L'interrupteur IT4 est commandé par un signal correspondant au signal sur son entrée wr avec, de manière optionnelle, un retard pour limiter les injections de charges, et est fermé quand ce signal retardé est actif, ouvert sinon. L'interrupteur IT5 est commandé par un signal correspondant au signal sur son entrée rd avec, de manière optionnelle un retard pour limiter les injections de charges, et est fermé quand ce signal retardé est actif, ouvert sinon. L'interrupteur IT6 est fermé quand le signal sur son entrée rd est actif, et ouvert sinon. L'interrupteur IT7 est fermé quand le signal sur son entrée wr est actif, et ouvert sinon.

En outre, le bas de la figure 10 représente la mise en œuvre d'une cellule Cellk d'indice k égal à 1 dans l'exemple de la figure 10, dans exemple de modèle de convertisseur où K est égal à 3 et D est égal à 2.

Dans cette figure, chaque circuit Cneg ou Cpos implémentant un poids correspondant est représenté par un bloc ayant la même référence que le poids qu'il met en œuvre. Chaque circuit Cneg ou Cpos mettant en œuvre un poids Wapkd, respectivement Wbpkd reçoit sur son entrée In le signal Ak0, respectivement Bk0, de la cellule Cellk.

Les signaux fournis aux entrées wr et rd des circuits Cpos et Cneg permettent de mettre en œuvre le transfert de données entre les K cellules Cellk pendant un même cycle C[n] de conversion, et entre deux cycles successifs de conversion, en mettant en œuvre les retards de d cycles correspondants.

Chaque cellule Cellk comprend en outre un circuit Sample. Une entrée In du circuit Sample reçoit le signal x. Dans chaque cellule Cellk, la sortie Out du circuit Sample est connecté à l'entrée du circuit Cpos ou Cneg mettant en œuvre le poid Wkx de la cellule. Chaque circuit Sample comprend un interrupteur IT8 connectée entre l'entrée In et la sortie Out du circuit Sample, et un interrupteur IT9 connectée entre la sortie Out du circuit Sample et le potentiel de référence.

Chaque circuit Sample reçoit en outre un signal de commande Rst. L'interrupteur IT8 est configuré pour être fermé quand le signal Rst est inactif, et ouvert sinon, l'interrupteur IT9 étant configuré pour être fermé quand le signal Rst est actif, et ouvert sinon. A titre d'exemple, le signal Rst est commuté à l'état actif pendant une phase de réinitialisation préalable à chaque conversion en N cycles.

Chaque cellule Cellk comprend un circuit SUMk. Par exemple, la cellule Cell1 représentée en figure 10 comprend un circuit SUM1. Chaque circuit SUMk comprend un amplificateur opérationnel AOP. L'amplificateur AOP de la cellule Cellk a son entrée inverseuse (-) connectée à une entrée In du circuit SUMk de la cellule, cette entrée In étant connectée au noeud 108k de la cellule (1081 en figure 10 qui représente la cellule Cell1, ou, dit autrement, la cellule Cellk d'indice k égal à 1). L'amplificateur AOP a son entrée non inverseuse (+) connectée au potentiel de référence. Une capacité C0 unitaire est connectée entre la sortie et l'entrée inverseuse de l'amplificateur AOP. Un interrupteur IT10 est connecté en parallèle de la capacité unitaire C0. Un interrupteur IT11 couple la sortie de l'amplificateur AOP du circuit SUMk à la sortie Out ce circuit SUMk. Un interrupteur IT12 est connectée entre la sortie Out du circuit SUMk et le potentiel de référence.

Chaque circuit SUMk reçoit le signal Rst. L'interrupteur IT11 est fermé quand le signal Rst est inactif, ouvert sinon. L'interrupteur IT12 est fermé quand le signal Rst est actif, ouvert sinon.

Chaque circuit SUMk reçoit en outre un signal de commande Rstk de la cellule Cellk à laquelle ce circuit appartient. Par exemple, en figure 10, le circuit SUM1 reçoit le signal Rst1. L'interrupteur IT10 est fermé lorsque le signal Rstk reçu par le circuit SUMk auquel il appartient est actif, ouvert sinon. Par exemple, en figure 10, le circuit SUM1 reçoit le signal Rst1.

Dans chaque cellule Cellk, la sortie Out du circuit SUMk de la cellule fournit le signal Ak0 de la cellule. Dans l'exemple de la figure 10, le circuit SUM1 de la cellule Cell1 fournit le signal A10 sur sa sortie Out.

Pour fournir le signal Bk0, chaque cellule Cellk comprend un circuit Quantk ayant son entrée In connectée à la sortie Out du circuit SUMk de la cellule, et sa sortie Out fournissant le signal Bk0 de la cellule. Dans l'exemple de la figure 10, le circuit Quant1 de la cellule Cell1 a son entrée In connectée à la sortie Out du circuit SUM1 de la cellule Cell1, et sa sortie Out fournissant le signal B10.

Chaque circuit Quantk comprend un comparateur à seuil COMP dont une entrée, par exemple non inverseuse, est connecté à son entrée In, et dont une autre entrée, par exemple inverseuse, est connectée au potentiel de référence. Le comparateur COMP de chaque circuit Quantk est cadencé par un signal de commande Cmpk reçu par ce circuit, et par exemple actif à l'état haut. Par exemple, la sortie du circuit COMP est mise à jour quand son signal de cadencement est actif. Par exemple, en figure 10, le circuit Quant1 reçoit le signal Cmp1.

En outre, chaque circuit Quantk comprend un interrupteur IT13 couplant la sortie du comparateur COMP à la sortie du circuit Quantk, et un interrupteur IT14 couplant la sortie Out du circuit Quantk au potentiel de référence. Chaque circuit Quantk reçoit le signal de commande Rst. L'interrupteur IT13 est fermé quand le signal Rst est inactif, ouvert sinon. L'interrupteur IT14 est fermé quand le signal Rst est actif, ouvert sinon.

En figure 10, on a représenté les signaux de sortie de chacune des 3 cellule Cell1, Cell2 et Cell3 qui sont fournis aux circuits Cneg et Cpos correspondant de la cellule Cell1 illustrée.

La fourniture des signaux de commande reçus par les entrées rd et wr des circuits Cneg et Cpos, des K signaux Cmpk, des K signaux Rstk et du signal Rst d'un encodeur à K cellules CellK de sorte à mettre en œuvre les transferts de données (des charges dans l'exemple de la figure 10) entre les K cellules lors d'un cycle d'indice n donnée, en mettant en œuvre les retards de d cycles, et de sorte à obtenir le fonctionnement décrit en relation avec les figures 5, 6 et 7 est à la portée de la personne du métier à partir de la présente description.

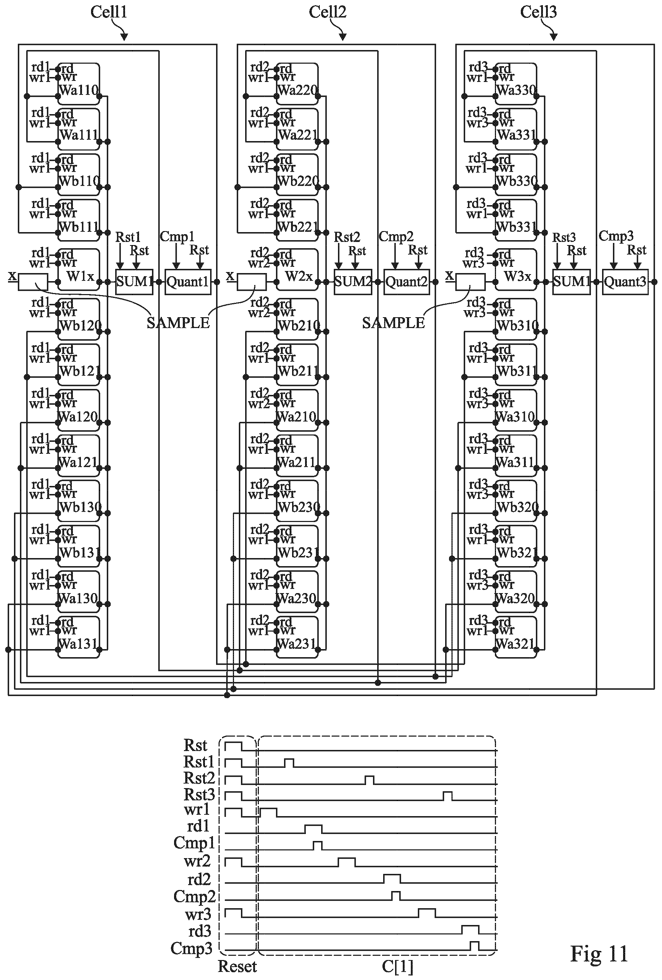

La figure 11 illustre, en haut, une mise en œuvre plus détaillée d'un modèle entrainé de modulateur, dans le cas où K est égal à 3 et D est égal à 2, et, en bas, des chronogrammes des signaux de commande, dans un exemple où chacun des signaux de commande est actif à l'état haut. Plus particulièrement, ces chronogrammes illustrent une phase de réinitialisation Reset et un premier cycle C[1] d'une conversion sur N cycles C[n].

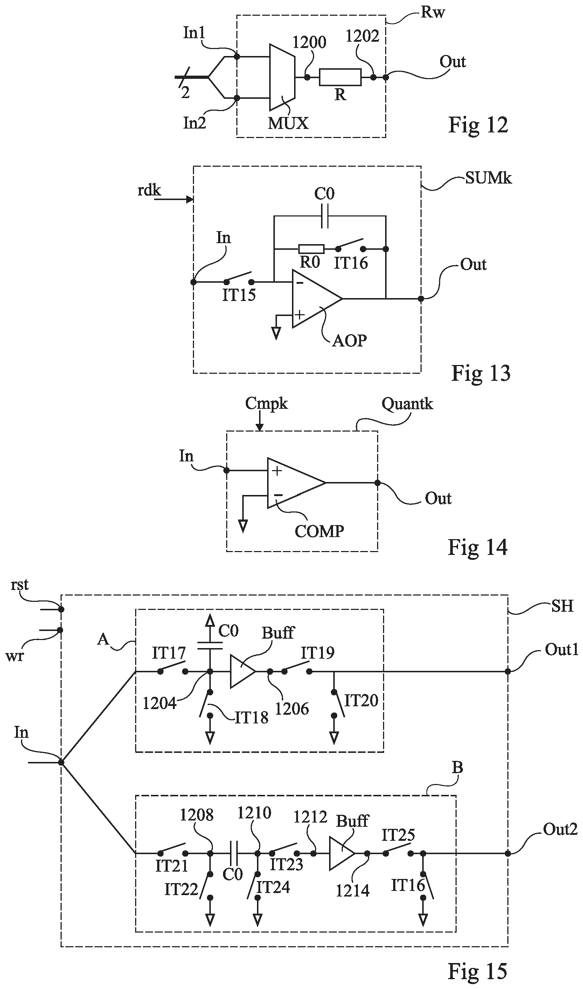

Les figures 12, 13, 14, 15 et 16 illustrent, de manière générique, un exemple de mise en œuvre matérielle d'un modèle entraîné d'encodeur lorsque les poids sont mis en œuvre à partir de composants résistifs.

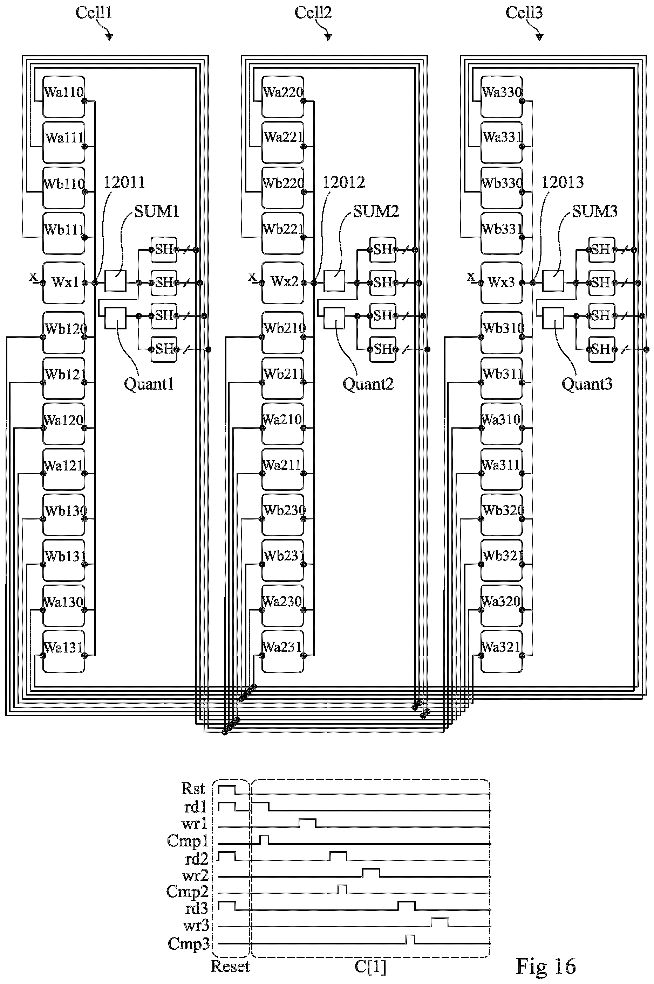

Plus particulièrement, comme cela est illustré par les figures 12 et 16, chaque poids d'une cellule Cellk, c'est à dire l'un quelconque des poids Wpx, Wapkd ou Wbpkd de la cellule, est mis en œuvre par un circuit Rw. Le circuit Rw comprend une résistance R de valeur égale à la valeur d'une résistance unitaire R0 divisée par la valeur du poids. La résistance R est connectée entre deux noeuds 1200 et 1202, le noeud 1202 étant connecté à une sortie Out du circuit Rw. En outre, chaque circuit Rw comprend deux entrées In1 et In2 et un multiplexeur MUX ayant ses deux entrées connectées aux entrées respectives In1 et In2, et sa sortie connectée au noeud 1200. Lorsque le poids implémenté par le circuit Rw est négatif, le multiplexeur couple l'entrée In1 au noeud 1200, et, à l'inverse, lorsque le poids implémenté par le circuit Rw est positif, le multiplexeur couple l'entrée In2 au noeud 1200. Bien que cela ne soit pas illustré sur la figure 12, le multiplexeur MUX reçoit un signal de commande binaire dont l'état est déterminé par le signe du poids implémenté. A titre d'exemple, ce signal de commande est fourni par un circuit de commande non illustré, par exemple un circuit de commande fournissant un signal de commande à chacun des multiplexeurs MUX des circuits Rw.

La figure 16 représente la mise en œuvre matérielle d'un modèle générique d'encodeur, dans un exemple de modèle de convertisseur où K est égal à 3 et D est égal à 2.

Dans cette figure, chaque circuit Rw implémentant un poids correspondant est représenté par un bloc ayant la même référence que le poids qu'il met en œuvre. Dans chaque cellule Cellk, chaque circuit Rw a sa sortie Out connectée à un noeud 1201k de la cellule. Par exemple, en figure 16, les circuits Rw de la cellule Cell1 ont tous leurs sorties connectées au noeud 12011 de la cellule. En outre, chaque circuit Rw reçoit sur ses entrées In1 et In2 une paire de signaux correspondant à un signal de sortie d'une des cellules Cellk auquel doit être appliqué le poids mis en œuvre par ce circuit.

Chaque cellule Cellk comporte un circuit SUMk comme cela est représenté en figure 16, une mise en œuvre d'un circuit SUMk étant illustrée en figure 13.

Chaque circuit SUMk comprend un amplificateur opérationnel AOP et un interrupteur IT15 couplant l'entrée inverseuse (-) de l'amplificateur AOP de la cellule Cellk à l'entrée In du circuit SUMk de la cellule, cette entrée In étant connectée au noeud 1008k de la cellule. L'amplificateur AOP a son entrée non inverseuse (+) connectée au potentiel de référence. Une capacité C0 unitaire est connectée entre la sortie et l'entrée inverseuse de l'amplificateur AOP. Une association en série d'un interrupteur IT16 et d'une résistance R0 unitaire est connectée en parallèle de la capacité C0. La sortie de l'amplificateur est connectée à la sortie Out du circuit SUMk.

Chaque circuit SUMk reçoit un signal rdk de commande. L'interrupteur IT15 est fermé quand le signal rdk est actif, ouvert sinon. L'interrupteur IT16 est fermé quand le signal rdk est actif, ouvert sinon.

Comme cela est représenté en figure 16, chaque cellule Cellk comprend un circuit Quantk ayant son entrée In connectée à la sortie Out du circuit SUMk de la cellule, et une sortie Out, une mise en œuvre d'un circuit SUMk étant illustrée en figure 14.

Chaque circuit Quantk comprend un comparateur à seuil COMP dont une entrée, par exemple non inverseuse (+), est connecté à son entrée In, et dont une autre entrée, par exemple inverseuse (-), est connectée au potentiel de référence. Le comparateur COMP de chaque circuit Quantk est cadencé par un signal de commande Cmpk reçu par ce circuit. Par exemple, la sortie du circuit COMP est mise jour quand son signal de cadencement est actif.

Comme cela est représenté en figure 16, chaque cellule Cellk comprend en outre plusieurs circuits SH, fournissant chacun un signal de sortie correspondant de la cellule Cellk. Une mise en œuvre d'un circuit SH est illustrée en Figure 15. Dans cette mise en œuvre, chaque signal de sortie d'un circuit SH, correspondant à un signal de sortie d'une cellule Cellk, correspond à une paire de signaux fournie aux entrées In1 et In2 d'un circuit Rw correspondant à un poids à appliquer à ce signal de sortie de cellule, et un seul des signaux de la paire de signaux est sélectionné par le multiplexeur du circuit Rw en fonction du signe du poids.

Chaque circuit SH comprend une entrée In et deux sorties Out1 et Out2 et est configuré pour mémoriser sur des capacités une image de la tension reçue sur son entrée In. En outre, en fonction de la façon donc est commandé chaque circuit SH par un signal de commande reçu sur son entrée rst et un signal de commande reçu sur son entrée wr, chaque circuit SH permet de mettre en œuvre ou non un retard d'un cycle C[n] entre son entrée et sa sortie. Chaque circuit SH permet en outre, lorsque ses sorties Out1 et Out2 sont connectées aux entrées respectives In1 et In2 d'un circuit Rw, de mettre en œuvre le signe du poids correspondant à ce circuit Rw, en sélectionnant avec le multiplexeur MUX du circuit Rw l'une ou l'autre des deux entrées In1 et In2.

Plus particulièrement, comme cela est représenté en bas de la figure 15, chaque circuit SH comprend un circuit A couplant l'entrée In du circuit SH à la sortie Out1, et un circuit B couplant l'entrée In du circuit SH à la sortie Out2.

Le circuit A comprend une capacité unitaire C0 connectée entre un noeud 1204 et le potentiel de référence. Un interrupteur IT17 couple l'entrée In au noeud 1204, et un interrupteur IT18 couple le noeud 1204 au potentiel de référence. Un circuit tampon ("buffer" en anglais) unitaire analogique Buff couple le noeud 1204 à un noeud 1206. Un interrupteur IT19 couple le noeud 1206 à la sortie Out1 et un interrupteur IT20 couple la sortie Out1 au potentiel de référence.

L'interrupteur IT17 est fermé lorsque le signal reçu par l'entrée wr est actif, ouvert sinon. Les interrupteurs IT18 et IT20 sont fermés lorsque le signal reçu par l'entrée rst est actif, ouverts sinon, l'interrupteur IT19 étant fermé lorsque le signal rst est inactif, ouvert sinon.

Le circuit B comprend une capacité unitaire C0 connectée entre un noeud 1208 et un noeud 1210. Un interrupteur IT21 couple l'entrée In au noeud 1208, un interrupteur IT22 couple le noeud 1208 au potentiel de référence, un interrupteur IT23 couple le noeud 1210 à un noeud 1212, et un interrupteur IT24 couple le noeud 1210 au potentiel de référence. Un circuit tampon unitaire analogique Buff couple le noeud 1212 à un noeud 1214. Un interrupteur IT25 couple le noeud 1214 à la sortie Out2 et un interrupteur IT26 couple la sortie Out2 au potentiel de référence.

L'interrupteur IT21 commandé par un signal correspondant au signal reçu par l'entrée wr auquel, de préférence, a été appliqué un retard pour éviter les injections de charges, est fermé lorsque ce signal retardé est actif, ouvert sinon. Les interrupteurs IT22 et IT23 sont fermés quand le signal reçu par l'entrée wr est inactif, ouvert sinon. L'interrupteur IT24 est fermé lorsque le signal reçu par l'entrée wr est actif ou qu'un signal correspondant au signal reçu par l'entrée rst auquel, de préférence, est appliqué un retard est actif, et ouvert sinon. L'interrupteur IT25 est fermé lorsque le signal reçu par l'entrée rst est inactif, ouvert sinon, l'interrupteur IT26 étant fermé lorsque le signal rst est actif, ouvert sinon.

En figure 16, chaque cellule Cellk comprend deux circuits SH connectés à la sortie Out du circuit SUMk de la cellule, un premier des deux circuits fournissant le signal de sortie Ak0 de la cellule, et l'autre des deux circuits fournissant le signal Ak1 de la cellule. En outre, chaque Cellk comprend deux autres circuits SH connectés à la sortie Out du circuit Quantk de la cellule, un premier des deux circuits fournissant le signal de sortie Bk0 de la cellule, et l'autre des deux circuits fournissant le signal Bk1 de la cellule. Par exemple, chaque circuit SH fournit une paire de signaux ayant des valeurs absolues identiques mais des signes opposés, et le multiplexeur du circuit RW auquel est fournie cette paire de signaux permet de sélectionner l'un des deux signaux, ce qui revient à sélectionner le signe du poids.

En bas de la figure 16, des chronogrammes illustrent des signaux de commande du modulateur, dans un exemple où chacun des signaux de commande est actif à l'état haut. Plus particulièrement, les chronogrammes illustrent une phase de réinitialisation Reset et un premier cycle C[1] d'une conversion sur N cycles C[n]. Dans cet exemple :

le premier circuit SH en partant du haut dans la cellule Cell1 reçoit les signaux wr1 et Rst sur ses entrées respectives wr et rst ;
le deuxième circuit SH en partant du haut dans la cellule Cell1 reçoit les signaux wr3 et Rst sur ses entrées respectives wr et rst ;
le troisième circuit SH en partant du haut dans la cellule Cell1 reçoit les signaux wr1 et Rst sur ses entrées respectives wr et rst ;
le quatrième circuit SH en partant du haut dans la cellule Cell1 reçoit les signaux wr3 et Rst sur ses entrées respectives wr et rst ;
le premier circuit SH en partant du haut dans la cellule Cell2 reçoit les signaux wr2 et Rst sur ses entrées respectives wr et rst ;
le deuxième circuit SH en partant du haut dans la cellule Cell2 reçoit les signaux wr3 et Rst sur ses entrées respectives wr et rst ;
le troisième circuit SH en partant du haut dans la cellule Cell2 reçoit les signaux wr2 et Rst sur ses entrées respectives wr et rst ;
le quatrième circuit SH en partant du haut dans la cellule Cell2 reçoit les signaux wr3 et Rst sur ses entrées respectives wr et rst ;
le quatre circuits SH de la cellule Cell3 reçoivent les signaux wr3 et Rst sur leurs entrées respectives wr et rst ;
le circuit SUM1 reçoit le signal de commande rd1 ;
le circuit SUM2 reçoit le signal de commande rd2 ;
le circuit SUM3 reçoit le signal de commande rd3 ;
le circuit Quant1 reçoit le signal de commande Cmp1 ;
le circuit Quant2 reçoit le signal de commande Cmp2 ; et
le circuit Quant3 reçoit le signal de commande Cmp3.

On notera que la mise en œuvre des figures 12 à 16 permet, lorsque les valeurs des résistances R des circuits Rw sont programmables, de programmer le modulateur de la figure 16 de sorte à pouvoir mettre en œuvre différents modèles entrainés de modulateurs à K cellules. Cela peut permettre, par exemple, de tester rapidement une mise en œuvre matérielle d'un modèle entrainé de modulateur, sans devoir concevoir un circuit dédié. Plus généralement, une topologie programmable de modulateur du type de celle de la figure 16, avec une valeur donnée de K et une valeur donnée de D peut être programmée avec des modèles entrainés de modulateurs dans lesquels K est inférieur ou égal à cette valeur donnée de K et/ou D est inférieur ou égal à cette valeur donnée de D. Dit autrement, cette topologie programmable est à l'image d'un FPGA (de l'anglais "Field Programmable Gate Array" - Réseau de portes programmable in-situ), mais est dédié à être programmée à partir du modèle entrainé de modulateur basé sur une succession de cellules Cellk.

De manière similaire, dans la mise en œuvre des figures 10 et 11, lorsque les valeurs des capacités des circuits Cneg, Cpos, Sumk et Quantk sont programmables, et que chaque poids est mis en œuvre par un circuit Cneg, un circuit Cpos et un multiplexeur aiguillant sélectivement un signal reçu vers l'un ou l'autre des circuits Cneg ou Cpos en fonction du signe du poids considéré, le modulateur est alors programmable. A titre d'exemple, une capacité programmable peut être mise en œuvre par une banque de capacités sélectionnables en parallèle, par exemple par une banque de capacités pondérées par dichotomie. Cela permet de pouvoir programmer différents modèles entrainés de modulateurs à K cellules, de sorte, par exemple, à tester rapidement une mise en œuvre matérielle d'un modèle entrainé de modulateur sans devoir concevoir un circuit dédié. Plus généralement, une topologie programmable de modulateur du type de celle de la figure 11, avec une valeur donnée de K et une valeur donnée de D peut être programmée avec des modèles entrainés de modulateurs dans lesquels K est inférieur ou égal à cette valeur donnée de K et/ou D est inférieur ou égal à cette valeur donnée de D. Dit autrement, cette topologie programmable est à l'image d'un FPGA (de l'anglais "Field Programmable Gate Array" - Réseau de portes programmable in-situ), mais est dédié à être programmée à partir du modèle entrainé de modulateur basé sur une succession de cellules Cellk.

Dans les exemples de mises en œuvre décrits ci-dessus en relation avec les figures 10 à 16, les poids et chemins ont tous été représentés. En pratique, lorsque l'on vise une mise en œuvre matérielle par un circuit dédié, lorsqu'un poids est nul, le circuit correspondant à la mise en œuvre de ce poids ainsi que les connexions associées à ce circuit sont omises.

Un exemple de mise en oeuvre de la méthode décrite précédemment va maintenant être décrit.

Dans cet exemple, la fabrication d'un convertisseur sigma-delta d'ordre M égal à 3 est recherchée, le convertisseur étant de type à intégrateurs cascadés (CIFF de l'anglais "Cascaded Integrator Feed-Forward").

Le modèle générique d'encodeur 200 comprend, dans cet exemple, K égal 4 cellules Cellk, les cellules Cell1, Cell2 et Cell3 correspondant chacune à un intégrateur et la cellule Cell4 étant un étage sommateur et quantificateur.

Etant donné que les topologies de modulateur sigma-delta pour les convertisseurs CIFF sont bien connues, des contraintes déterminées par ces topologies matérielles de convertisseurs ont déjà été appliquées au modèle générique d'encodeur 200 sous la forme d'un masque binaire pour masquer les poids, c'est à dire les chemins de données, absents de ces topologies matérielles connues. En outre, à partir de cette connaissance préalable de la topologie visée, D est fixé égal à 2.

Ainsi, après masquage, la matrice WM des poids de l'exemple du modèle générique d'encodeur pour correspondre à une topologie CIFF connue peut s'écrire :

[Math 19]

$$ WM^T = \begin{pmatrix} W1x & 0 & 0 & W4x \\ 0 & 0 & 0 & 0 \\ 0 & 0 & 0 & Wa410 \\ 0 & 0 & 0 & 0 \\ Wa111 & Wa211 & 0 & 0 \\ 0 & 0 & 0 & 0 \\ 0 & 0 & 0 & Wa420 \\ 0 & 0 & 0 & 0 \\ 0 & Wa221 & Wa321 & 0 \\ 0 & 0 & 0 & 0 \\ 0 & 0 & 0 & Wa430 \\ 0 & 0 & 0 & 0 \\ 0 & 0 & Wa331 & 0 \\ 0 & 0 & 0 & 0 \\ 0 & 0 & 0 & 0 \\ Wb141 & 0 & 0 & 0 \\ 0 & 0 & 0 & 0 \end{pmatrix} $$

Le décodeur (ou filtre) du modèle de convertisseur CIFF utilisé ici est du type de celui décrit en relation avec la figure 8.

Les modèles entraînés sont comparés avec un convertisseur CIFF d'ordre 3 connu, appelé par la suite convertisseur CIFF de référence et correspondant à la matrice de l'équation [Math 19] ci-dessus dans laquelle les poids non nuls ont les valeurs suivantes :

- W1x = 0.5674 ;
- Wa111 = 1.0000 ;
- Wb141 = -0.5674 ;
- Wa211 = 0.5126 ;
- Wa221 = 1.0000 ;
- Wa321 = 0.3171 ;
- Wa331 = 1.0000 ;
- W4x = 1.0000 ;
- Wa410 = 1.4000 ;
- Wa420 = 0.9900 ; et
- Wa430 = 0.4700.

Pour comparer le convertisseur CIFF de référence avec des convertisseurs obtenus par entrainement du modèle, c'est à dire par entrainement de la matrice [Math 19], on observe l'erreur maximale sur toute la dynamique DR du convertisseur. On utilise également la métrique MAXresol définie par [Math 18] .

Par ailleurs, on fixe ici une valeur maximale N égale à 100.

En outre, on compare des entrainements du modèle réalisés avec du bruit aléatoire suivant une distribution gaussienne ayant une déviation standard égale à $0,25*10^{-3}$, ce bruit aléatoire étant ajouté au modèle, en sortie de chaque cellule Cellk, comme une couche d'augmentation de données.

Afin de comparer les performances d'un convertisseur obtenu après un apprentissage profond supervisé avec celles du convertisseur de référence, la métrique MAXresol est par exemple utilisée, par exemple avec des signaux de test de dynamique équivalente. Plus particulièrement, les signaux du modèle ont une excursion maximale correspondant, par exemple, à la plage [-0,5 ; 0,5]. Les données d'entrée utilisées pour l'apprentissage ont une dynamique comprise dans la plage [-0,4 ; 0,4] et les données d'entrée utilisées pour le test ont une dynamique comprise dans la plage [-0,35 ; 0,35]. La dynamique DR du convertisseur sera une résultante de l'apprentissage. Ainsi, si l'apprentissage est tel que, à l'étape 920 (figure 9), le modèle entrainé satisfait aux spécifications visées, alors le convertisseur correspondant au modèle entrainé aura une dynamique DR au moins adaptée aux données de test. A titre d'exemple, pour le convertisseur de référence, la dynamique DR des données d'entrée correspond à la plage [-0,35 ; 0,35].

En outre, pour évaluer l'impact du choix de la fonction Fcost sur l'entrainement, on considère ici une fonction Fcost1 = Frmse + Fdr, une fonction Fcost2 = Flse + Fdr, une fonction Fcost3 = Fmix + Fdr et une fonction Fcost4 = Fmax + Fdr, avec A et B égaux respectivement à 0,8 et 0,2 dans la fonction de fidélité Fmix, et $\Delta k$ égal à 0,4 dans l'expression de la fonction Fdr selon [Math 15].

La valeur de la métrique MAXresol obtenue par simulation du modèle entrainé en l'absence de bruit temporel, est :

- meilleure (plus élevée) que celle obtenue pour le convertisseur de référence lorsque le modèle a été entrainé avec la fonction Fcost2 ou Fcost3,
- moins bonne (plus faible) que celle obtenue pour le convertisseur de référence lorsque le modèle a été entrainé avec la fonction Fcost1, et
- meilleure (plus élevée) que celle obtenue pour le convertisseur de référence lorsque le modèle a été entrainé avec la fonction Fcost4 pour des valeurs de N supérieures à 50.

La valeur de la métrique MAXresol obtenue par simulation du modèle entrainé en présence de bruit, est :

- meilleure que celle obtenue pour le convertisseur de référence lorsque le modèle a été entrainé avec la fonction Fcost2 ou Fcost3 pour des valeurs de N inférieures à 50, et
- moins bonne que celle obtenue pour le convertisseur de référence lorsque le modèle a été entrainé avec la fonction Fcost1,
- moins bonne que celle obtenue pour le convertisseur de référence lorsque le modèle a été entrainé avec la fonction Fcost4 pour des valeurs de N inférieures à 50,
- similaire à celle obtenue pour le convertisseur de référence lorsque le modèle a été entrainé avec la fonction Fcost4 pour des valeurs de N supérieures à 50.

A titre d'exemple, la matrice des poids du modulateur obtenue avec un entrainement utilisant la fonction Fcost2 et avec les couches d'augmentations de données introduisant du bruit temporel aléatoire peut s'écrire :

[Math 20]

$$WM^T = \begin{pmatrix} 0.4922 & 0 & 0 & 0.7467 \\ 0 & 0 & 0 & 0 \\ 0 & 0 & 0 & 1.2985 \\ 0 & 0 & 0 & 0 \\ 1.0197 & 0.3713 & 0 & 0 \\ 0 & 0 & 0 & 0 \\ 0 & 0 & 0 & 1.0519 \\ 0 & 0 & 0 & 0 \\ 0 & 1.0192 & 0.1166 & 0 \\ 0 & 0 & 0 & 0 \\ 0 & 0 & 0 & 1.1020 \\ 0 & 0 & 0 & 0 \\ 0 & 0 & 1.0195 & 0 \\ 0 & 0 & 0 & 0 \\ 0 & 0 & 0 & 0 \\ -0.5014 & 0 & 0 & 0 \\ 0 & 0 & 0 & 0 \end{pmatrix}$$

A titre d'exemple, le modulateur correspondant au modèle entrainé peut être mis en œuvre de la manière décrite avec les figures 10 et 11 pour une implémentation des poids sous forme capacitive, ou de la manière décrite en relation avec les figures 12 à 16 pour une implémentation des poids sous forme résistive.

En se référant de nouveau à l'exemple de modèle entrainé obtenu tel qu'indiqué par [Math 20], l'erreur de quantification pour ce modèle entrainé a été comparée à celle du convertisseur de référence, avec et sans bruit temporel, pour une valeur N égale à 100.

En l'absence de bruit temporel, il a été constaté que cette erreur de quantification est plus faible pour le modèle entrainé que pour le convertisseur de référence pour des signaux d'entrée x ayant une valeur xa comprise entre -0,35 et environ -0,30 et entre environ 0,30 et 0,35, c'est à dire aux limites de la dynamique DR.

En présence de bruit temporel, les erreurs de quantification pour le modèle entrainé et pour le convertisseur de référence sont similaires sur toute la dynamique DR.

Un autre exemple de mise en oeuvre de la méthode de la figure 9 décrite précédemment va maintenant être décrit.

Dans cet autre exemple, il est proposé d'entrainer un modèle correspondant à la topologie définie par la matrice de poids de [Math 21] :

[Math 21]

$$WM^T = \begin{pmatrix} W1x & W2x & W3x & W4x \\ 0 & 0 & 0 & 0 \\ 0 & 0 & 0 & Wa410 \\ 0 & 0 & 0 & 0 \\ Wa111 & Wa211 & Wa311 & 0 \\ 0 & 0 & 0 & 0 \\ 0 & 0 & 0 & Wa420 \\ 0 & 0 & 0 & 0 \\ Wa121 & Wa221 & Wa321 & 0 \\ 0 & 0 & 0 & 0 \\ 0 & 0 & 0 & Wa430 \\ 0 & 0 & 0 & 0 \\ Wa131 & Wa231 & Wa331 & 0 \\ 0 & 0 & 0 & 0 \\ 0 & 0 & 0 & 0 \\ Wb141 & Wb241 & Wb341 & 0 \\ 0 & 0 & 0 & 0 \end{pmatrix}$$

Dit autrement, ce modèle comprend K égal 4 cellules Cellk. Les cellules Cell1, Cell2, Cell3 et Cell4 reçoivent toutes le signal x[n] et lui appliquent des poids respectifs W1x, W2x, W3x et W4x. Les cellules Cell1, Cell2 et Cell3 reçoivent toutes la sortie non quantifiée et retardée d'un cycle A11 [n] de la cellule Cell1 et lui appliquent des poids respectifs Wa111, Wa211 et Wa311. Les cellules Cell1, Cell2, et Cell3 reçoivent toutes la sortie non quantifiée et retardée d'un cycle A21[n] de la cellule Cell2 et lui appliquent des poids respectifs Wa121, Wa221 et Wa321. Les cellules Cell1, Cell2 et Cell3 reçoivent toutes la sortie non quantifiée et retardée d'un cycle A31[n] de la cellule Cell3 et lui appliquent des poids respectifs Wa131, Wa231 et Wa331. Les cellules Cell1, Cell2 et Cell3 reçoivent toutes la sortie quantifiée et retardée B41[n] de la cellule Cell4 et lui appliquent des poids respectifs Wb141, Wb241 et Wb341. La cellule Cell4 reçoit les sorties non-quantifiées et non-retardées A10[n], A20[n] et A30[n] des cellules respectives Cell1, Cell2 et Cell3 et leurs applique les poids respectifs Wa410, Wa420 et Wa430. Les autres connexions sont absentes, et leurs poids correspondants sont nuls, et ces poids sont maintenus nuls pendant l'entrainement grâce à une contrainte appliqué sur le modèle, en pratique un masque binaire.

Le modèle défini par [Math 21] est une topologie mixte entre une topologie CIFF et une topologie CIFB (de l'anglais "Cascaded Integrators Feed-Backward" - contre réaction à intégrateurs cascadés).

La valeur de la métrique MAXresol obtenue par simulation du modèle entrainé en l'absence de bruit temporel, est :

- meilleure pour la topologie de la matrice [Math 21] que pour la topologie de la matrice [Math 20] pour des valeurs de N supérieures à 50 lorsque les modèles ont été entrainés avec la fonction Fcost2 ou Fcost3,
- similaire pour la topologie de la matrice [Math 21] et pour la topologie de la matrice [Math 20] pour des valeurs de N inférieures à 50 lorsque les modèles ont été entrainés avec la fonction Fcost2 ou Fcost3, et
- similaire pour la topologie de la matrice [Math 21] et pour la topologie de la matrice [Math 20] pour des valeurs de N comprises entre 1 et 100 lorsque les modèles ont été entrainés avec la fonction Fcost4.

La valeur de la métrique MAXresol obtenue par simulation du modèle entrainé en présence de bruit temporel, est :

- meilleure pour la topologie de la matrice [Math 21] que pour la topologie de la matrice [Math 20] pour des valeurs de N supérieures à 50 lorsque les modèles ont été entrainés avec la fonction Fcost2 ou Fcost3,
- similaire pour la topologie de la matrice [Math 21] et pour la topologie de la matrice [Math 20] pour des valeurs de N inférieures à 50 lorsque les modèles ont été entrainés avec la fonction Fcost2 ou Fcost3, et
- similaire pour la topologie de la matrice [Math 21] et pour la topologie de la matrice [Math 20] pour des valeurs de N comprises entre 1 et 100 lorsque les modèles ont été entrainés avec la fonction Fcost4.

A titre d'exemple, le modèle entrainé obtenu avec la fonction Fcost2 à partir de la topologie de la matrice [Math 21] correspond à la matrice de poids suivante :

[Math 22]

$$WM^T = \begin{pmatrix} 0.4919 & 0.2338 & 0.2810 & 0.1613 \\ 0 & 0 & 0 & 0 \\ 0 & 0 & 0 & 0.6285 \\ 0 & 0 & 0 & 0 \\ 1.0193 & 0.3723 & 0.1167 & 0 \\ 0 & 0 & 0 & 0.5667 \\ 0 & 0 & 0 & 0 \\ 0 & 0 & 0 & 0 \\ -0.0003 & 1.0196 & 0.1557 & 0 \\ 0 & 0 & 0 & 0 \\ 0 & 0 & 0 & 0.8706 \\ 0 & 0 & 0 & 0 \\ -0.0001 & -0.0001 & 1.0006 & 0 \\ 0 & 0 & 0 & 0 \\ 0 & 0 & 0 & 0 \\ -0.4938 & -0.2278 & -0.2373 & 0 \\ 0 & 0 & 0 & 0 \end{pmatrix}$$

Pour cet exemple de modèle entrainé, il a été constaté que l'erreur de quantification du modèle entrainé est meilleure que celle du convertisseur de référence pour toute la dynamique DR lorsqu'il n'y a pas de bruit temporel. En outre l'INL (de l'anglais "Integral Non Linearity" - non linéarité intégrale) est meilleure pour le modèle entraîné.

En reprenant l'exemple de modèle entrainé correspondant à [Math 22], ou en repartant du modèle correspondant à la topologie de la matrice [Math 21], une nouvelle étape d'entrainement axé sur la quantification est mise en œuvre pour obtenir des poids quantifiés.

Dans cet exemple, dans l'équation [Math 17], qstep est une valeur apprise en utilisant un poids $W^l$**scale** appris, et est alors égal à $1/(\text{round}((2^{q-1})/W^l\text{scale}))$. En outre, une contrainte est appliquée au modèle pour que les poids quantifiés soient tous multiples d'un facteur 1/s avec s entier.

On obtient alors une matrice WMq de poids quantifiés multiple d'un élément unitaire (dénominateur commun) de valeur 1/s avec s égal à 6. En outre, la valeur apprise de qstep est égale à 4, et la matrice de poids quantifiée s'écrit :

[Math 23]

$$WMq^{T} = \begin{pmatrix} 3 & 1 & 2 & 4 \\ 0 & 0 & 0 & 0 \\ 0 & 0 & 0 & 1 \\ 0 & 0 & 0 & 0 \\ 6 & 2 & 0 & 0 \\ 0 & 0 & 0 & 0 \\ 0 & 0 & 0 & 5 \\ 0 & 0 & 0 & 0 \\ 0 & 6 & 1 & 0 \\ 0 & 0 & 0 & 0 \\ 0 & 0 & 0 & 8 \\ 0 & 0 & 0 & 0 \\ 0 & 0 & 6 & 0 \\ 0 & 0 & 0 & 0 \\ 0 & 0 & 0 & 0 \\ -3 & -1 & -2 & 0 \\ 0 & 0 & 0 & 0 \end{pmatrix}$$

Chaque poids non nul est mis en œuvre en multipliant sa valeur quantifiée par la valeur de l'élément unitaire, dans cet exemple égal à 1/s avec s égal à 6.

Cette mise en œuvre avec des poids quantifiés est comparée à un convertisseur de référence correspondant au convertisseur de référence des exemples précédents dans lequel les poids ont été quantifiés. Il est alors constaté que, dans ce convertisseur de référence à poids quantifié, les signaux de sortie des étages saturent alors que ce n'est pas le cas des signaux de sorties des cellules Cellk du modèle entrainé à poids quantifiés de [Math 23].

En outre, le modèle entrainé à poids quantifiés de [Math 23] présente une erreur de quantification bien inférieure à celle du convertisseur de référence à poids quantifiés, sur toute la dynamique DR, pour une valeur N égale à 100.

Cela résulte du fait que la méthodologie classique de dimensionnement permettant d'obtenir les poids quantifiés du convertisseur de référence à partir des poids non quantifiés de ce convertisseur de référence ne tient pas compte des effets de la quantification des poids. Au contraire, la méthode présentée ici, permettant par exemple d'obtenir la matrice de poids quantifié [Math 23] tient compte de ces effets lorsque l'entrainement est axé sur la quantification. Cela illustre l'intérêt d'un apprentissage satisfaisant conjointement l'ensemble des spécifications matérielles transcrites sous formes de contraintes ou de régularisations, à la différence d'une approche de dimensionnement standard nécessitant un ajustement séquentiel des paramètres de la topologie.

A titre d'exemple, comme cela a été évoqué précédemment, il est possible de mettre en œuvre une régularisation L0 ou L1 lors d'un l'entraînement basé sur la quantification. Il a été constaté que, en augmentant la pondération d'une régularisation L1 (qui a pour objectif d'introduire une pénalité fonction de la somme des valeurs absolues des poids latents de l'encodeur), le nombre de poids non nuls tend à diminuer. Augmenter le poids de la régularisation L1 permet d'obtenir un modèle entrainé plus compact, par exemple un modèle entrainé correspondant à un ordre 2 plutôt qu'à un ordre 3 comme c'est le cas du modèle entrainé correspondant à la matrice [Math 23], mais avec des performances plus faibles.

Dans les exemples d'entraînement de convertisseurs analogique numérique décrits précédemment, de préférence, les sorties quantifiées des cellules Cellk ne sont pas utilisées, par exemple en étant masquées par une matrice de masquage, sauf en ce qui concerne la dernière cellule.

A titre d'autre exemple, il est prévu de conserver, pour chaque cellule Cellk, au moins une sortie quantifiée Bkd[n], et de fournir l'ensemble de ces sorties quantifiées à un filtre conçu pour traiter ces flux de bits.

Un autre exemple de mise en oeuvre de la méthode de la figure 9 décrite précédemment va maintenant être décrit.

Dans cet autre exemple, il est proposé d'entrainer un modèle de convertisseur dans lequel le filtre reçoit au moins une sortie quantifiée Bkd[n] de chaque cellule Cellk.

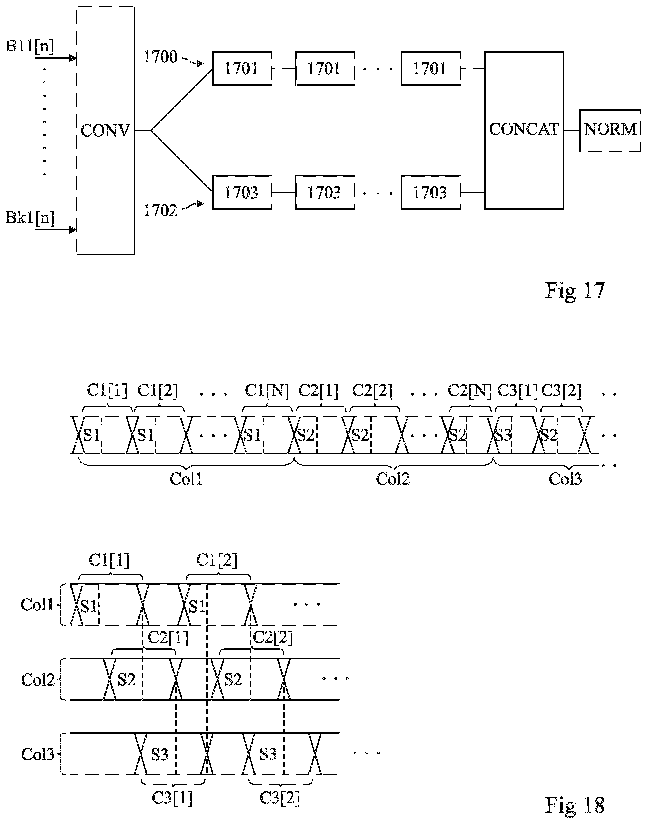

La figure 17 illustre un exemple de modèle de filtre pour traiter des flux de bits provenant des K cellules Cellk d'un modèle générique de modulateur, dans le cas où chaque cellule fournit un flux de bits correspondant à la sortie Bk1 [n] de la cellule.

A chaque cycle C[n] d'une conversion, le filtre reçoit K flux de bits Bk1[n].

Le filtre comprend une première couche de convolution unidimensionnelle CONV. Cette couche de convolution est configurée pour effectuer à chaque cycle C[n] des recombinaisons des K flux Bk1 sur une profondeur temporelle donnée, pour enrichir l'expressivité du filtre.

Par exemple, la couche CONV reçoit K canaux Bk1 de profondeur temporelle N. La couche CONV effectue alors C*K convolutions de profondeur v. Par exemple, la couche CONV calcule C valeurs, chaque valeur étant une somme pondérée de K convolutions de profondeur v appliquées aux K canaux reçus. La couche CONV fournit alors en sortie un vecteur de dimension C mis à jour à chaque cycle C[n] de conversion.

La sortie de cette couche de convolution CONV est fournie à une première branche 1700 du filtre. La première branche comprend plusieurs cellules ou réseaux de neurones simples SRNN (de l'anglais "Simple Recurrent Neural Network") cascadés, sans couche d'activation. En figure 17, chaque réseau ou cellule SRNN est référencé 1701. A titre d'exemple, le premier réseau 1701 est similaire au réseau SRNN1 de la figure 8, à la différence que, plutôt que de recevoir un seul bit Bk0[n] et de lui appliquer un seul poids Wd1, ce réseau reçoit un vecteur de C élément auquel il applique un vecteur de C poids correspondant. En outre, le réseau récurrent SRNN1 reçoit en outre en entrée autant signaux qu'il fournit de sorties, chacun de ces signaux d'entrée étant déterminé par une sortie correspondante du réseau, et auxquels il applique un vecteur de poids Wc1 ayant une taille égale au nombre de sorties du réseau. Dans cet exemple, le réseau ne fournit qu'une seule sortie et le vecteur Wc1 ne comprend qu'un seul poids. A titre d'exemple, le nombre de réseaux 1701 est déterminé par la précision de filtrage visée, et est, par exemple, supérieur ou égal à K.

La sortie de la couche CONV est également fournie à une deuxième branche 1702 du filtre. La deuxième branche comprend des unités récurrentes fermées (GRU de l'anglais "gated recurrent unit") en cascade, par exemple à activation linéaire et sigmoïde. Les unités récurrentes fermées sont bien connues de la personne du métier et ne sont pas redéfinies ici. En figure 17 chaque unité récurrente fermée est référencée 1703. A titre d'exemple, le nombre d'unités récurrentes est le même que le nombre de réseau 1701.

Chacune des branches 1700 et 1702 fournit donc une seule donnée (ou signal) mise à jour à chaque cycle C[n]. Les sorties fournies par chacune des branches 1700 et 1702 sont ensuite concaténées comme cela est illustré en figure 17 par un bloc "CONCAT".

Le filtre comprend enfin une couche NORM de normalisation de la sortie de la couche CONCAT, c'est à dire un vecteur de données de dimension 2, mise à jour à chaque cycle C[n]. La couche NORM effectue, à chaque cycle C[n], une somme pondérée, avec des poids appris, des deux données du vecteur de dimension 2 qu'elle reçoit.

Dans un autre exemple, la branche 1702 et la concaténation CONCAT peuvent être omises, ainsi que le bloc de convolution, afin de ne conserver que la branche 1700 qui va directement recevoir en entrée les K flux Bk1.

A titre d'exemple, on considère un modèle générique dans lequel :

pour le modulateur :

- K est égal à 4 ;
- la valeur de N maximale est 100 ;
- les plages de valeurs des données d'entrée d'entrainement, des données d'entrée de simulation et des signaux internes du modulateur sont les mêmes que celles définies pour les exemples précédents ;
- m = 4 ;
- des couches d'augmentation de données ajoutant un bruit aléatoire gaussien d'écart type égal à $0.25*10^{-3}$ sont ajoutées en sortie de chacune des K cellules Cellk ;
- une matrice de masquage de poids est appliquée sur la matrice WM des poids du modulateur, pour masquer :

    * pour chaque cellule Cellk à l'exception de la dernière, les poids Wak40, Wbk40, Wak41, et
    * pour la dernière cellule Cell4, les poids autres que W4x, Wa410, Wb410, Wa420, Wb420, Wa430 et Wb430 ;
    et

pour le filtre :

- la convolution n'est faite que sur les sorties quantifiées retardées des K cellules Cellk, c'est à dire sur les sorties Bk1 [n] des K cellules Cellk ;
- la branche 1700 comprend 4 réseaux 1701 ; et
- la branche 1702 comprend 4 unités 1703.

De préférence, pour faciliter la convergence lors de l'apprentissage du modèle, à partir de plusieurs ensembles de données d'entrée xa, une couche de normalisation est ajoutée au modèle, en sortie du filtre, qui est configurée, pour chaque ensemble de données xa d'entrainement, pour appliquer un gain correctif alignant la moyenne des valeurs absolues des signaux xq obtenus pour cet ensemble de données xa, sur la moyenne des valeurs absolues des données d'entrée xa de cet ensemble. Dans ce cas, une propriété statistique est imposée aux données d'entrainement qui consiste à ce que, dans chaque ensemble de données xa utilisé, les données xa suivent une distribution avec une moyenne des valeurs absolue connue et identique pour tous les ensembles. Une telle propriété statistique correspond à une stratégie d'apprentissage telle qu'illustré par le bloc 919 ("STAT") de la figure 9.

De préférence, pour faciliter la convergence lors de l'apprentissage du modèle, des couches de régularisations sur les données sont ajoutées en sortie de chaque cellule Cellk, pour introduire, pour chaque ensemble de données d'entrée xa, une pénalité proportionnelle à la différence entre la moyenne des valeurs absolues visée pour cet ensemble et la moyenne des valeurs absolues obtenue pour cet ensemble en sortie de chaque cellule Cellk. Dans ce cas, la même propriété statistique que ci-dessus est imposée aux ensembles de données d'entrainement.

De préférence, pour faciliter la convergence lors de l'apprentissage du modèle, le taux d'apprentissage est rendu dépendant de la valeur courante de la métrique MAXresol, en plus d'une diminution classique du taux d'apprentissage basée le rang des époques. Cela correspond à une stratégie d'apprentissage illustrée par le bloc 918 ("CB FCT") en figure 9.

De préférence, pour faciliter la convergence lors de l'apprentissage du modèle, il est prévu deux taux d'apprentissage différents, l'un pour le filtre, l'autre pour le modulateur, et, à chaque époque, un seul des deux taux d'apprentissage est mis à jour par une fonction de rappel, en alternant une époque avec une mise à jour du premier taux, et une époque avec une mise à jour du deuxième taux. Cela correspond à une stratégie d'apprentissage illustrée par le bloc 918 ("CB FCT") en figure 9. L'intérêt de prévoir ces deux taux d'apprentissage est d'alterner, au cours des époques, celui des deux taux d'apprentissage qui est le plus fort, par exemple dix fois plus fort que l'autre taux d'apprentissage pour l'époque considérée, de sorte à stabiliser l'apprentissage, tout en ne figeant pas la mise à jour des poids.

De préférence, l'entrainement est axé sur la quantification, mais avec un pas de quantification qstep qui n'est plus basé sur la valeur maximale des valeurs absolues à des poids latents et égal à $1/(\text{round}((2^{q-1})/Wl_{max}))$, mais qui est appris pendant l'entrainement et égal à $1/(\text{round}((2^{q-1})/Wl_{scale}))$, avec $Wl_{scale}$ un poids appris lors de l'entrainement.

Dans l'exemple considéré, la fonction de coût utilisée est la fonction Fcost2.

Le modèle entrainé à poids quantifiés obtenu pour cet exemple présente alors une erreur de quantification plus faible que celle du modèle entrainé à poids quantifié correspondant à [Math 23], et, en outre une meilleure robustesse vis-à-vis du bruit. Ainsi, cet exemple montre que l'utilisation, par le filtre, des sorties quantifiées de chaque cellule Cellk permet d'améliorer la conversion analogique numérique.

Un autre exemple de mise en oeuvre de la méthode de la figure 9 décrite précédemment va maintenant être décrit.

Dans cet autre exemple, on considère ici le cas où le convertisseur à fabriquer est configuré pour mettre en œuvre des conversions analogiques numériques en pied de colonne d'une matrice de pixels au sein d'un capteur d'image. Il est classiquement prévu de mettre un convertisseur par colonne de sorte que, lors de la lecture d'une ligne, chaque convertisseur convertisse le signal de sortie d'un pixel de sa colonne. Toutefois, cela résulte en une mise en œuvre encombrante du fait de la surface occupée par chaque convertisseur.

Lire plusieurs colonnes avec un seul convertisseur permet de relâcher les contraintes d'implémentation, notamment les contraintes liées à la surface disponible en pied de chaque colonne. Dans une telle mise en œuvre, on prévoit un seul convertisseur pour plusieurs colonnes, par exemple trois colonnes ce qui permet de diviser par 3 le nombre de convertisseurs. Dans ce cas, le convertisseur convertit d'abord le signal d'une première colonne de l'ensemble en N cycles, puis le signal d'une deuxième colonne de l'ensemble en N cycles et ainsi de suite jusqu'à avoir lu toutes les colonnes. Cependant, le temps nécessaire à la mise en œuvre de chaque cycle est limité par le temps nécessaire à l'échantillonnage du signal, d'où il résulte que le temps nécessaire pour qu'un convertisseur lise l'ensemble des colonnes auxquelles il est associé est limité. En effet, dans un convertisseur capacitif, à chacun des N cycles de conversion, une capacité d'entrée du convertisseur doit d'abord être chargée avec le signal de sortie de la colonne, qui correspond au signal à convertir. Or, ce temps de chargement est généralement important, par exemple du fait des propriétés du transistor à source suiveuse du pixel qui est responsable du chargement de la capacité.

Ainsi, dans cet exemple d'application, il est proposé un convertisseur mettant en oeuvre une méthode de lecture, plus particulièrement une méthode d'échantillonnage, dans laquelle les colonnes associées à un même convertisseur sont échantillonnées par ce convertisseur les unes après les autres, de manière cyclique et répétée en entrée du convertisseur. Dit autrement, il est proposé un convertisseur dans lequel des canaux en entrée du convertisseur sont échantillonnés de manière cyclique, alternée et entrelacée. De cette façon, pendant que le convertisseur échantillonne une colonne, il peut traiter l'échantillon disponible pour la colonne précédente. Cela permet de réduire le temps total nécessaire pour convertir les signaux de sortie de l'ensemble des colonnes associées au convertisseur.

La figure 18 illustre le cas d'un convertisseur associé à trois colonnes Col1, Col2 et Col3, c'est à dire un multiplexage de trois colonnes vers un convertisseur, dans le cas où les colonnes sont lues séquentiellement, les unes après les autres (en haut de la figure 18), et dans le cas où la lecture des colonnes se fait de manière cyclique et entrelacée (en bas de la figure 18). Plus particulièrement, lors de la lecture entrelacée des colonnes, les N cycles de conversion de chaque colonne sont entrelacés de manière cyclique avec les N cycles de conversion de chacune des autres colonnes.

En figure 18, en haut, la colonne Col1 est lue en première par le convertisseur. Cette lecture correspond à N cycles C[n], référencés C1 [n] en figure 18, chaque cycle C1[n] débutant par une période S1 correspondant à l'échantillonnage du signal de sortie de la colonne Col1. Puis la colonne Col2 est lue en deuxième par le même convertisseur. Cette deuxième lecture correspond à N cycles C [n], référencés C2[n] en figure 18, chaque cycle C2[n] débutant par une période S2 correspondant à l'échantillonnage du signal de sortie de la colonne Col2. Enfin la colonne Col3 est lue en dernier par le convertisseur. Cette dernière lecture correspond à N cycles C[n], référencés C3[n] en figure 18, chaque cycle C3[n] débutant par une période S3 correspondant à l'échantillonnage du signal de sortie de la colonne Col3.

En figure 18, en bas, les N cycles de lecture de chaque colonne sont entrelacés de manière cyclique et recouvrante avec les N cycles de lecture de chaque autre colonne. Par exemple, le convertisseur met en œuvre successivement un cycle C1 [n], puis un cycle C2[n] puis un cycle C3[n] et répète ce motif N fois. Pendant chaque cycle C1[n], la période S2 du cycle C2[n] est mise en œuvre de sorte que, dès la fin du cycle C1 [n], la période S2 soit terminée. Pendant chaque cycle C2 [n], la période S3 du cycle C3 [n] est mise en oeuvre de sorte que, dès la fin du cycle C2[n], la période S3 soit terminée. Enfin, pendant chaque cycle C3[n], la période S3 du cycle C1 [n+1] est mise en oeuvre de sorte que, dès la fin du cycle C3[n], la période S3 soit terminée.

Il en résulte que le temps total nécessaire au convertisseur pour lire les 3 colonnes est plus faible dans le cas où les N cycles de conversion de chaque colonne sont entrelacés de manière cyclique et recouvrante avec les N cycles de conversion de chaque autre colonne, que dans le cas où les N cycles de lecture de chaque colonne sont mis en œuvre successivement pour chaque colonne et les colonnes sont lues les unes après les autres, sans réduire les durées S1, S2, S3 d'échantillonnage des valeurs de sortie des colonnes Col1, Col2, Col3. Cela résulte du fait que, lorsque les N cycles de conversion de chaque colonne sont entrelacés de manière cyclique et recouvrante avec les N cycles de conversion de chaque autre colonne selon un motif répété N fois, à l'échantillonnage du cycle de conversion correspondant à la colonne est mis en œuvre pendant le cycle de conversion précédent qui correspond à une autre colonne.

Pour mettre en œuvre le fonctionnement décrit ci-dessus, il est prévu, dans l'implémentation matérielle du convertisseur à fabriquer, un circuit d'échantillonnage TSample à T entrées et une sortie, avec T le nombre de colonnes associées au convertisseur. Le circuit d'échantillonnage est configuré pour échantillonner de manière cyclique et périodique les T colonnes les unes après les autres. En outre, à chaque fois que la sortie du circuit d'échantillonnage fournit un signal échantillonné correspondant à une colonne, le circuit d'échantillonnage met en œuvre l'échantillonnage d'une autre colonne. Ainsi, pendant que l'encodeur du convertisseur reçoit et traite le signal échantillonné disponible sur la sortie du circuit d'échantillonnage et correspondant à l'une des T colonnes, le circuit d'échantillonnage est en train d'échantillonner une autre des T colonnes. Dans une implémentation à base de capacités d'échantillonnage, à la différence de la solution présentée en haut de la figure 18 dans laquelle on dispose d'une unique capacité d'échantillonnage en entrée du convertisseur, la solution entrelacée proposée implique cependant la présence de T capacités d'échantillonnage afin de gérer les recouvrements.

La conversion des signaux de sortie de T colonnes, lorsqu'une conversion s'effectue en N cycles, s'effectue en T*N cycles C[n], avec n un indice allant de 1 à T*N. A chaque cycle C[n], les sorties quantifiées Bkd de chaque cellule Cellk sont mémorisées à chaque mise à jour du vecteur d'entrée d'une des K cellules du convertisseur, la mise à jour de chaque cellule étant effectuée par exemple de la gauche vers la droite, et l'ensemble des sorties mémorisées est fourni au décodeur à la fin du cycle C[n] sous la forme d'un vecteur Z[n] correspondant. Dit autrement, à chaque début d'intracycle d'un cycle C[n], où un intracycle débute lorsqu'une cellule Cellk fournit ses sorties mises à jour à la cellule Cellk suivante, toutes les sorties Bkd des K cellules CellK sont mémorisées, et l'ensemble de ces mémorisations est fourni à la fin du cycle C[n] sous la forme d'un vecteur Z[n] au décodeur. Ainsi, ce vecteur Z[n] comprend D*K signaux Bkd pour chaque intracycle, donc D*K*K signaux Bkd à la fin du cycle C[n]. Il est important de noter que cette notion d'intracycle permet d'exploiter l'évolution transitoire des sorties Bk0d d'un cycle C[n] donné. Dans le cas où on ne tiendrait compte que des sorties Bk1d, la notion d'intracycle n'a pas de sens dans la mesure où toutes les cellules sont mises à jour en même temps.

Le modèle de décodeur utilisé comprend, par exemple, T branches 1900 comprenant chacune plusieurs réseaux de neurones récurrents simples 1902. Le premier réseau de neurone récurrent simple 1902 de chaque branche 1900 est configuré pour recevoir un vecteur d'entrée ayant la dimension du vecteur Z[n], et comprend donc un vecteur de poids ayant la dimension du vecteur Z[n] plus un (pour le signal de rebouclage du réseau sur lui-même dans le cas de réseaux récurrents simples à une seule sortie). Les réseaux 1902 suivants de la branche sont, par exemple, similaires aux réseaux SRNN2 et SRNN3 décrits en relation avec la figure 8.

Le décodeur comprend en outre un circuit de démultiplexage Cmux. Le circuit Cmux reçoit chacun des vecteurs T*N vecteur Z[n]. Le circuit Cmux est configuré pour fournir les vecteurs Z[n] qu'il reçoit de manière alternée et cyclique à chacune des T branches 1900. Ainsi, à cycle C[n] correspondant à l'une des T colonnes, le vecteur Z[n] obtenu à la fin du cycle C[n] est fourni à la même branche des T branches 1700 du filtre. Chaque branche 1900 du décodeur fournit alors le résultat de conversion d'une colonne correspondante.

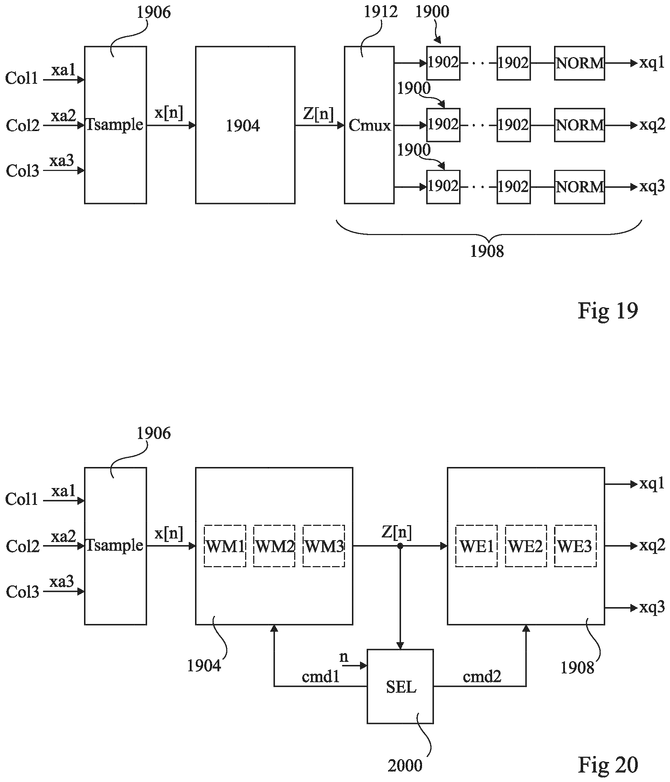

La figure 19 illustre un exemple d'un modèle de convertisseur tel que décrit ci-dessus dans le cas où T est égal à 3.

L'encodeur 1904 comprend K égal 4 cellules CellK dans cet exemple, et est représenté sous la forme d'un bloc pour ne pas surcharger la figure. Le modèle de convertisseur comprend un bloc 1906 (bloc "TSample" en figure 19) mettant en œuvre, dans le modèle, la fonction du circuit d'échantillonnage TSample qui fera partie du convertisseur une fois fabriqué. Le bloc Tsample reçoit les signaux de sortie xa1, xa2 et xa3 des Tcolonnes Col1, Col2 et Col3. Le vecteur Z[n] de sortie de l'encodeur, c'est à dire le vecteur Z[n] disponible à la fin de chacun des T*N cycles C[n], est fourni par l'encodeur 1904 au filtre, ou décodeur, 1908.

Le filtre 1908 comprend les T=3 branches 1900 de réseaux 1902 cascadés. A titre d'exemple, chaque branche comprend K=4 réseaux 1902 cascadés. De manière optionnelle, chaque branche 1900 comprend une couche de normalisation 1910 (bloc "NORM" en figure 19) connectée au dernier réseau 1902 de la branche. Le décodeur 1908 comprend un bloc 1912 (bloc "Cmux" en figure 19) mettant, dans le modèle, la fonction du circuit Cmux qui fera partie du convertisseur une fois fabriqué.

Chaque branche fournit un signal numérique correspondant à la conversion du signal d'une des Tcolonnes. Par exemple, une première branche 1900 fournit un signal xq1 correspondant à la conversion du signal xa1, une deuxième branche fournit un signal xq2 correspondant à la conversion du signal xa2, et une troisième branche fournit un signal xq3 correspondant à la conversion du signal xa1.

A titre d'exemple, en entraînant un modèle de convertisseur du type de celui de la figure 19 dans lequel :

le modulateur comprend K égal quatre cellule Cellk,
N est égal à T*40,
T est égal à 3,
D est égal à 2,
des couches d'augmentation de données sont prévues et introduisent un bruit aléatoire gaussien d'écart type égal à $0.25*10^{-3}$,
les plages de valeurs des données d'entrée d'entrainement, des données d'entrée de simulation et des signaux internes du modulateur sont les mêmes que celles définies pour les exemples précédents,
le démodulateur correspond au décodeur 1908 décrit en relation avec la figure 19,
et dans lequel l'entrainement est mis en œuvre de la façon suivante :

l'entrainement est axé sur la quantification avec q compris appartenant à la plage allant de 10 à 20,
la fonction de coût utilisée est la fonction Fcost2,
les inventeurs ont obtenu un modèle de convertisseur entrainé fonctionnant avec le multiplexage sur son entrée décrit ci-dessus avec T égal à 3, avec un poids unitaire pour les poids quantifiés égal à $1.18889*10^{-6}$ pour q égal à 20.

Pour chaque colonne, la performance de conversion par le convertisseur entrainé, par exemple évaluée avec la métrique MAXresol, est similaire à celle obtenue en prévoyant un convertisseur indépendant par colonne mettant en œuvre une conversion en N cycles.

Cet exemple d'entraînement d'un convertisseur analogique-information montre l'intérêt du modèle générique d'encodeur proposé ici, ainsi que de la méthode de conception de convertisseur proposée. En particulier, cet exemple montre qu'il est possible d'entraîner le modèle générique d'encodeur conjointement à un modèle de filtre sous la forme de réseaux de neurones, ou, dit autrement, un filtre modélisé par des réseaux de neurones, de sorte à mettre en œuvre une fonction de conversion analogique vers information. Sans la méthode proposée ici, et en particulier sans le modèle générique d'encodeur proposé ici, il n'existe pas de méthode permettant de déterminer et dimensionner une topologie de convertisseur permettant de mettre en œuvre le même multiplexage/démultiplexage entre plusieurs canaux, où l'échantillonnage est alterné de manière cyclique et périodique entre les canaux.

Un autre exemple de mise en oeuvre de la méthode de la figure 9 décrite précédemment va maintenant être décrit.

Dans cet autre exemple, le convertisseur à fabriquer est du type décrit dans l'exemple précédent, c'est à dire avec un multiplexage alterné, cyclique et périodique de T canaux à convertir en entrée de l'encodeur du convertisseur, et un démultiplexage alterné, cyclique et périodique de vecteur de sortie Z[n] de l'encodeur vers T branches du décodeur, le multiplexage et le démultiplexage étant mis à jour à chaque début des T*N cycles C[n] de conversion. Toutefois, on propose ici en plus de prévoir R matrices de poids WMi pour le modèle d'encodeur, avec i allant de 1 à R, et, de manière optionnelle, V matrices de poids WEj pour le décodeur, avec j allant de 1 à V. Dans cet exemple, R et V sont égaux à T. Une fonction supplémentaire SEL est ajoutée au modèle de convertisseur. Cette fonction est configurée pour sélectionner laquelle des matrices WMi, et, lorsque les matrices WEj optionnelles sont prévues, laquelle des matrices WEj doivent être utilisées à chacun des T*N cycles C[n], en se basant sur l'analyse de plusieurs vecteurs Z[n] fournis par l'encodeur lors des cycles C[n] précédents et sur la connaissance de l'indice n du cycle C[n] courant. Cette fonction SEL, correspondant à un mécanisme d'attention, est, par exemple, ajoutée au modèle sous la forme d'un réseau de neurones. De préférence, lors de l'entrainement, une régularisation est appliquée aux poids des matrices WMi pour forcer ces différentes matrices de poids WMi à avoir un certain taux de poids en commun. En effet, cela permet d'avoir une implémentation matérielle plus compacte. Une régularisation similaire peut être prévue pour les différentes matrices de poids WEj.

Un exemple d'un tel modèle de convertisseur est illustré, de manière très schématique et fonctionnelle, en figure 20, dans le cas où R et V sont égaux à 3, et où T est égal à 3.

Comme cela se voit sur la figure 20, le modèle d'encodeur 1904 comprend les R = 3 matrices de poids WM1, WM2 et WM3 et, dans cet exemple, le modèle de décodeur 1908 comprend les V = 3 matrices de poids WE1, WE2 et WE3. Un bloc 2000 ("SEL" en figure 20) reçoit les vecteurs Z[n] de sortie de l'encodeur 1904, et l'indice n du cycle C[n] courant. Ce bloc 2000 détermine alors, sur la base de plusieurs vecteurs Z[n] reçus lors des cycles C[n] précédant le cycle C[n] courant, laquelle des matrices de poids WM1, WM2 et WM3 doit être utilisée au niveau de l'encodeur 1904 pour le cycle C[n] courant, et, lorsque V matrices WEj sont prévues pour le décodeur, laquelle des matrices de poids WE1, WE2 et WE3 doit être utilisée au niveau du décodeur pour ce cycle C[n] courant. La fonction SEL indique à l'encodeur 1904 la matrice WMi sélectionnée pour le cycle courant, et au décodeur 1908 la matrice WEj sélectionnée pour ce cycle courant, via deux signaux respectifs cmd1 et cmd2.

Pour mettre en œuvre en matériel le modèle de la figure 20 après avoir entrainé ce dernier, chaque poids en commun entre les trois matrices WM1, WM2, WM3 peut être mis en œuvre par un unique circuit correspondant, par exemple un unique circuit Cpos ou Cneg, et lorsqu'un poids est différent selon la matrice WM1, WM2, WM3 considérée, chaque valeur différente de ce poids est mise en œuvre par un circuit dédié correspondant, et ce circuit est sélectionné (ou activé ou connecté dans un chemin de données correspondant) lorsque que la matrice WMi à laquelle il appartient est sélectionné par le circuit 2000, et désélectionné (ou désactivé ou déconnecté du chemin de données correspondant) lorsque une autre matrice WMi est sélectionné par le circuit 2000. A titre d'exemple, le circuit 2000 peut être mis en œuvre par un circuit numérique adapté à mettre en œuvre le réseau de neurone entrainé correspondant à la fonction SEL. A titre d'exemple, une fonction de régularisation peut être utilisée afin de favoriser une différence limitée entre les R matrices WMi.

Dans une variante de réalisation non illustrée, seules les R matrices WMi de l'encodeur 1904 et la fonction SEL sont prévues, le décodeur 1908 étant modélisé par une seule matrice de poids, identique pour tous les cycles de conversions.

Dans un autre exemple, non illustré, de mise en oeuvre de la méthode de la figure 9 décrite précédemment, il est proposé de modifier la matrice WM de poids de l'encodeur et celle WE des poids du décodeur en fonction de l'indice courant n de la conversion, de manière similaire à ce qui est décrit dans la demande de brevet EP 3259847.

Ainsi, il est prévu deux couples WM1, WE1 et WM2, WE2 de matrices de poids de l'encodeur et du décodeur.

Une valeur de l'indice n du cycle C[n] auquel le couple de matrices WM1, WE1 est remplacé par le couple de matrice WM2, WE2 est apprise lors de l'entrainement profond supervisé. Par exemple, en utilisant une topologie de convertisseur du type de celle définie par [Math 19], une contrainte est appliquée aux matrices WM1 et WM2 pour que les poids de la matrice WM1 correspondant aux chemins de rebouclage non quantifiés et retardés d'un cycle des cellules Cellk soient forcés à 1, c'est à dire pour que les poids Wa111, Wa221, et Wa331 soient forcés à 1 dans l'exemple de la matrice [Math 19], et que ces mêmes poids soient forcés à une valeur supérieure à 1 dans la matrice WM2. En outre, de préférence, une régularisation ou une contrainte est appliquée aux autres poids de ces deux matrices WM1 et WM2 pour qu'ils soient les mêmes dans les deux matrices, de sorte à réduire la complexité et la surface du convertisseur qui sera fabriqué à partir du modèle entrainé.

Un autre exemple de mise en oeuvre de la méthode de la figure 9 décrite précédemment va maintenant être décrit.

Dans cet autre exemple, le convertisseur à fabriquer n'est plus destiné à convertir des signaux analogiques en des signaux numériques, mais est destiné à extraire un ou plusieurs paramètres latents d'un signal analogique d'entrée. Dit autrement, dans cet exemple, le convertisseur à fabriquer est un convertisseur analogique-information, et non pas un convertisseur analogique-numérique dit standard, au sens où ce convertisseur ne se limite plus à un signal d'entrée statique et/ou ce convertisseur ne fournit plus l'image numérisée du signal d'entrée.

Cet exemple va être décrit dans le cas d'un signal analogique d'entrée xa sinusoïdal, dont on veut extraire des paramètres latents.

Plus particulièrement, le signal xa échantillonné s'exprime sous la forme $x[n] = 0,5 * (A*\sin(2*\Pi*F*n + \varphi) + C)$, avec n allant de 1 à N. Les paramètres latents à extraire sont, dans cet exemple :

- l'amplitude A distribuée uniformément sur un intervalle [-0,4 ; 0,4] pour l'entrainement et [-0,35 ; 0,35] pour les simulations lors des tests ;
- la fréquence F exprimée de la façon suivante :

[Math 24]

$$F = \frac{1}{H * (N - Pmin) + (\dfrac{Pmin + Pmax}{2})}$$

avec H un paramètre uniformément distribué sur un intervalle [-0,45 ; 0,45] pour l'entrainement et [-0,43 ; 0,43] pour les simulations lors des tests, Pmin par exemple égal à 4 et Pmax par exemple égal à N ;
- la composante continue C distribuée uniformément sur un intervalle [-0,4 ; 0,4] pour l'entrainement et [-0,35 ; 0,35] pour les simulations lors des tests ; et
- la phase φ exprimée de la façon suivante :

[Math 25]

$$\varphi = \arccos(2X)$$

avec X un paramètre uniformément distribué sur un intervalle [-0,45 ; 0,45] pour l'entrainement et [-0,43 ; 0,43] pour les simulations lors des tests.

Le modèle de convertisseur comprend J encodeurs ENCj comprenant chacun K cellules Cellk, c'est à dire J encodeurs tels que ceux décrits précédemment, J étant un entier strictement supérieur à 1 et j étant un indice allant de 1 à J. Chacun des J encodeurs reçoit en entrée, à chaque cycle C[n], un échantillon analogique x[n] correspondant.
A chaque cycle C[n], chaque encodeur fournit un vecteur Zj [n] comprenant les sorties Bk1 de chacune des K cellules Cellk de cet encodeur, ces vecteurs Zj [n] étant concaténés pour former un vecteur V[n] comprenant J*K éléments.
Le modèle de convertisseur comprend un décodeur ou filtre recevant les vecteurs V[n] de l'encodeur constitué des J encodeurs de K cellules Cellk.
Le décodeur comprend E couches de convolution CONVe, avec E un entier égal au nombre de paramètres latents recherchés, et e un entier allant de 1 à E. A chaque cycle C[n], chaque couche CONVe effectue O convolutions sur les l derniers vecteurs V[n] successifs reçus, par exemple sur l=4 vecteurs V [n], avec O un entier non nul. Dit autrement, chaque couche CONVe effectue O convolutions sur l'axe temporel des vecteurs V[n] avec une profondeur de l cycles C[n]. Bien entendu, la personne du métier aura compris que chaque couche CONVe est alors adapté à mémoriser (ou stocker) l-1 vecteur V[n] successifs, de sorte à pouvoir mettre en œuvre chacune des O convolutions sur l vecteurs V[n] successifs. A chaque cycle C[n], chaque couche CONVe fournit un vecteur Ve[n] comprenant le résultat des O convolutions faites par la couche CONVe à ce cycle. Ces O convolutions sont réalisées à partir de O noyaux de convolution appris et indépendants entre eux au sein d'une même couche et entre les E couches.
Le décodeur comprend en outre E filtres FILTERe. Chaque filtre FILTERe reçoit le vecteur Ve[n] d'une couche CONVe correspondante.
A titre d'exemple, chaque filtre FILTERe comprend une cascade de réseaux de neurones récurrents simples, c'est à dire des réseaux de neurones récurrents simples connectés les uns à la suite des autres, se terminant de préférence par une couche (ou étage) de normalisation.
Par exemple, chaque filtre FILTERe comprend au moins quatre, par exemple cinq, réseaux de neurones récurrents simples.
De préférence, dans chaque filtre FILTERe un étage introduisant des non linéarités est intercalé entre la sortie du troisième réseau de neurones récurrent simple et l'entrée du quatrième réseau de neurones récurrent simple. Le but de cette non linéarité est de faciliter l'estimation du contenu spectrale du signal dans chaque bande, indépendamment de la puissance du signal, de sorte à faciliter l'extraction du paramètre F. Par exemple, l'étage de non-linéarité est configuré pour calculer le carré de chaque valeur de sortie du troisième réseau de neurones récurrent simple, pour appliquer une normalisation L2 aux valeurs au carré ainsi calculées (par exemple par division de la somme des valeurs au carré du lot d'entrainement), et pour calculer la racine carrée de ces valeurs normalisées.
Chaque filtre FILTERe est configuré pour fournir l'un des paramètres latents recherchés.

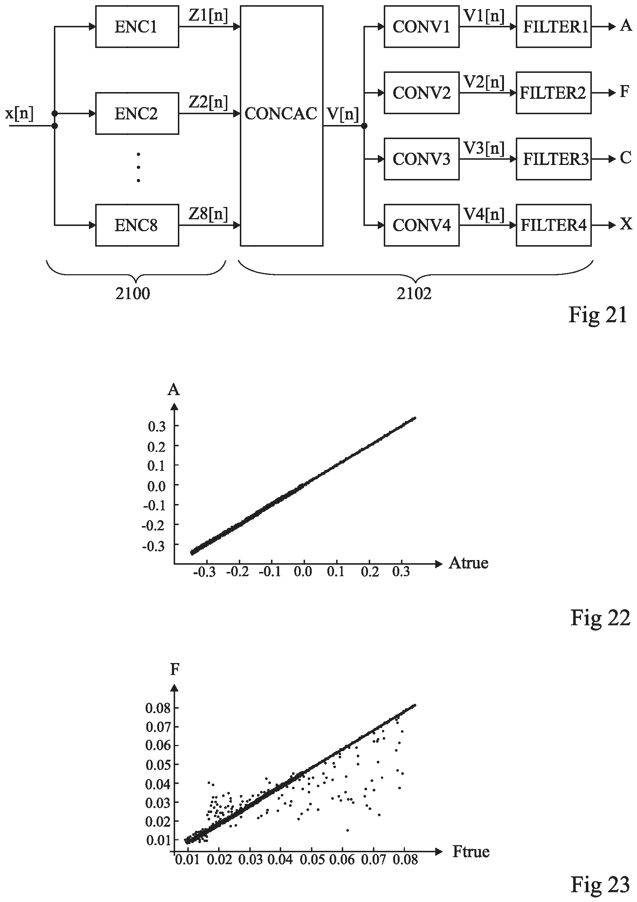

La figure 21 illustre, de manière schématique et sous la forme de blocs, un exemple d'un tel modèle de convertisseur, dans le cas où J est égal à 8, et E est égal à 4.
Dans cet exemple, le modèle de convertisseur comprend donc :

- un modulateur 2100 comportant J encodeurs ENCj (ENC1, ENC2, ..., ENC8 en figure 21) ; et
- un filtre 2102 comprenant :

  un bloc CONCAT configuré pour mettre en œuvre la concaténation de J vecteurs Z[n] pour fournir le vecteur V[n],

E couches de convolution CONVe (CONV1, CONV2, CONV3, CONV4 en figure 21), mettant en œuvre chacune O convolutions de profondeur par exemple égale à 4 sur l'axe temporel, et E filtres FILTERe (FILTER1, FILTER2, FILTER3, FILTER4 en figure 21).

A chaque cycle C[n] :

- chacun des J encodeur ENC1, ENC2, ..., ENC8 reçoit le signal analogique échantillonné x[n], et fournit un vecteur correspondant respectivement Z1[n], Z2[n], ..., Z8[n],
- le bloc CONCAT fournit le vecteur V[n] à partir des J vecteur Zi[n],
- chacune des couches CONV1, CONV2, CONV3, CONV4 reçoit le vecteur V[n], effectue O convolution sur ce vecteur et les I-1 vecteurs précédents, et fournit le vecteur respectif V1[n], V2[n], V3[n] et V4[n] comprenant le résultat des O convolutions ;
- chacun des filtres FILTER1, FILTER2, FILTER3 et FILTER4 reçoit le vecteur respectivement V1[n], V2[n], V3[n] et V4[n] ; et
- au Nième cycle C[n], c'est à dire à la fin de la conversion, la sortie du filtre FILTER1 fournit l'amplitude A du signal d'entrée du convertisseur, la sortie du filtre FILTER2 fournit la fréquence F du signal d'entrée du convertisseur, la sortie du filtre FILTER3 fournit la composante continue C du signal d'entrée du convertisseur, et la sortie du filtre FILTER4 fournit la valeur du paramètre X à partir de laquelle peut être calculée la phase $\varphi$ du signal d'entrée du convertisseur.

Le modèle proposé en figure 21 a été entrainé avec :

- un entrainement axé sur la quantification,
- N égal à 120,
- une stratégie d'apprentissage consistant à apprendre le pas de quantification dans le premier encodeur ENC1 seulement et à appliquer le même pas de quantification appris aux autres encodeurs du modulateur 1200, ce qui permet de limiter l'influence des variations des valeurs des capacités résultant de variations de fabrication dans le convertisseur qui sera fabriqué et de simplifier l'implémentation des poids en ayant une valeur de capacité unitaire commune à l'ensemble des encodeurs ENCj,
- l'utilisation de la fonction de coût Fcost2 adaptée au présent cas, et
- l'ajout de couches introduisant du bruit temporel sur la sortie de chaque cellule Cellk de chaque encodeur ENCj.

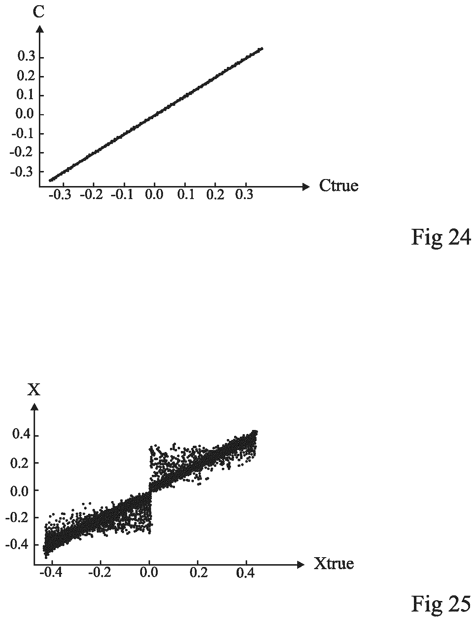

Les figures 22, 23, 24 et 25 illustrent l'évolution des valeurs fournies par le convertisseur entrainé pour les paramètres respectifs A, F, C et X (axes des ordonnées) en fonction des valeurs attendues respectives Atrue, Ftrue, Ctrue et Xtrue (axes des abscisses) de ces paramètres.

On notera que la précision de conversion pourrait être augmentée en augmentant la valeur du paramètre J et/ou la profondeur des E*O convolutions sur l'axe temporel et/ou le nombre de réseaux de neurones récurrents simples cascadés dans chaque filtre FILTERe.

L'exemple ci-dessus montre qu'il est possible, à partir du modèle générique d'encodeur basé sur K cellules Cellk, de construire un modèle d'encodeur et de l'entrainer par apprentissage profond supervisé, de sorte à mettre en œuvre une conversion analogique-information donnée. Ce convertisseur peut ensuite être fabriqué, par exemple en mettant en œuvre chaque encodeur du modèle entrainé de convertisseur de la façon décrite en relation avec les figures 10 et 11 ou 12 à 16, et en mettant en œuvre le modèle entrainé du filtre du décodeur en logiciel et/ou en matériel, par exemple au moins en partie avec un circuit numérique adapté à mettre en œuvre un réseau de neurones.

L'obtention d'un tel convertisseur ne serait pas possible avec des méthodes usuelles de conception.

A titre de variante, on pourrait prévoir que chaque cellule Cellk de l'encodeur ENCj ait accès aux sorties des cellules d'un autre encodeur. Cela reviendrait à augmenter la dimension du vecteur de poids associé à l'entrée de chaque cellule Cellk de sorte à pouvoir recevoir les sortie Akd ou Bkd d'au moins une cellule d'un autre encodeur. Des fonctions de régularisation ou contraintes seraient, par exemple, appliquées pour éviter d'avoir un trop grand nombre de poids non nuls. L'échange de données entre plusieurs cellules permettrait d'enrichir l'expressivité globale du réseau. Dans cette proposition de variante, la mise à jour des sorties des cellules Cellk peut par exemple être réalisée de gauche à droite au sein de chaque encodeur. En résumé, on aurait des groupes de cellules formant un encodeur qui peuvent échanger des signaux avec d'autres groupes de cellules formant un autre encodeur, avec un ordre de mise à jour des sorties Ak0 et Bk0 commun entre les différents encodeurs ou propre à chaque encodeur.

Bien que l'on ait décrit ici un exemple de convertisseur analogique information, d'autres exemples de convertisseurs analogique information peuvent être conçus grâce au modèle générique d'encodeur proposé et à la méthode de conception proposée. En particulier, la personne du métier sera en mesure d'adapter la modélisation du filtre sous la forme de réseaux de neurones à la fonctionnalité recherchée pour le convertisseur qu'elle conçoit.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

En particulier, les exemples de régularisations, de contraintes et de stratégies d'apprentissage ne se limitent pas à ceux décrits précédemment à titre illustratif. La personne du métier sera en mesure de prévoir d'autres contraintes, par exemple déterminées par les propriétés matérielles et/ou fonctionnelles du convertisseur à fabriquer, d'autres régularisations, par exemple déterminées par les propriétés matérielles et/ou fonctionnelles du convertisseur à fabriquer, et d'autres stratégies d'apprentissage, par exemple déterminées par les propriétés matérielles et/ou fonctionnelles du convertisseur à fabriquer. Par exemple, la personne du métier pourra s'appuyer sur au moins l'une des techniques suivantes permettant l'exploration de topologies d'un réseau avec différentes stratégies d'apprentissage ou entrainement :

- distillation de savoir ("Knowledge Distillation" en anglais) : consiste à entrainer un réseau de neurones à se comporter comme un autre réseau de neurones, ce qui, appliqué à la présente description, revient à entrainer un convertisseur à se comporter comme un autre convertisseur ;
- bruit à bruit ("Noise2Noise" en anglais) : consiste à entrainer un réseau à convertir un signal bruité en calculant la fonction de coût non pas à partir des données de sortie du réseau, mais à partir de données bruitées obtenues à partie de données de sortie auxquelles a été ajouté du bruit (par exemple avec des couches d'augmentation de données en sortie du réseau) ;
- apprentissage contrastif ("Contrastive Learning" en anglais) : des données d'entrées proches (ou ayant une relation particulière en entrée du réseau) conduisent à des données de sortie proches (ou ayant une relation particulière en sortie du réseau ;
- recherche d'architecture neuronale (NAS de l'anglais "Neural Architecture Search") : consiste en une recherche automatique d'architecture en complexifiant progressivement une topologie initiale simple.

Par ailleurs, la personne du métier sera en mesure de prévoir d'autres fonctionnalités pour un convertisseur à fabriquer que celles qui ont été décrites à titre d'exemple, et saura adapter le modèle de filtre à connecter à la suite du modèle générique d'encodeur en fonction de ces fonctionnalités visées, c'est à dire, par exemple, adapter la modélisation du filtre sous la forme de réseaux de neurones en fonction de la fonctionnalité visée dans le convertisseur à fabriquer.

En outre, les exemples de valeurs donnés à titre d'exemple, par exemple pour les paramètres $\Delta k$, $\lambda$, pour l'écart type du bruit gaussien des couches d'augmentation de donnée, le paramètre K, le paramètre D, le paramètre N, le paramètre q, etc..., pourront être modifiés par la personne du métier, par exemple sur la base de propriété matérielle et/ou fonctionnelle du convertisseur qu'elle cherche à concevoir avec le modèle générique et la méthode proposés, par exemple en mettant en œuvre plusieurs fois et successivement la méthode décrite, et en modifiant certains paramètres à chaque nouvelle mise en œuvre, en fonction du convertisseur qu'elle cherche à concevoir.

Enfin, la mise en oeuvre pratique des modes de réalisation et variantes décrits est à la portée de la personne du métier à partir des indications fonctionnelles données ci-dessus. En particulier, bien que cela n'ait pas été décrit, les modèles de filtres (c'est à dire de décodeur), une fois entrainés, peuvent être mis en œuvre par des circuits numériques et/ou des programmes d'ordinateurs adaptés à mettre en œuvre des réseaux de neurones. En effet, les données reçues par les filtres décrits sont des données quantifiées pouvant aisément être représentées par des données numériques qui peuvent être traitées par du logiciel et/ou par un circuit numérique.

**Revendications**

1. Méthode de conception d'un convertisseur de type sigma delta comprenant une étape d'apprentissage profond supervisé appliquée à un modèle de convertisseur, dans laquelle :

   le modèle de convertisseur comprend au moins un encodeur récurrent et au moins un décodeur récurrent ;
   chaque encodeur récurrent est basé sur un modèle générique comprenant une succession de K cellules génériques identiques Cellk, avec K un paramètre entier et supérieur ou égal à 1 et k un indice entier allant de 1 à K ;
   le convertisseur fonctionne à un taux de suréchantillonnage N, avec N un entier supérieur ou égal à 1 ;
   chaque conversion par le convertisseur comprend N cycles C[n], avec n un indice entier allant de 1 à N ;
   chaque cellule Cellk du modèle générique est un réseau de neurones récurrent qui, à chaque cycle C[n], calcule un produit d'un vecteur d'entrée X[n] par un vecteur de poids Wk de la cellule Cellk et fournit un vecteur de sortie Qk[n] comprenant D paires de sorties Akd[n] et Bkd[n],
   avec :

- D entier supérieur ou égal à 1 et d un indice entier allant de 0 à D-1,
- Akd[n] le résultat du produit calculé par la cellule Cellk retardé de d cycles,
- Bkd[n] une quantification du résultat du produit calculé par la cellule Cellk retardée de d cycles ; et

à chaque début de cycle C[n], le vecteur X[n] est le même pour toutes les cellules Cellk et comprend, par exemple est égal à, la concaténation des K vecteurs Qk[n] et d'un échantillon x[n], pour le cycle C[n], d'un signal x à convertir,
et dans laquelle le convertisseur sigma-delta est obtenu en fabriquant un circuit électronique correspondant au modèle obtenu après l'entrainement.

2. Méthode selon la revendication 1, dans laquelle chaque encodeur récurrent modélise un modulateur sigma-delta du convertisseur et chaque décodeur récurrent modélise un filtre du convertisseur.

3. Méthode selon la revendication 1 ou 2, dans laquelle chaque décodeur récurrent est basé sur une ou plusieurs successions de réseaux de neurones récurrents simples (SRNN1, SRNN2, SRNN3).

4. Méthode selon l'une quelconque des revendications 1 à 3, dans laquelle au moins une contrainte déterminée par une propriété matérielle ou par une propriété fonctionnelle du convertisseur à fabriquer est appliquée au modèle de convertisseur, de préférence à chaque encodeur.

5. Méthode selon la revendication 4, dans laquelle ladite au moins une contrainte comprend :

une contrainte déterminée par une dynamique maximale en sortie d'une des K cellules Cellk et correspondant à un ajout d'une couche de coupure en sortie de ladite cellule Cellk ; et/ou
une contrainte déterminée par une robustesse à des non-idéalités temporelles et correspondant à un ajout sur un noeud interne de l'encodeur d'une couche d'augmentation de donnée modélisant un bruit aléatoire gaussien ; et/ou une contrainte déterminée par un dimensionnement de circuits mettant en œuvre des poids de l'encodeur et correspondant à un entrainement axé sur la quantification ; et/ou
une contrainte déterminée par une surface du convertisseur à fabriquer et correspondant à un masquage de poids de l'encodeur ; et/ou
une contrainte déterminée par une topologie du convertisseur à fabriquer et correspondant à un masquage de poids de l'encodeur ; et/ou
une contrainte déterminée par une surface du convertisseur et correspondant à une technique de coupure de poids de l'encodeur.

6. Méthode selon l'une quelconque des revendications 1 à 5, dans laquelle au moins une régularisation déterminée par une propriété matérielle ou par une propriété fonctionnelle du convertisseur est appliquée au modèle de convertisseur.

7. Méthode selon la revendication 6, dans laquelle :
une régularisation est déterminée par une surface du convertisseur à fabriquer et correspond à une régularisation L1 appliquée aux poids de l'encodeur ; et/ou une régularisation est déterminée par une atténuation de signaux internes et correspond à une pénalité lorsqu'un poids d'un chemin de rebouclage d'une cellule Cellk est inférieur à 1.

8. Méthode selon l'une quelconque des revendications 1 à 7, dans laquelle une fonction de coût utilisée pour l'entraînement comprend un terme déterminé par une fonction de régularisation déterminée par des conditions de saturation du convertisseur.

9. Méthode selon la revendication 7, dans lequel la fonction de coût comprend un terme déterminé par une fonction de fidélité de type logarithme de la somme des exponentielles des différences.

10. Méthode selon l'une quelconque des revendications 1 à 9, dans laquelle la fabrication du convertisseur comprend une mise en oeuvre de chaque poids non nul du modèle d'encodeur entrainé par un circuit capacitif (Cpos, Cneg) ayant une capacité (C) dont une valeur est déterminée par ledit poids.

11. Méthode selon l'une quelconque des revendications 1 à 9, dans laquelle la fabrication du convertisseur comprend une mise en oeuvre de chaque poids non nul du modèle d'encodeur entrainé par un circuit résistif (Rw) ayant une résistance (R) dont une valeur est déterminée par ledit poids.

**12.** Méthode selon l'une quelconque des revendications 1 à 11, dans laquelle l'entrainement est axé sur la quantification.

**13.** Méthode selon l'une quelconque des revendications 1 à 12, dans laquelle le décodeur est déterminé par une fonctionnalité du convertisseur à fabriquer.

**14.** Méthode selon l'une quelconque des revendications 1 à 13, dans laquelle le convertisseur à fabriquer met en œuvre un échantillonnage cyclique et alterné de plusieurs canaux d'entrée (Col1, Col2, Col3) du convertisseur.

Fig 1

Fig 2

Fig 3

Fig 4

Fig 5

Fig 6

| Cell1 | Cell2 | Cell3 | Cell1 | Cell2 | Cell3 | Cell1 | Cell2 | Cell3 | Cell1 | Cell2 | Cell3 |
|-------|-------|-------|-------|-------|-------|-------|-------|-------|-------|-------|-------|
| | C[n] | | | C[n+1] | | | C[n+2] | | | C[n+3] | |

t0    t1    t2    t3    t4

Fig 7

Fig 8

Fig 9

Fig 10

Fig 11

Fig 12

Fig 13

Fig 14

Fig 15

48

Fig 16

Fig 17

Fig 18

Fig 19

Fig 20

Fig 21

Fig 22

Fig 23

Fig 24

Fig 25

Fig 26

# EP 4 625 826 A1

Europäisches Patentamt
European Patent Office
Office européen des brevets

## RAPPORT DE RECHERCHE EUROPEENNE

Numéro de la demande

EP 25 16 6016

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 10 970 441 B1 (ZHANG XUAN [US] ET AL) 6 avril 2021 (2021-04-06) * figures 1-23 * * colonne 1, ligne 1 - colonne 41, ligne 50 * ----- | 1-14 | INV. H03M3/00 G06N3/044 G06N3/0455 G06N3/048 G06N3/09 |
| A | US 11 394 391 B2 (IGNJATOVIC ZELJKO [US]) 19 juillet 2022 (2022-07-19) * figures 1-6 * * colonne 1, ligne 1 - colonne 9, ligne 60 * ----- | 1-14 | |
| A | CAO WEIDONG ET AL: "NeuADC: Neural Network-Inspired Synthesizable Analog-to-Digital Conversion", IEEE TRANSACTIONS ON COMPUTER-AIDED DESIGN OF INTEGRATED CIRCUITS AND SYSTEMS, IEEE, USA, vol. 39, no. 9, 26 juin 2019 (2019-06-26), pages 1841-1854, XP011806572, ISSN: 0278-0070, DOI: 10.1109/TCAD.2019.2925391 [extrait le 2020-08-19] * figures 1-8 * * page 1841 - page 1853 * ----- | 1-14 | |

DOMAINES TECHNIQUES RECHERCHES (IPC)

H03M
G06N

Le présent rapport a été établi pour toutes les revendications

| Lieu de la recherche | Date d'achèvement de la recherche | Examinateur |
|---|---|---|
| La Haye | 18 juillet 2025 | Jespers, Michaël |

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 25 16 6016

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

18-07-2025

| Document brevet cité au rapport de recherche | Date de publication | Membre(s) de la famille de brevet(s) | Date de publication |
|---|---|---|---|
| US 10970441 B1 | 06-04-2021 | AUCUN | |
| US 11394391 B2 | 19-07-2022 | AUCUN | |

Pour tout renseignement concernant cette annexe : voir Journal Officiel de l'Office européen des brevets, No.12/82

EPO FORM P0460

## RÉFÉRENCES CITÉES DANS LA DESCRIPTION

**Documents brevets cités dans la description**

- EP 3259847 A

**Littérature non-brevet citée dans la description**

- Design Automation of Analog and Mixed Signal Circuits Using Neural Networks - A Tutorial Brief. **G. LINAN-CEMBRANO et al.** IEEE Transactions on Circuits and Systems II: Express Briefs